# EUROPEAN PATENT SPECIFICATION

(11) **EP 1 972 440 B1**
(45) Date of publication and mention of the grant of the patent: **23.06.2010**
(21) Application number: 08005296.2
(22) Date of filing: 20.03.2008
(51) Int. Cl.: B41C 1/10, G03F 7/033, G03F 7/30

(54) **Negative lithographic printing plate precursor and lithographic printing method using the same**
Negativ-Lithografiedruckplattenvorläufer und Lithografiedruckverfahren damit
Précurseur de plaque d'impression lithographique négative et son procédé d'impression lithographique

(30) Priority: 23.03.2007 JP 2007077372; 30.03.2007 JP 2007094777
(43) Date of publication of application: 24.09.2008
(73) Proprietor: FUJIFILM Corporation, Minato-ku Tokyo (JP)
(72) Inventor: Iwai, Yu, Haibara-gun, Shizuoka (JP); Aoshima, Norio, Haibara-gun, Shizuoka (JP)
(74) Representative: HOFFMANN EITLE

(56) References cited:
- EP-A- 1 757 982
- JP-A- 11 305 428
- US-A1- 2004 180 285
- US-A1- 2005 238 994

## Description

### Background of the Invention

### 1. Field of the Invention

The present invention relates to a lithographic printing plate precursor and a lithographic printing method using the same. More specifically, the invention relates to what is called a negative lithographic printing plate precursor capable of direct plate making on the basis of digital signals from, e.g., a computer, by scanning lasers having wavelengths of 300 to 1,200 nm, and also relates to a lithographic printing method capable of directly developing and printing the lithographic printing plate precursor on a printing press without going through developing treatment process.

### 2. Description of the Related Art

A lithographic printing plate generally comprises a lipophilic image part that receives ink and a hydrophilic non-image part that receives a fountain solution in a printing process. Lithographic printing is a printing method of making difference in an ink-adhering property on the surface of a lithographic printing plate with the lipophilic image part of the lithographic printing plate as the ink-receptive part and the hydrophilic non-image part as the fountain solution-receptive part (ink-repellent part) by making use of the natures of water and oil ink of repelling to each other, adhering ink only on the image part, and transferring the ink to the material to be printed, e.g., paper.

For manufacturing such a lithographic printing plate, a lithographic printing plate precursor (a PS plate) comprising a hydrophilic support having provided thereon a lipophilic photosensitive resin layer (an image-recording layer) has so far been widely used. A lithographic printing plate is generally obtained by a plate-making method of exposing a lithographic printing plate precursor through an original image such as a lith film and the like, and then dissolving and removing other unnecessary image-recording layer with an alkali developing solution or an organic solvent for leaving the part to become an image part of the image-recording layer to thereby bare a hydrophilic support surface.

In a conventional plate-making process of a lithographic printing plate precursor, a process of dissolving and eliminating an unnecessary image-recording layer with a developing solution and the like corresponding to the image-recording layer is necessary after exposure, however the exclusion or simplification of such an additional wet process is one of the subjects in the industry. Since the discard of waste solutions discharged with wet processes is a particularly great interest in the industry at large in recent years from the consideration of the global environment, the solution of the above problem is increasingly desired.

As a simple plate-making method, a method that is called on-press development is proposed, which is a method of using an image-recording layer capable of removing an unnecessary part of an image-recording layer in an ordinary printing process, and removing an unnecessary part of an image-recording layer after exposure on a printing press to obtain a lithographic printing plate.

As the specific examples of on-press development, e.g., a method of using a lithographic printing plate precursor having an image-recording layer soluble or dispersible with, e.g., a fountain solution, an ink solvent, or an emulsified product of a fountain solution and ink, a method of mechanically removing an image-recording layer by the contact with the rollers and the blanket cylinder of a press, and a method of mechanically removing an image-recording layer by the contact with the rollers and the blanket cylinder after weakening the cohesive strength of an image-recording layer or the adhesive strength of an image-recording layer and a support by the penetration of a fountain solution, an ink solvent, or the like are exemplified.

Incidentally, in the invention, unless otherwise indicated, "development process" means a process of removing the part of an image-recording layer not exposed with a laser by bringing the unexposed part into contact with a liquid (generally an alkali developing solution) to thereby bare a hydrophilic support surface with an apparatus other than a printing press (generally an automatic processor), and "on-press development" means a method and a process of removing the part of an image-recording layer not exposed with a laser by bringing the unexposed part into contact with a liquid (generally at least one of a printing ink and a fountain solution) to thereby bare a hydrophilic support surface with a printing press.

On the other hand, in recent years, digitized techniques of electronically processing, accumulating and outputting image data with a computer have prevailed, and various novel image output systems corresponding to these digitized techniques have been put to practical use. Under such circumstances, a computer-to-plate (CTP) technique of directly making a lithographic printing plate is attracting public attention, which technique comprises scanning exposing a lithographic printing plate precursor with high convergent radiant rays such as laser beams carrying digitized image data without using a lith film. With such a tendency, it is one of important technical subjects to obtain a lithographic printing plate precursor well adapted to such a technique.

As described above, the simplification of plate-making operation, and the realization of dry system and non-processing system have been more and more required in recent years from both aspects of global environmental protection and the adaptation for digitization.

Of lithographic printing plate precursors, as a lithographic printing plate precursor capable of scanning exposure, a lithographic printing plate precursor comprising a hydrophilic support having provided thereon a lipophilic photosensitive resin layer containing a photosensitive compound capable of generating an active seed such as a radical and a Brϕnsted acid by laser exposure is proposed and already has been on the market. A negative lithographic printing plate can be obtained by laser scanning the above lithographic printing plate precursor based on digital information to generate active seeds, causing physical or chemical change on the photosensitive layer by the action of the active seeds to make the layer insoluble, and developing the precursor without intermission. In particular, a lithographic printing plate precursor comprising a hydrophilic support having thereon a photo-polymerization type photosensitive layer containing a photo-polymerization initiator excellent in photosensitivity speed, an addition-polymerizable ethylenic unsaturated compound, and a binder polymer soluble in an alkali developing solution, and if necessary, an oxygen-intercepting protective layer has various advantages such that it is excellent in productivity, development processing is simple, and good in resolution and ink adhesion, so that such a lithographic printing plate precursor is promising as a printing plate having preferred printing properties.

As a lithographic printing plate precursor capable of on-press development, e.g., a lithographic printing plate precursor comprising a hydrophilic support having thereon an image-forming layer containing hydrophobic thermoplastic polymer particles dispersed in a hydrophilic binder is disclosed in Japanese Patent 2938397. The same patent discloses that on-press development is possible by exposing the lithographic printing plate precursor with an infrared laser to thereby coalesce the hydrophobic thermoplastic polymer particles by heat to form an image, mounting the lithographic printing plate precursor on a cylinder of a press, and then developing with at least one of a fountain solution and ink.

A method of forming an image by coalescence by mere heat fusion of fine particles like this method certainly shows a good on-press developing property, but there are problems in the method such that image strength (adhesion with a support) is extremely weak and press life is insufficient.

A lithographic printing plate precursor comprising a hydrophilic support having thereon an image-recording layer (a heat-sensitive layer) containing microcapsules microencapsulating a polymerizable compound is disclosed in JP-A-2001-277740 (The term "JP-A" as used herein refers to an '"unexamined published Japanese patent application".) and JP-A-2001-277742.

Further, JP-A-2002-287334 discloses a lithographic printing plate precursor comprising a support having thereon an image-recording layer (a photosensitive layer) containing an infrared absorber, a radical polymerization initiator and a polymerizable compound.

Such a method of using polymerization reaction is characterized in that the image strength is relatively good as compared with the image part formed by heat fusion of polymer fine particles since the density of chemical bonding of the image part is high, but from a practical point of view, even such a method is still insufficient in all of on-press developing property, fine line reproducibility and press life, and particularly press life is extremely inferior when UV ink is used.

Moreover, US 2003/0064318 discloses a lithographic printing plate precursor capable of on-press development comprising a support having provided thereon an image-recording layer containing a polymerizable compound, and a graft polymer having a polyethylene oxide chain on the side chain or a block polymer having polyethylene oxide block.

A negative working photosensitive composition has been developed with enhanced storage stability and can be used to manufacture negative-type lithographic printing plate precursors displaying high sensitivity and printing durability (EP-A-1 757 982). These benefits were attested to the inclusion of an organic boron compound and a binder resin having a sulfonamide or active imino group in the photosensitive composition.

A negative-working heat-sensitive lithographic printing plate precursor has also been developed which provides high image quality over a prolonged printing run (US-A-2005/238 994). These properties were achieved by incorporating a phenolic resin in a first layer and a polymer containing at least one sulphonamide group in a second layer disposed between the first layer and the support.

Infrared-absorbing compounds have been described which can be included into negative-type lithographic printing plate precursors which then display improved dot stability (US-A-2004/180 285).

A photosensitive composition has also been described which can be developed in an aqueous alkaline solution containing no organic solvent and which exbibits excellent printing durability (JP-A-11 305 428). The solubility of the composition in aqueous alkaline solution was achieved by incorporating a specific diazo resin.

However, although the technique shows a good on-press developing property, fine line reproducibility and press life are still insufficient.

### Summary of the Invention

Accordingly, an object of the invention is to provide a negative lithographic printing plate precursor capable of image recording by laser exposure. Another object of the invention is to provide a negative lithographic printing plate precursor capable of on-press development without performing development processing. A further object is to provide a lithographic printing method. A still further object is to provide a negative lithographic printing plate precursor excellent in chemical resistance and having high press life even when printing using UV ink (UV-curable ink) is performed.

As a result of examination of various polymer compounds, the present inventors have found that the above objects can be attained by the use of a polymer compound having a plurality of specific functional groups in a photo-polymerization layer (an image-recording layer), thus the present invention has been achieved. The invention is as follows.
<1> A negative on-press development type lithographic printing plate precursor comprising:
   a support; and
   a photo-polymerization layer containing a polymer compound having at least one of a sulfonamido group and a cyclic structure derived from maleimide, and further having a hydrophilic group in a molecule thereof, wherein
   the hydrophilic group is an alkylene oxide structure represented by a following Formula (II): 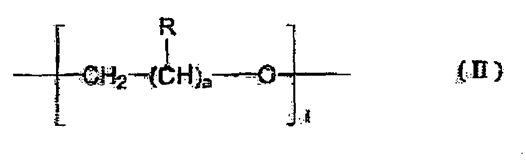
   wherein
   R represents a hydrogen atom or a methyl group;
   a represents 1, 3 or 5; and
   1 represents an integer of from 1 to 9.
<2> The negative on-press development type lithographic printing plate precursor according to <1>, comprising:
   a support; and
   a photo-polymerization layer containing a polymer compound having a sulfonamido group and a hydrophilic group in a molecule thereof.
<3> The negative on-press development type lithographic printing plate precursor according to <2>, wherein
   the polymer compound has a unit derived from a monomer having a sulfonamido group represented by any of following Formulae (Ia) to (Ie): 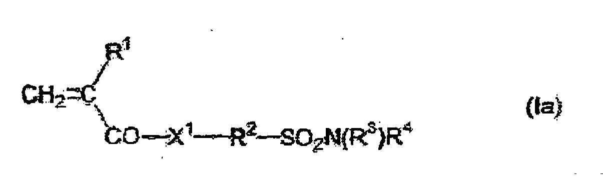 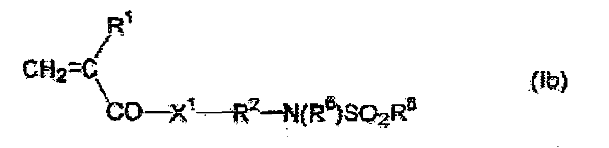 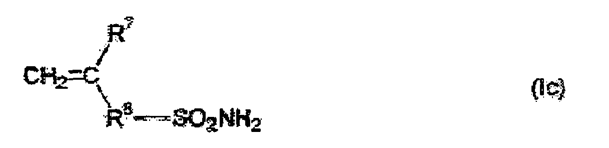 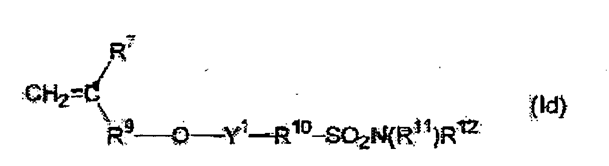 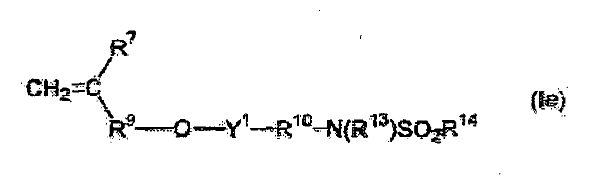 wherein
   X¹ represents O or NR;
   R¹ represents a hydrogen atom or a methyl group;
   R² , R⁸ and R¹⁰ each independently represents an alkylene, cycloalkylene, arylene or aralkylene group having from 1 to 12 carbon atoms, each of which may have a substituent;
   R³ , R⁴ R⁵, R¹¹, R¹² and R¹³ each independently represents a hydrogen atom, or an alkyl, cycloalkyl, aryl or aralkyl group having from 1 to 12 carbon atoms, each of which may have a substituent;
   R⁶ and R¹⁴ each independently represents alkyl, cycloalkyl, aryl or aralkyl group having from 1 to 12 carbon atoms, each of which may have a substituent;
   R⁷ represents a hydrogen atom, a halogen atom, or a methyl group;
   R⁹ represents a single bond, or an alkylene, cycloalkylene, arylene or aralkylene group having from 1 to 12 carbon atoms, each of which may have a substituent;
   R represents a hydrogen atom, or an alkyl, cycloalkyl, aryl or aralkyl group having from 1 to 12 carbon atoms, each of which may have a substituent; and
   Y¹ represents a single bond or a carbonyl group.
<4> The negative on-press development type lithographic printing plate precursor according.to <1>, comprising:
   a support; and
   a photo-polymerization layer containing a polymer compound having a cyclic structure derived from maleimide and a hydrophilic group in a molecule thereof.
<5> The negative on-press development type lithographic printing plate precursor according to <4>, wherein
   the cyclic structure derived from maleimide is a structure represented by a following Formula (I): 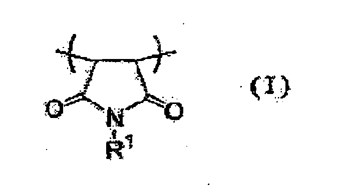 wherein
   R¹ represents a hydrogen atom or a monovalent organic group that may have a substituent.
<6> The negative on-press development type lithographic printing plate precursor according to <5>, wherein
   R¹ in the Formula (I) represents an aryl group that may have a substituent.
<7> The negative on-press development type lithographic printing plate precursor according to <1>, wherein
   the photo-polymerization layer contains an infrared absorber, a polymerization initiator and a polymerizable monomer.
<8> The negative on-press development type lithographic printing plate precursor according to <1>, wherein
   the photo-polymerization layer contains a microcapsule or microgel.
<9> The negative on-press development type lithographic printing plate precursor according to <2>, wherein
   the photo-polymerization layer contains a polymerizable monomer, and
   a mass ratio of the polymer compound having a sulfonamido group and a hydrophilic group in a molecule thereof to the polymerizable monomer is from 1/1 to 1/3.
<10> The negative on-press development type lithographic printing plate precursor according to <4>, wherein
   the photo-polymerization layer contains a polymerizable monomer, and
   a mass ratio of the polymer compound having a cyclic structure derived from maleimide and a hydrophilic group in a molecule thereof to the polymerizable monomer is from 1/1 to 1/3.
<1 > The negative on-press development type lithographic printing plate precursor according to <1>, wherein
   the photo-polymerization layer can be removed with at least one of printing ink and a fountain solution.
<12> The negative on-press development type lithographic printing plate precursor according to <1>, wherein
   the photo-polymerization layer can be removed with at least one of UV ink and a fountain solution.
<13> A lithographic printing method comprising:
   mounting the negative on-press development type lithographic printing plate precursor according to <11> on a printing press and imagewise exposing it with an infrared laser beam, or imagewise exposing the negative on-press development type lithographic printing plate precursor according to <11> with a infrared laser beam and mounting it on a printing press; and
   feeding oil ink and an aqueous component to the negative on-press development type lithographic printing plate precursor to thereby remove an unexposed part of the photo-polymerization layer; and
   performing printing.
<14> A lithographic printing method comprising:
   mounting the negative on-press development type lithographic printing plate precursor according to <12> on a printing press and imagewise exposing it with an infrared laser beam, or imagewise exposing the negative on-press development type lithographic printing plate precursor according to <12> with a infrared laser beam and mounting it on a printing press;
   feeding UV ink and an aqueous component to the negative on-press development type lithographic printing plate precursor to thereby remove an unexposed part of the photo-polymerization layer; and
   performing printing.

By the use of a polymer compound having at least one of a sulfonamido group and a cyclic structure derived from maleimide, and further having a hydrophilic group in the molecule, the above problems could be solved in the invention. The mechanism of the action is not clear but it is presumed that to have at least one of a sulfonamido group and a cyclic structure derived from maleimide prevents chemicals and UV inks from penetrating by (1) high polarity of the functional groups, and (2) interaction of the compounds to each other. Further, it is thought that to have a hydrophilic group in the molecule presumably contributes to rapid penetration of the fountain solution into a photo-polymerization layer and rapid on-press developing property can be obtained.

### Detailed Description of the Invention

### [Negative Lithographic Printing Plate Precursor]

It is a prior condition that the negative lithographic printing plate precursor in the invention comprises a hydrophilic support having thereon a laser-sensitive photo-polymerization layer. The photo-polymerization layer and other constituents are described in detail below.

### Photo-polymerization layer:

### [A polymer compound having a sulfonamido group and a hydrophilic group in the molecule]

The photo-polymerization layer in the invention contains as a binder polymer a polymer compound having a sulfonamido group and a hydrophilic group in the molecule (hereinafter sometimes referred to as a specific polymer compound) as an essential component.

By containing the specific polymer compound, chemical resistance and press life in printing using UV ink are improved and good on-press developing property can be obtained.

As the specific polymer compound, a compound having an -SO₂-N- bond in the side chain or main chain is preferred, and a compound having an -SO₂-N- bond in the side chain is more preferred. It is preferred to have the hydrophilic group in the side chain.

Such a specific polymer compound can be obtained, for example, by copolymerization of a polymerizable monomer having a sulfonamido group and a polymerizable monomer having a hydrophilic group in a proper solvent by using any known polymerization initiator.

As the preferably used polymerizable monomer having a sulfonamido group, a compound represented by any of formulae (Ia) to (Ie) is exemplified.

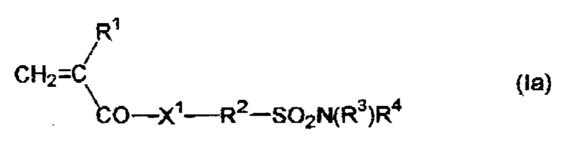

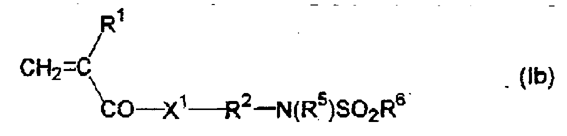

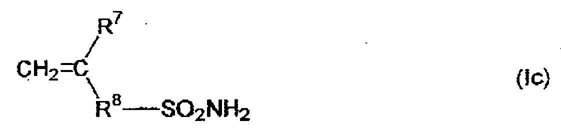

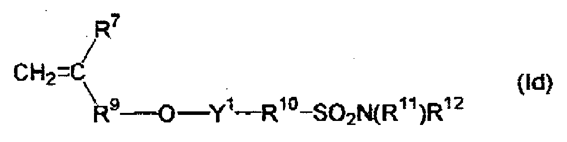

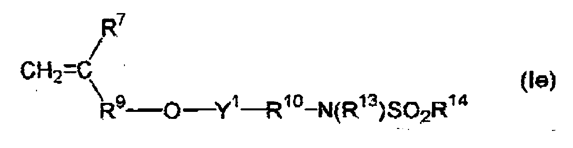

In the formulae, X¹ represents O or NR; R¹ represents a hydrogen atom or a methyl group; R², R⁸ and R¹⁰ each independently represents an alkylene, cycloalkylene, arylene or aralkylene group having from 1 to 12 carbon atoms, each of which may have a substituent; R³, R⁴, R⁵, R¹¹, R¹² and R¹³ each independently represents a hydrogen atom, or an alkyl, cycloalkyl, aryl or aralkyl group having from I to 12 carbon atoms, each of which may have a substituent; R⁶ and R¹⁴ each independently represents an alkyl, cycloalkyl, aryl or aralkyl group having from 1 to 12 carbon atoms, each of which may have a substituent; R⁷ represents a hydrogen atom, a halogen atom, or a methyl group; R⁹ represents a single bond, or an alkylene, cycloalkylene, arylene or aralkylene group having from 1 to 12 carbon atoms, each of which may have a substituent; R represents a hydrogen atom, or an alkyl, cycloalkyl, aryl or aralkyl group having from 1 to 12 carbon atoms, each of which may have a substituent; and Y¹ represents a single bond or a carbonyl group.

Of the monomers represented by formula (Ia) or (Ib), monomers that are especially preferably used in the invention are compounds wherein R² represents an alkylene or cycloalkylene group having 2 to 6 carbon atoms, or a phenylene or naphthylene group, which may have a substituent; R³, R⁴ and R⁵ each represents a hydrogen atom, an alkyl or cycloalkyl group having 1 to 6 carbon atoms, or a phenyl or naphthyl group, which may have a substituent; R⁶ represent an alkyl or cycloalkyl group having 1 to 6 carbon atoms, or a phenyl or naphthyl group, which may have a substituent; and R represents a hydrogen atom, an alkyl or cycloalkyl group having 1 to 6 carbon atoms, or a phenol or naphthyl group, which may have a substituent.

Such monomers include methacrylamides, e.g.,
N-(o-aminosulfonylphenyl)methacrylamide, N-(m-aminosulfonylphenyl)methacrylamide,
N-(p-aminosulfonylphenyl)methacrylamide, N-(o-methylaminosulfanylphenyl)methacrylamide,
N-(m-methylaminosulfonylphenyl)methacrylamide,
N-(p-methylammosulfonylphenyl)methacrylamide,
N-(o-ethylaminosulfonylphenyl)methacrylamide,
N-(m-ethylaminosulfonylphenyl)methacrylamide,
N-(p-ethylaminosulfonylphenyl)methacrylamide
N-(o-n-propylaminosulfonylphenyl)methacrylamide,
N-(m-n-propylaminosulfonylphenyl)methacrylamide,
N-(p-n-propylaminosulfonylphenyl)methacrylamide,
N-(o-i-propylaminosulfonylphenyl)methacrylamide,
N-(m-i-propylaminosulfonylphenyl)methacrylamide,
N-(p-i-propylaminosulfonylphenyl)methacrylamide,
N-(o-n-butylaminosulfonylphmyl)methacrylamide,
N-(m-n-butylaminosulfonylphenyl)methacrylamide,
N -(p-n-butylaminosulfonylphenyl)methacrylamide,
N-(o-i-butylaminosulfonylphenyl)methacrylamide,
N-(m-i-butylaminosulfonylphenyl)methacrylamide,
N-(p-i-butylaminosulfonylphenyl)methacrylamide,
N-(o-sec-butylaminosulfonylphenyl)methacrylamide,
N-(m-sec-butylaminosulfonylphenyl)methacrylamide,
N-(p-sec-butylaminosulfonylphenyl)methacrylamide,
N-(o-t-butylaminosulfonylphenyl)methacrylamide,
N-(m-t-butylaminosulfonylphenyl)methacrylamide,
N-(p-t-butylaminosulfonylphenyl)methacrylamide,
N-(o-phenylaroinosulfonylphenyl)methacrylamide,
N-(m-phenylaminosulfonylphenyl)methacrylamide,
N-(p-phenylaminosulfonylphenyl)methacrylamide,
N-[o-(-naphthylaminosulfonyl)phenyl]methacrylamide,
N-[m-(-naphthylaminosulfonyl)phenyl]methacrylamide,
N-[p-(-naphthylaminosulfonyl)phenyl]methacrylamide,
N-[o-(-naphthylaminosulfonyl)phenyl]methacrylamide,
N-[m-(-naphthylaminosulfonyl)phenyl]methacrylamide,
N-[p-(-naphthylaminosulfonyl)phenyl]methacrylamide,
N-[1-(3-aminosulfonyl)naphthyl]methacrylamide,
N-[1-(3-methylaminosulfonyl)naphthyl]methacrylamide,
N-[1-(3-ethylaminosulfonyl)naphthyl]methacrylamide,
N-(o-methylsulfonylaminophenyl)methacrylamide,
N-(m-methylsulfonylaminophenyl)methacrylamide,
N-(p-methylsulfonylaminophenyl)methacrylamide,
N-(o-ethylsulfonylaminophenyl)methacrylamide,
N-(m-ethylsulfonylaminophenyl)methacrylamide,
N-(p-ethylsulfonylaminophenyl)methacylamde,
N-(o-pbenylsulfonylaminophenyl)methacrylamide,
N-(m-phenylsulfonylaminophenyl)methacrylamide,
N-(p-phenylsulfonylaminophenyl)methacrylamide,
N-[o-(p-methylpheylsulfonylamino)phenyl]methacrylamide,
N-[m-(p-methylphenylsulfonylamino)phenyl]methacrylamide,
N-[p-(p-methylphenylsulfonylamino)phenyl]methacrylamide,
N-[p-(-naphthylsulfonylamino)phenyl]methacrylamide,
N-[p-(-naphthylsulfonylamino)phenyl]methacrylamide,
N-(2-methylsulfonylaminoethyl)methacrylamide,
N-(2-ethylsulfonylaminoethyl)methacrylamide,
N-(2-pheuylsulfonylaminoethyl)methacrylamide,
N-(2-p-methylphenylsulfonylaminoethyl)methacrylamide,
N-(2-naphthylsulfonylaminoethyl)methacrylamide,
N-(2-naphthylsulfonylaminoethyl)methacrylamide,
N-(m-dimethylaminosulfonylphenyl)methacrylamide,
N-(p-dimethylaminosulfonylphenyl)methacrylamide,
N-(o-diethylaminosulfonylphenyl)methacrylmide,
N-(m-diethylaminosulfonylphenyl)methacrylamide,
N-(p-diethylaminosulfonylphenyl)methacrylamide, etc., and acrylamides having the same substituents as above;

Further, methacrylates, e.g., o-aminosulfonylphenyl methacrylate,
m-aminosulfonylphenyl methacrylate,
p-aminosulfonylphenyl methacrylate,
o-methylaminosulfonyl-phenyl methacrylate,
m-methylaminosulfonylphenyl methacrylate,
p-methylaminosulfonylphenyl methacrylate,
o-ethylaminosulfonylphenyl methacrylate,
m-ethylaminosulfonylphenyl methacrylate,
p-ethylaminosulfonylphenyl methacrylate,
o-n-propylaminosulfonylphenyl methacrylate,
m-n-propylaminosulfonylphenyl methacrylate,
p-n-propylaminosulfonylphenyl methacrylate,
o-i-propylaminosulfonylphenyl methacrylate,
m-i-propylaminosulfonylphenyl methacrylate,
o-n-butylaminosulfonylphenyl methacrylate,
m-n-butylaminosulfonylphenyl methacrylate,
p-n-butylaminosulfonylphenyl methacrylate,
m-i-butylarzxinosulfonylphenyl methacrylate,
p-i-butylaminosulfonylphenyl methacrylate,
m-sec-butylaminosulfonylphenyl methacrylate,
p-sec-butylaminosulfonylphenyl methacrylate,
m-t-butylaminosulfonylphenyl methacrylate,
p-t-butylaminosulfonylphenyl methacrylate,
o-phenylaminosulfonylphenyl methacrylate,
m-phenylaminosulfonylphenyl methacrylate
p-phenylaminosulfonylphenyl methacrylate,
m-(-naphthylaminosulfonyl)phenyl methacrylate,
p-(-naphthylaminosulfonyl)phenyl methacrylate,
m-(-naphthylaminosulfonyl)phenyl methacrylate,
p(-naphthylaminosulfonyl)phenyl methacrylate,
1-(3-aminosulfonyl)naphthyl methacrylate,
1-(3-methylaminosulfonyl)naphthyl methacrylate,
1-(3-ethylaminosulfonyl)naphthyl methacrylate,
o-methylsulfonylaminophenyl methacrylate,
m-methylsulfonylaminophenyl methacrylate,
p-methylsulfonylaminophenylmethacrylate,
o-ethylsulfonylaminophenyl methacrylate,
m-ethylsulfonylaminophenyl methacrylate,
p-ethylsulfonylaminophenyl methacrylate,
o-phenylsulfonylaminophenyl methacrylate,
m-phenylsulfonylaminophenyl methacrylate,
p-phenylsulfonylaminophenyl methacrylate,
o-(p-methylphenylsulfonylamino)phenyl methacrylate,
m-(p-metbylphenylsulfonylamino)phenyl methacrylate,
p-(p-methylphenylsulfonylamino)phenyl methacrylate,
p-(-naphthylsulfonylamino)phenyl methacrylate,
p-(-naphthylsulfonylamino)phenyl methacrylate,
2-methylsulfonylaminoethyl methacrylate,
2-ethylsulfonylaminoethyl methacrylate,
2-phenylsulfonylaminoethyl methacrylate,
2-p-methylphenylsulfonylaminoethyl methacrylate,
2-naphthylsulfonylaminoethyl methacrylate,
2-naphthylsulfonylaminoethyl methacrylate,
o-dimethylaminosulfonylphenyl methacrylate,
m-dimethylaminosulfonylphenyl methacrylate,
p-dimethylaminosulfonylphenyl methacrylate,
o-diethylaminosulfonylphenyl methacrylate,
m-diethylaminosulfonylphenyl methacrylate,
p-diethylaminosulfonylphenyl methacrylate, etc., and acrylates having the same substituents as above are exemplified.

In the monomers represented by any of formulae (Ic) to (Ie), as preferred substituents, R⁷ represents a hydrogen atom; R⁸ represents a methylene, phenylene or naphthylene group, each of which may be substituted; R⁹ represents a single bond or a methylene group; R¹⁰ represents an arylene group having 1 to 6 carbon atoms, or a phenylene or naphthylene group, each of which may be substituted; R¹¹, R¹² and R¹³ each represents a hydrogen atom, an alkyl or cycloalkyl group having 1 to 6 carbon atoms, or a phenyl or naphthyl group, each of which may be substituted; and R¹⁴ represents an alkyl or cycoalkyl group having 1 to 6 carbon atoms, or a phenyl or naphthyl group, each of which may be substituted.

The specific examples of the compounds represented by any of formulae (Ic) to (Ie) include p-aminosulfonylstyrene, p-aminosulfonyl-α-methylstyrene, p-aminosulfonylphenyl allyl ether, p-(N-methylaminosulfonyl)phenyl allyl ether, p-(N-dimethylaminosulfonyl)phenyl allyl ether, methyl-sulfonylaminovinyl acetate, phenylsulfonylaminovinyl acetate, methylsulfonylaminoallyl acetate, phenylsulfonylaminoallyl acetate, and p-methylsulfonylaminophenyl allyl ether.

The structural units having a sulfonamido group may be used in the specific polymer compound of the invention only by one kind alone, or two or more units may be used. From the viewpoint of press life and chemical resistance, the structural units having a sulfonamido group are contained in the specific polymer compound preferably in a range of from 1 to 80 mol%, more preferably from 10 to 80 mol%, and most preferably from 20 to 70 mol%.

### [A polymer compound having a cyclic structure derived from maleimide and a hydrophilic group in the molecule]

The photo-polymerization layer in the invention contains as a binder polymer a polymer compound having a cyclic structure derived from maleimide and a hydrophilic group in the molecule (hereinafter sometimes referred to as a specific polymer compound) as an essential component. By containing the specific polymer compound, chemical resistance and press life in printing using UV ink are improved and good on-press developing property can be obtained.

The cyclic structure derived from maleimide in the invention is a structural unit derived from maleimide having various substituents on unsubstituted maleimide or a nitrogen atom, and the cyclic structure is especially preferably a structure represented by the following formula (I).

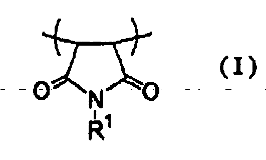

In formula (I), R¹ represents a hydrogen atom or a monovalent organic group that may have a substituent From the viewpoint of the improvement of chemical resistance, R¹ preferably represents a monovalent organic group that may have a substituent. As the monovalent organic group, an alkyl group having from 1 to 12 carbon atoms and an aryl group having from 6 to 14 carbon atoms are preferably used, and in the light of the improvement of chemical resistance, an aryl group is more preferably used, and a phenyl group is especially preferred.

As the substituents introducible to the organic group, acid groups showing alkali solubility, e.g., a hydroxyl group, a carboxyl group, a sulfonamido group, an active imido group, etc., polar substituents capable of hydrogen bonding and having a hydrogen atom or a hetero atom, e.g., an amido group, a cyano group, a nitro group, a carboxylic acid ester group, a sulfonic acid ester group, an acyl group, etc., hydrocarbon groups, e.g., an alkyl group, an aryl group, etc., and heterocyclic groups having an atom such as nitrogen, oxygen, sulfur, etc., in the ring are exemplified. As the substituent on the aryl group, a hydroxyl group or a sulfonamido group is preferred.

As the examples of the cyclic structures derived from maleimide that can be preferably used in the specific polymer compound of the invention, the following structures can be exemplified, but the invention is not restricted thereto.

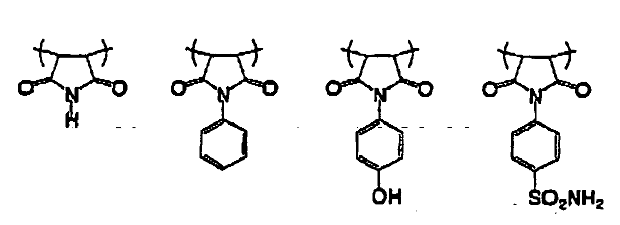

The cyclic structure derived from maleimide may be used in the specific polymer compound of the invention by one kind alone, or two or more structures may be used. In view of press life and chemical resistance, the cyclic structure derived from maleimide is contained in the specific polymer compound preferably in a range of from 10 to 80 mol%, and more preferably from 30 to 70 mol%.

Also, the specific polymer compound of the invention has a hydrophilic group. The hydrophilic group contributes to the provision of an on-press developing property to the photo-polymerization layer. As such hydrophilic groups, for example, a hydroxyl group, a carboxyl group, a carboxylate group, a hydroxyethyl group, an alkylene oxide structure, a hydroxypropyl group, a polyoxyethyl group, a polyoxypropyl group, an amino group, an aminoethyl group, an aminopropyl group, an ammonium group, an amido group, a carboxymethyl group, a sulfonic acid group, a phosphoric acid group, etc., are exemplified, and an amido group, a hydroxyl group, a polyoxyethyl group, and an alkylene oxide structure are preferred. An alkylene oxide structure represented by the following formula (II) is most preferred.

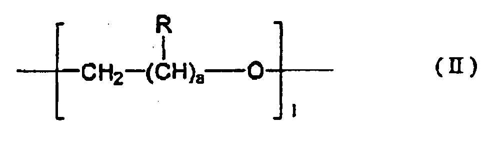

In formula (II), R represents a hydrogen atom or a methyl group; a represents an integer of 1, 3 or 5; and 1 represents an integer of from 1 to 9, preferably an integer of from 1 to 8, more preferably an integer of from 1 to 7, still more preferably an integer of from 1 to 6, and most preferably an integer of from 1 to 4.

The specific examples of the monomers having these hydrophilic groups include acrylamide, methacrylamide, N,N-dimethylacrylamide, N-isopropylacrylamide, N-vinyl-pyrrolidone, N-vinylacetamide, N-acryloylmorpholine, 2-hydroxyethyl acrylate, 2-hydroxyethyl methacrylate, polyoxyethylene monomethacrylate, polyoxyethylene monoacrylate, polyoxypropylene monomethacrylate, and polyoxypropylene monoacrylate. These monomers can be used by one kind alone, or in combination of two or more. The structural units having these hydrophilic groups are preferably used in the specific polymer compound in a range of from 1 to 85 mol%, and especially preferably from 5 to 70 mol%.

For the purpose of the enhancement of various performances such as image strength and the like, it is a preferred embodiment the specific polymer compound of the invention is copolymerized with other radical polymerizable monomers in addition to the monomers having the above substituents so long as the effect of the invention is not impaired. As the monomers copolymerizable with the specific polymer compound of the invention, monomers selected from, for example, acrylic acid esters, methacrylic acid esters, N,N-di-substituted acrylamides, N,N-di-substituted methacrylamides, styrenes, acrylonitriles, and methacrylonitriles are exemplified.

Specifically, acrylic acid esters, e.g., alkyl acrylate (the carbon atom number of the alkyl group is preferably from 1 to 20, specifically, methyl acrylate, ethyl acrylate, propyl acrylate, butyl acrylate, amyl acrylate, ethylhexyl acrylate, octyl acrylate, t-octyl acrylate, chloroethyl acrylate, 2,2-dimethylhydroxypropyl acrylate, 5-hydroxypentyl acrylate, trimethylolpropane monoacrylate, pentaerythritol monoacrylate, glycidyl acrylate, benzyl acrylate, methoxybenzyl acrylate, furfuryl acrylate, tetrahydrofurfuryl acrylate, etc.), aryl acrylate (e.g., phenyl acrylate, etc.), methacrylic acid esters, e.g., alkyl methacrylate (the carbon atom number of the alkyl group is preferably from 1 to 20, e.g., methyl methacrylate, ethyl methacrylate, propyl methacrylate, isopropyl methacrylate, amyl methacrylate, hexyl methacrylate, cyclohexyl methacrylate, benzyl methacrylate, chlorobenzyl methacrylate, octyl methacrylate, 4-hydroxybutyl methacrylate, 5-hydroxypentyl methacrylate, 2,2-dimethyl-3-hydroxypropyl methacrylate, trimethylolpropane mono-methacrylate, pentaerythritol monomethacrylate, glycidyl methacrylate, furfuryl methacrylate, tetrahydrofurfuryl methacrylate, etc.), aryl methacrylate (e.g., phenyl methacrylate, cresyl methacrylate, naphthyl methacrylate, etc.), styrene, styrene such as alkylstyrene (e.g., methylstyrene, dimethylstyrene, trimethylstyrene, ethyl-styrene, diethylstyrene, isopropylstyrene, butylstyrene, hexylstyrene, cyclohexylstyrene, decylstyrene, benzylstyrene, chloromethylstyrene, trifluoromethylstyrene, ethoxymethyl-styrene, acetoxymethylstyrene, etc.), alkoxystyrene (e.g., methoxystyrene, 4-methoxy-3-methylstyrene, dimethoxystyrene, etc.), halogenostyrene, (e.g., chlorostyrene, dichloro-styrene, trichlorostyrene, tetrachlorostyrene, pentachloro-styrene, bromostyrene, dibromostyrene, iodostyrene, fluoro-styrene, trifluorostyrene, 2-bromo-4-trifluoromethylstyrene, 4-fluoro-3-trifluoromethylstyrene, etc.), acrylonitrile, methacrylonitrile, etc., are exemplified.

Moreover, the specific polymer compound of the invention may contain an ester group represented by the following formula (III) or an amido group represented by the following formula (IV) in the molecule.

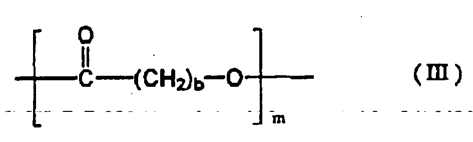

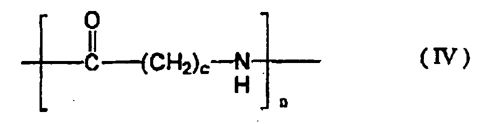

In the formulae, b represents an integer of from 2 to 5, c represents an integer of from 2 to 7, and m and n each represents an integer of from 1 to 100.

Of these radical polymerizable monomers, acrylic acid esters, methacrylic acid esters and styrenes are preferably used. These monomers can be used by one kind alone, or two or more, and they are used preferably in a range of from 0 to 95 mol%, and especially preferably from 20 to 90 mol%.

The specific polymer compound of the invention may be any of a block copolymer, a random copolymer and a graft copolymer.

As the solvents for use in synthesizing these polymer compounds, e.g., ethylene dichloride, cyclohexanone, methyl ethyl ketone, acetone, methanol, ethanol, propanol, butanol, ethylene glycol monomethyl ether, ethylene glycol monoethyl ether, 2-methoxyethyl acetate, 1-methoxy-2-propanol, 1-methoxy-2-propyl acetate, N,N-dimethylformamide, N,N-dimethylacetamide, dimethyl sulfoxide, toluene, ethyl acetate, methyl lactate, ethyl lactate, etc., are exemplified. These solvents may be used alone, or two or more kinds may be used as mixture.

The mass average molecular weight Mw of the specific polymer compound of the invention is preferably 2,000 or more, and more preferably from 5,000 to 500,000. Further, unreacted monomer may be contained in the specific polymer compound of the invention. In this case, the unreacted monomer preferably accounts for the proportion of 15 mass% or less of the specific polymer compound of the invention.

The content of the specific polymer compound of the invention in the photo-polymerization layer is preferably about 5 to 95 mass% as solid content, and more preferably about 10 to 85 mass%. In this range of the content, good strength of an image part and an image-forming property can be obtained.

The specific polymer compound according to the invention can be obtained by copolymerization of the monomer having a sulfonamido group of the precursor of the sulfonamido group or maleimide of the precursor of the cyclic structure, with the radical polymerizable monomer having a hydrophilic group in a proper solvent by using any known polymerization initiator.

The specific examples of the constitutional units of the specific polymer compounds used as the binder polymers in the invention are shown below, but the invention is not limited thereto. 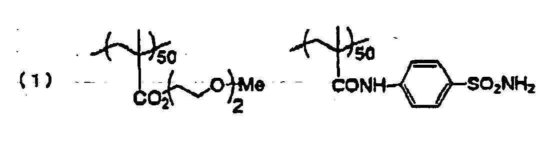 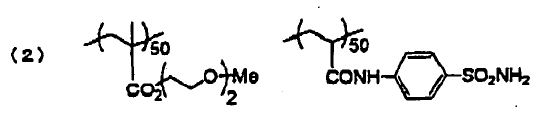 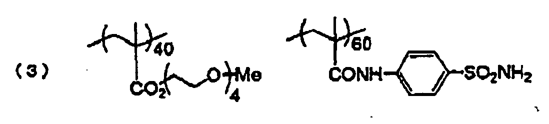 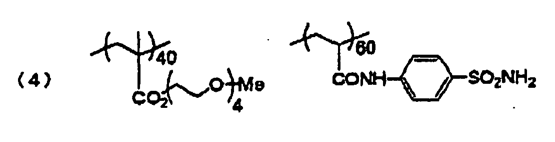 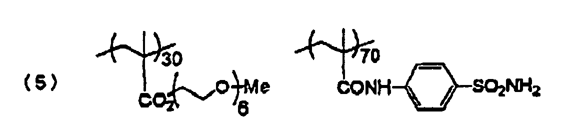 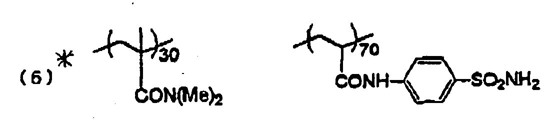 *Reference Example 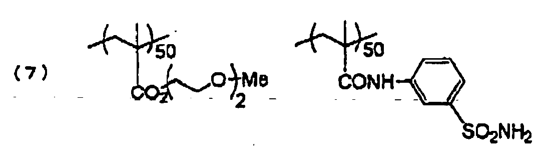 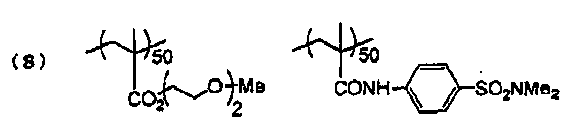 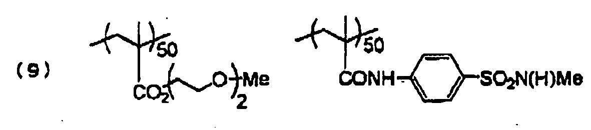 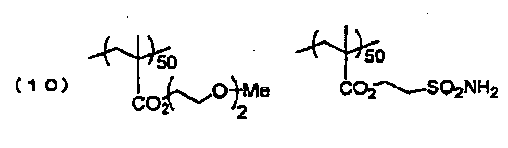 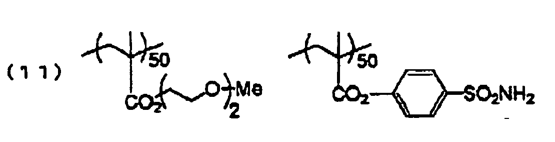 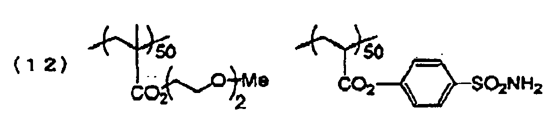 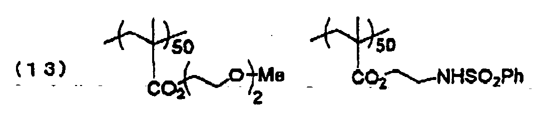 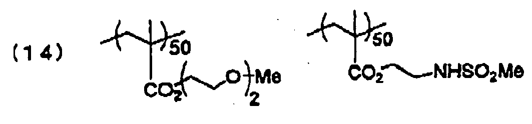 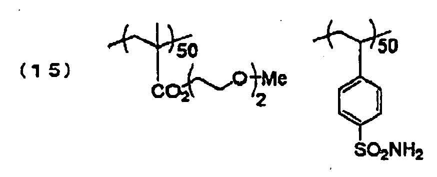 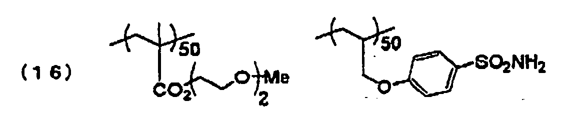 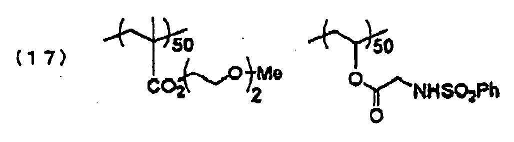 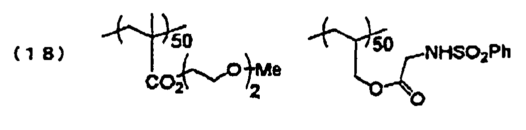 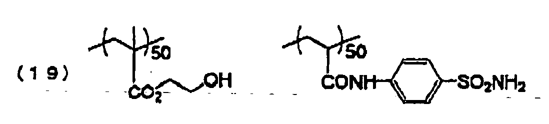 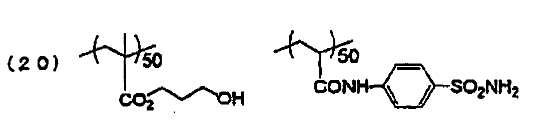 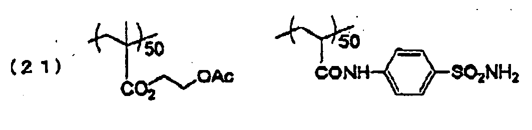 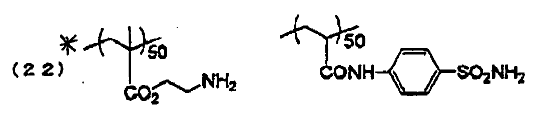 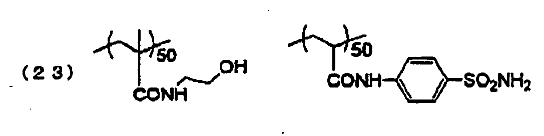 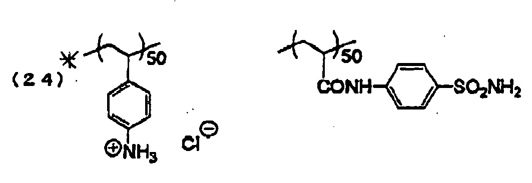 *Reference Example 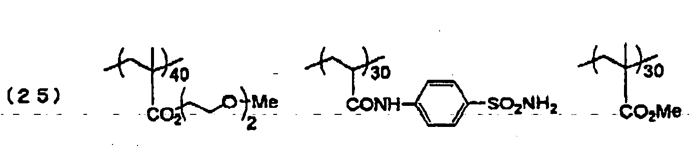 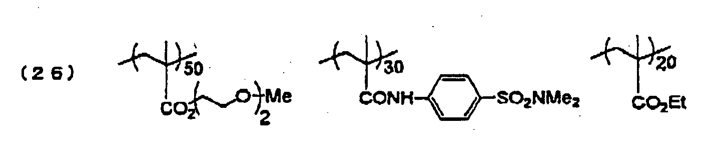 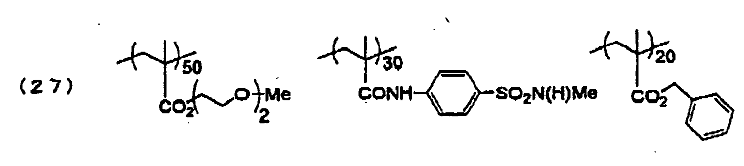 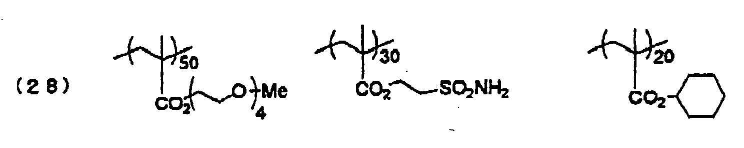 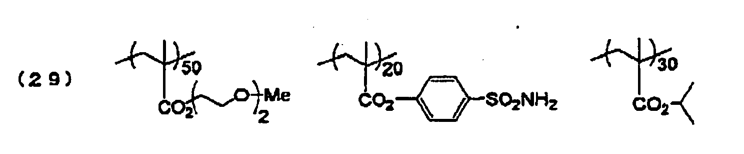 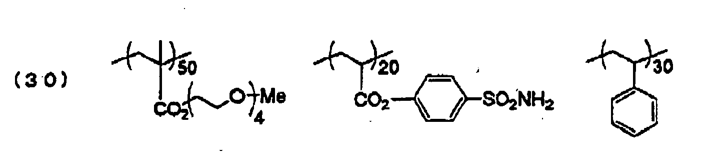 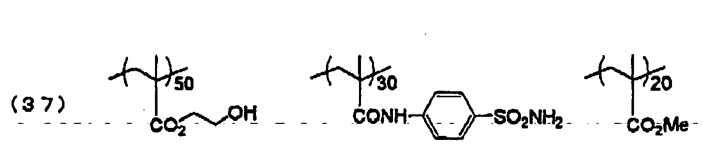 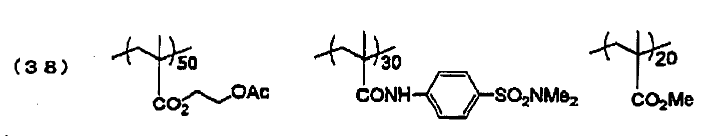 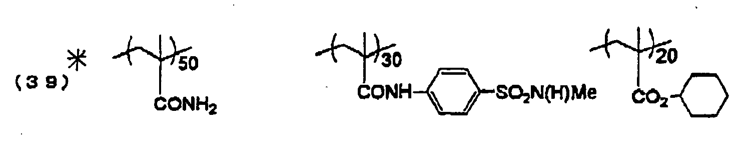 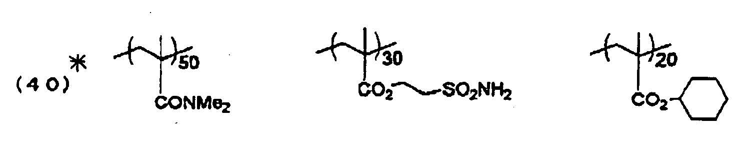 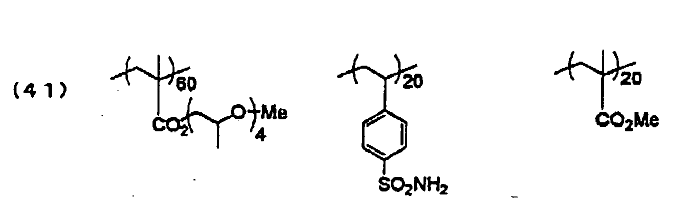 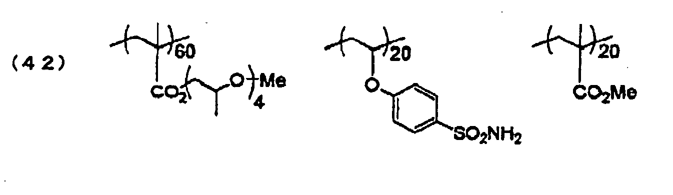 *Reference Example 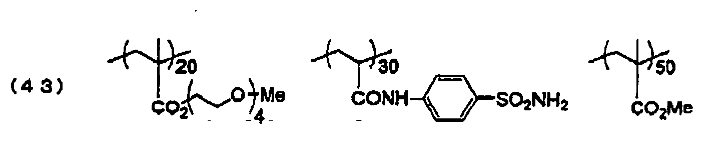 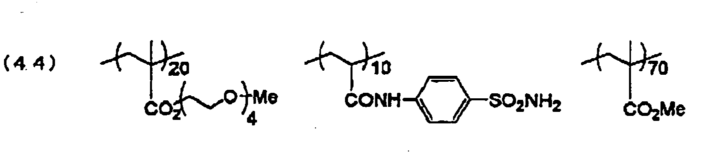 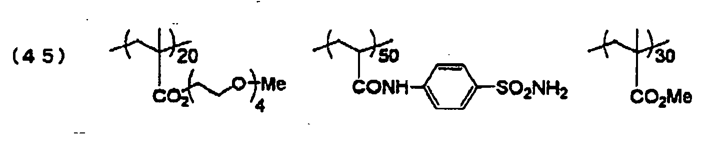 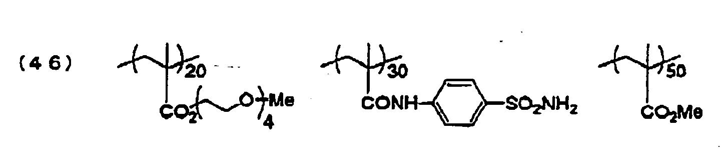 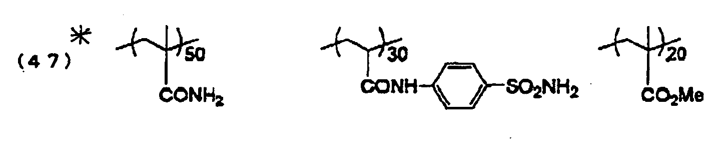 *Reference Example 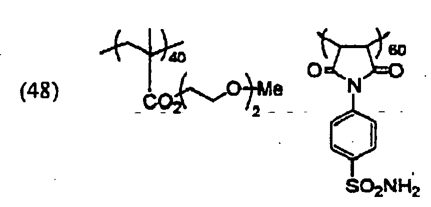 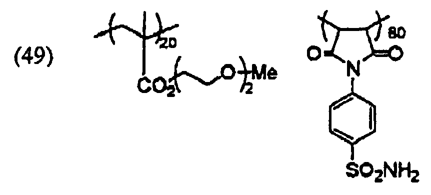 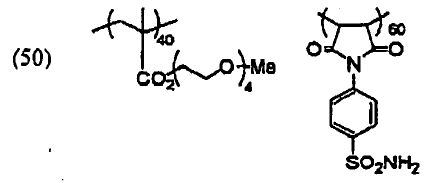 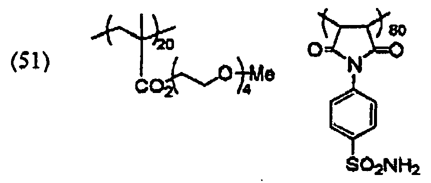 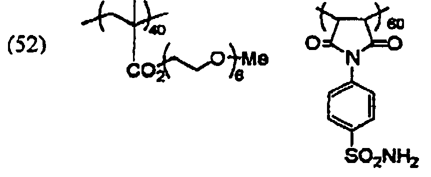 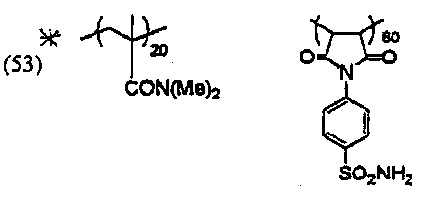 *Reference Example 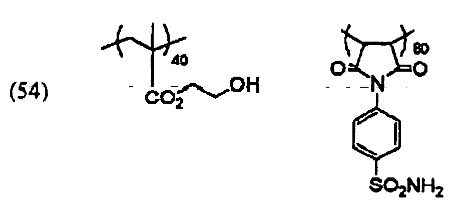 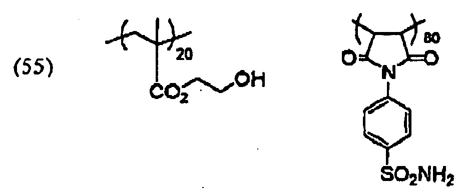 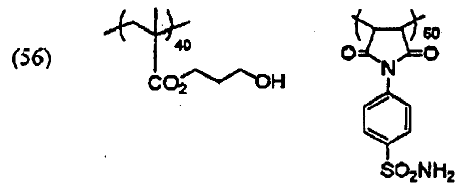 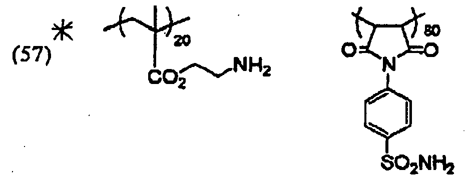 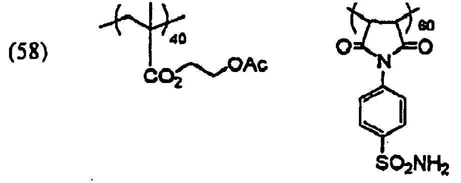 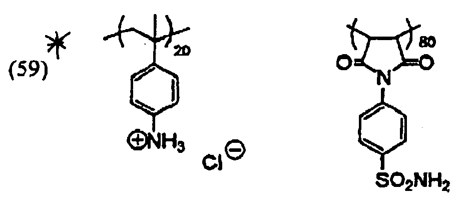 *Reference Example 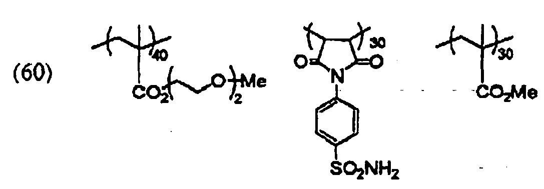 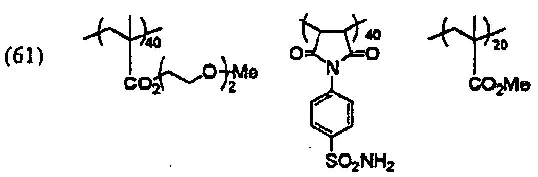 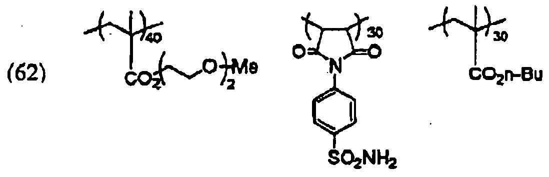 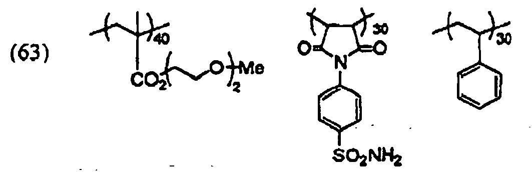 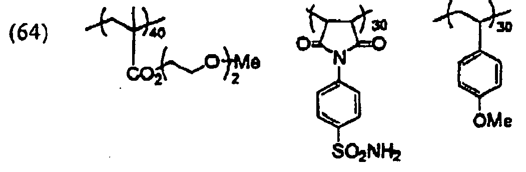 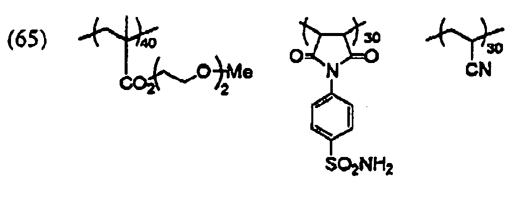 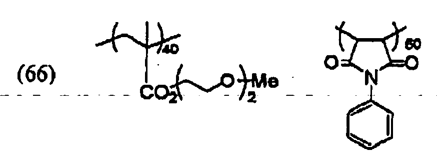 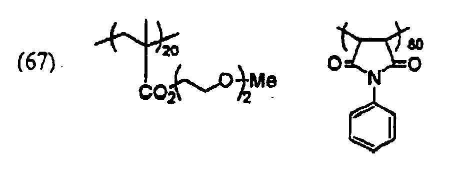 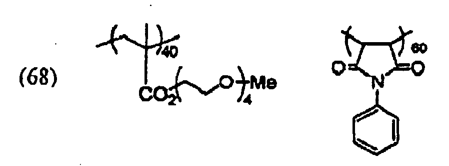 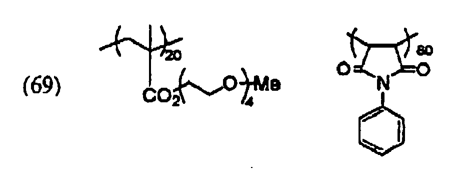 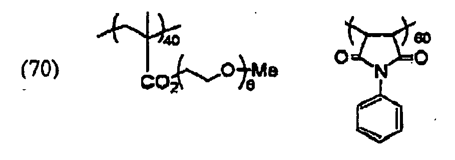 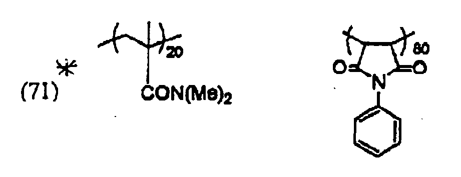 *Reference Example 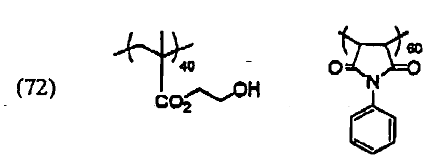 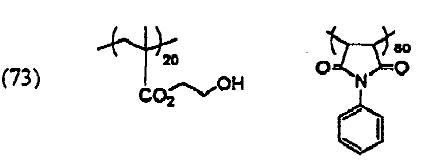 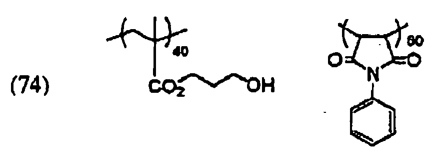 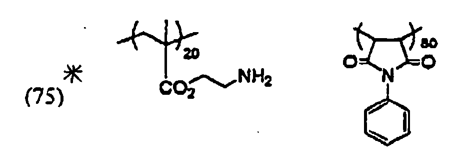 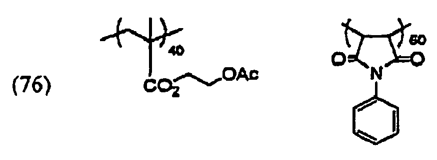 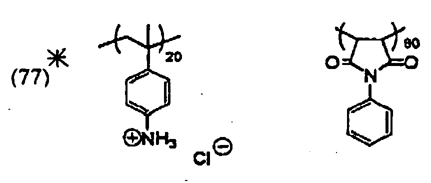 *Reference Example

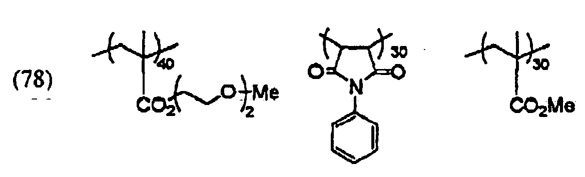

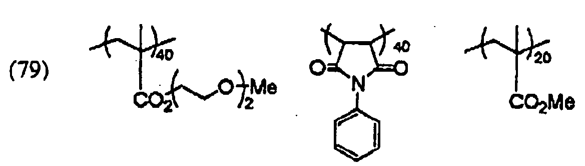

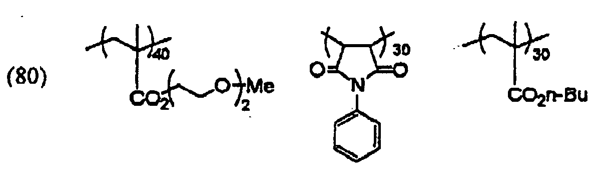

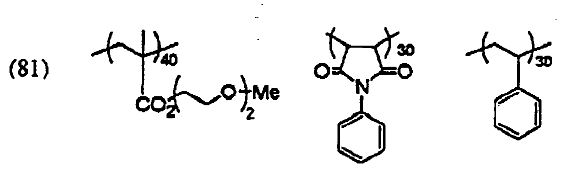

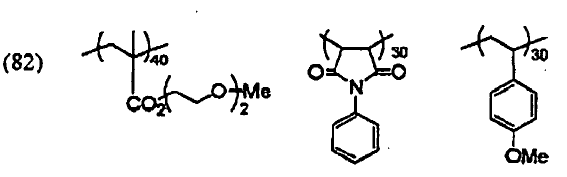

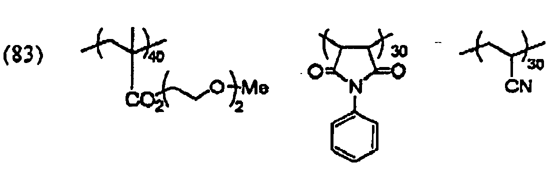

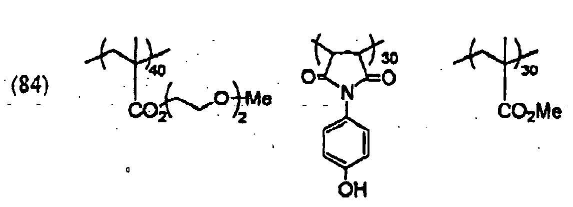

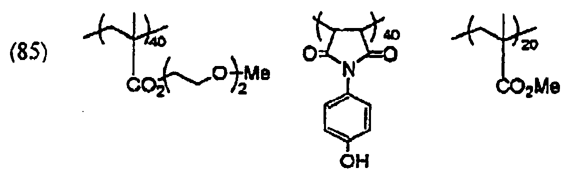

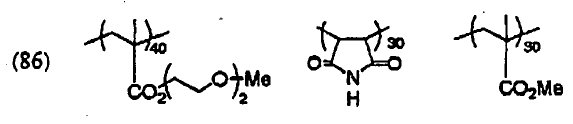

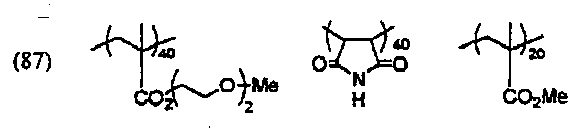

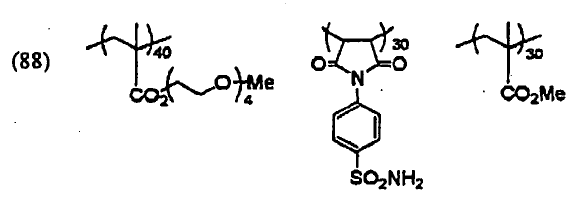

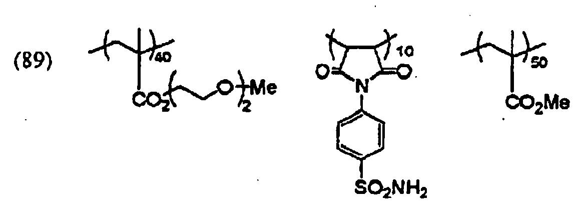

### [Other binder polymers]

In addition to the specific polymer compounds, conventionally known binder polymers can be used in the invention with no restriction, and linear organic polymers having a film-forming property are preferably used. The examples of such binder polymers include acrylic resins, polyvinyl acetal resins, polyurethane resins, polyurea resins, polyimide resins, polyamide resins, epoxy resins, methacrylic resins, polystyrene resins, novolak type phenolic resins, polyester resins, synthetic rubbers, and natural rubbers.

It is preferred that binder polymers have a crosslinking property for the purpose of improving the film strength of an image part. For giving a crosslinkable property to binder polymers, it is effective to introduce a crosslinkable functional group such as an ethylenic unsaturated bond into the main chain or side chain of the polymers. The crosslinkable functional group may be introduced by copolymerization.

As the examples of polymers having an ethylenic unsaturated bond in the main chain of the molecule, poly-1,4-butadiene, poly-1,4-isoprene, and the like are exemplified.

As the examples of the polymers having an ethylenic unsaturated bond in the side chain of the molecule, polymers of esters or amides of acrylic acid or methacrylic acid, wherein the residue of the ester or amide (R of -COOR or -CONHR) has an ethylenic unsaturated bond are exemplified.

As the examples of the residues having an ethylenic unsaturated bond (the above R), -(CH₂)ₙCR¹=CR²R³, -(CH₂O)ₙCH₂CR¹=CR²R³, -(CH₂CH₂O)ₙCH₂CR¹=CR²R³, -(CH₂)ₙNH-CO-O-CH₂CR¹=CR²R³, -(CH₂)ₙ-O-CO-CR¹=CR²R³ and -(CH₂CH₂O)₂-X are exemplified (in the formulae, R¹, R² and R³ each represents a hydrogen atom, a halogen atom, an alkyl group having from 1 to 20 carbon atoms, an aryl group, an alkoxyl group or an aryloxy group, and R¹ and R² or R³ may be bonded to each other to form a ring, n represents an integer of from I to 10, and X represents a dicyclopentadienyl residue).

The specific examples of the ester residues include -CH₂CH=CH₂ (disclosed in JP-B-7-21633) (the term "JP-B" as used herein refers to an "examined Japanese patent publication"), -CH₂CH₂O-CH₂CH=CH₂, -CH₂C(CH₃)=CH₂, -CH₂CH=CH-C₆H₅, -CH₂CH₂OCOCH=CH-C₆H₅, -CH₂CH₂-NHCOO-CH₂CH=CH₂ and -CH₂CH₂O-X (wherein X represents a dicyclopentadienyl residue).

The specific examples of the amido residues include -CH₂CH=CH₂, -CH₂CH₂-Y (wherein Y represents a cyclohexene residue), and -CH₂CH₂-OCO-CH=CH₂.

By the addition of a free radical (a polymerization initiation radical or a grown radical in the polymerization process of a polymerizable monomer) to a crosslinkable functional group of a binder polymer having a crosslinking property, addition polymerization occurs directly between the polymers or via the polymerization chain of the polymerizable monomer, as a result, crosslinking is formed between the molecules of the polymer, and the binder polymer is hardened. Alternatively, the atoms in the polymer (e.g., the hydrogen atoms on the carbon atoms contiguous to the functional crosslinking group) are extracted by the free radical and polymer radicals are grown, and the polymer radicals are bonded to each other, whereby crosslinking is formed between the polymer molecules, and the binder polymer is hardened.

The content of crosslinkable groups in a binder polymer (the content of radical polymerizable unsaturated double bonds by an iodometric titration method) is preferably from 0.1 to 10.0 mmol per gram of the binder polymer, more preferably from 1.0 to 7.0 mmol, and most preferably from 2.0 to 5.5 mmol. Good sensitivity and good preservation stability can be obtained with this range of the content of crosslinkable groups.

From the viewpoint of the improvement of an on-press developing property, the binder polymer is preferably high in solubility or dispersibility in at least one of ink and a fountain solution.

For the enhancement of solubility or dispersibility in ink, the binder polymer is preferably lipophilic, and for the improvement of solubility in a fountain solution, the binder polymer is preferably hydrophilic. Therefore, it is also preferred in the invention to use a lipophilic binder polymer and a hydrophilic binder polymer in combination.

As hydrophilic binder polymers, binder polymers having a hydrophilic group, e.g., a hydroxyl group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amido group, a carboxymethyl group, a sulfo group and a phosphoric acid group are preferably exemplified.

The specific examples of hydrophilic binder polymers include gum arabic, casein, gelatin, starch derivative, carboxymethyl cellulose and the sodium salts thereof, cellulose acetate, sodium alginate, vinyl acetate-maleic acid copolymers, styrenemaleic acid copolymers, polyacrylic acids and the salts thereof, polymethacrylic acids and the salts thereof, homopolymers and copolymers of hydroxyethyl methacrylate, homopolymers and copolymers of hydroxyethyl acrylate, homopolymers and copolymers of hydroxypropyl methacrylate, homopolymers and copolymers of hydroxypropyl acrylate, homopolymers and copolymers of hydroxybutyl methacrylate, homopolymers and copolymers of hydroxybutyl acrylate, polyethylene glycols, hydroxypropylene polymers, polyvinyl alcohols, hydrolyzed polyvinyl acetate having a hydrolysis degree of 60 mol% or more, preferably 80 mol% or more, polyvinyl formal, polyvinyl butyral, polyvinyl pyrrolidone, homopolymers and copolymers of acrylamide, homopolymers and copolymers of methacrylamide, homopolymers and copolymers of N-methylolacrylamide, alcohol-soluble nylon, and polyether of 2,2-bis(4-hydroxyphenyl)propane and epichlorohydrin.

The binder polymers have a mass average molecular weight of preferably 5,000 or higher, more preferably from 10,000 to 300,000, and a number average molecular weight of preferably 1,000 or higher, more preferably from 2,000 to 250,000. The degree of polydispersion (mass average molecular weight/ number average molecular weight) is preferably from 1.1 to 10.

The binder polymers may be any of random polymers, block polymers and graft polymers, but random polymers are preferred. The binder polymers may be used alone or as a mixture of two or more.

The binder polymers are available commercially or can be synthesized by conventionally known methods. As the solvents for use in the synthesis, e.g., tetrahydrofuran, ethylene dichloride, cyclohexanone, methyl ethyl ketone, acetone, methanol, ethanol, ethylene glycol monomethyl ether, ethylene glycol monoethyl ether, 2-methoxyethyl acetate, diethylene glycol dimethyl ether, 1-methoxy-2-propanol, 1-methoxy-2-propyl acetate, N,N-dimethylformamide, N,N-dimethylacetamide, toluene, ethyl acetate, methyl lactate, ethyl lactate, dimethyl sulfoxide, and water are exemplified. These solvents may be used alone or two or more solvents may be used as a mixture.

As the radical polymerization initiators used in the synthesis of the binder polymer, known compounds, e.g., azo initiators and peroxide initiators can be used.

The binder polymer is used in a range of from 0 to 90 mass% to all the solids content of the photo-polymerization layer, more preferably from 0 to 80 mass%, and still more preferably from 0 to 70 mass%. When the binder polymer is used in this range, good image part strength and good image-forming property can be obtained.

### [Infrared absorber]

When the lithographic printing plate precursor of the invention is subjected to image formation with a laser light source emitting infrared rays of from 760 to 1,200 nm, it is preferred to contain an infrared absorber in the photo-polymerization layer. Infrared absorbers have a function to convert absorbed infrared rays to heat. A radical is generated by thermal decomposition of a polymerization initiator described later (a radical generator) by the heat generated at this time. Infrared absorbers for use in the invention are dyes or pigments having an absorption maximum in the wavelengths of from 760 to 1,200 nm.

As dyes for this purpose, commercially available dyes and known dyes described in literatures, e.g., Senryo Binran (Dye Handbook), compiled by Yuki Gosei Kagaku Kyokai (1970), and the like can be used. Specifically, azo dyes, metal complex salt azo dyes, pyrazolone azo dyes, naphthoquinone dyes, anthraquinone dyes, phthalocyanine dyes, carbonium dyes, quinoneimine dyes, methine dyes, cyanine dyes, squarylium dyestuffs, pyrylium salts and metal thiolate complexes are exemplified.

As preferred dyes, e.g., the cyanine dyes disclosed in JP-A-58-125246, JP-A-59-84356 and JP-A-60-78787, the methine dyes disclosed in JP-A-58-173696, JP-A-58-181690 and JP-A-58-194595, the naphthoquinone dyes disclosed in JP-A-58-112793, JP-A-58-224793, JP-A-59-48187, JP-A-59-73996, JP-A-60-52940 and JP-A-60-63744, the squarylium dyestuffs disclosed in JP-A-58-112792, and the cyanine dyes disclosed in British Patent 434,875 are exemplified.

Further, the near, infrared absorbing sensitizers disclosed in U.S. Patent 5,156,938 are also preferably used, in addition, the substituted arylbenzo(thio)pyrylium salts disclosed in U.S. Patent 3,881,924, the trimethine thiapyrylium salts disclosed in JP-A-57-142645 (corresponding to U.S. Patent 4,327,169), the pyrylium compounds disclosed in JP-A-58-181051, JP-A-58-220143, JP-A-59-41363, JP-A-59-84248, JP-A-59-84249, JP-A-59-146063 and JP-A-59-146061, the cyanine dyestuffs disclosed in JP-A-59-216146, the pentamethine thiopyrylium salts disclosed in U.S. Patent 4,283,475, and the pyrylium compounds disclosed in JP-B-5-13514 and JP-B-5-19702 are also preferably used in the invention. As other examples of preferred dyes, the near infrared absorbing dyes disclosed in U.S. Patent 4,756,993 as the compounds represented by formula (I) or (II) can be exemplified.

As other preferred examples of infrared absorbers for use in the invention, the specific indolenine cyanine dyestuffs disclosed in JP-A-2002-278057 as shown below are exemplified.

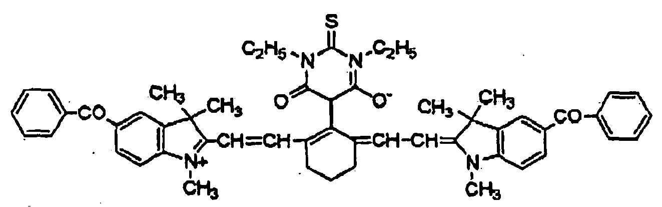

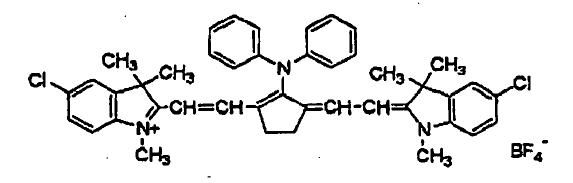

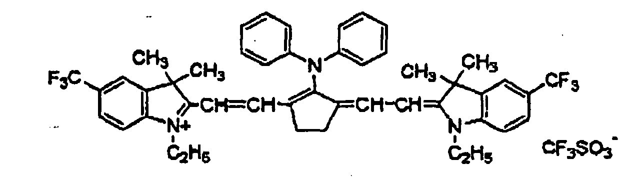

Of these dyes, the especially preferred dyes are cyanine dyestuffs, squarylium dyestuffs, pyrylium salts, nickel thiolate complexes, and indolenine cyanine dyestuffs. Cyanine dyestuffs and indolenine cyanine dyestuffs are more preferred, and as an especially preferred example, a cyanine dyestuff represented by the following formula (i) is exemplified.

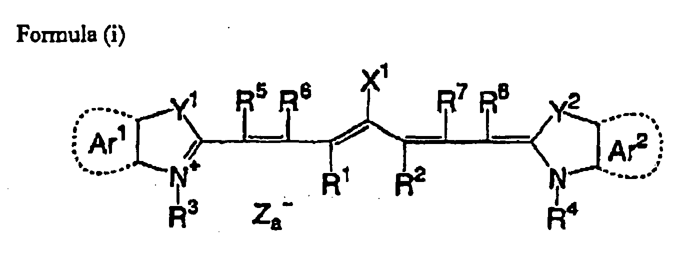

In formula (i), X¹ represents a hydrogen atom, a halogen atom, -NPh₂, X²-L¹, or a group shown below. 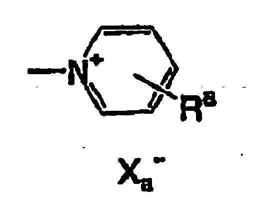
x² represents an oxygen atom, a nitrogen atom, or a sulfur atom; and L¹ represents a hydrocarbon group having from 1 to 12 carbon atoms, an aromatic ring having a hetero atom, or a hydrocarbon group having from 1 to 12 carbon atoms and containing a hetero atom. The hetero atom here means N, S, O, a halogen atom or Se.
Xₐ⁻ is defined as the same with the later-described Zₙ⁻; and R^{a} represents a substituent selected from a hydrogen atom, an alkyl group, an aryl group, a substituted or unsubstituted amino group, and a halogen atom.
R¹ and R² in formula (i) each represents a hydrocarbon group having from 1 to 12 carbon atoms. In view of the preservation stability of a recording layer coating solution, R¹ and R² each preferably represents a hydrocarbon group having 2 or more carbon atoms, and especially preferably R¹ and R² are bonded to each other to form a 5- or 6-membered ring.
Ar¹ and Ar², which may be the same or different, each represents an aromatic hydrocarbon group that may have a substituent. The examples of preferred aromatic hydrocarbon groups include a benzene ring and a naphthalene ring. The preferred examples of the substituents include a hydrocarbon group having 12 or less carbon atoms, a halogen atom, and an alkoxyl group having 12 or less carbon atoms. Y¹ and Y², which may be the same or different, each represents a sulfur atom or a dialkylmethylene group having 12 or less carbon atoms. R³ and R⁴, which may be the same or different, each represents a hydrocarbon group having 20 or less carbon atoms that may have a substituent. The preferred examples of the substituents include an alkoxyl group having 12 or less carbon atoms, a carboxyl group and a sulfo group. R⁵, R⁶, R⁷ and R⁸, which may be the same or different, each represents a hydrogen atom or a hydrocarbon group having 12 or less carbon atoms, preferably a hydrogen atom for easy availability of the material. Zₙ⁻ represents a counter anion, provided that when a cyanine dyestuff represented by formula (i) has an anionic substituent in the structure and the neutralization of the electric charge is not necessary, Zₐ⁻ is not necessary. Zₙ⁻ preferably represents a halogen ion, a perchlorate ion, a tetrafluoroborate ion, a hexafluorophosphate ion, or a sulfonate ion in view of the preservation stability of the recording layer coating solution, and a perchlorate ion, a hexafluorophosphate ion, and an arylsulfonate ion are especially preferred.

As the specific examples of the cyanine dyestuffs represented by formula (i) that can be preferably used in the invention, those disclosed in JP-A-2001-133969, paragraphs [0017] to [0019] are exemplified.

Further, as especially preferred other examples, the specific indolenine cyanine dyestuffs disclosed in JP-A-2002-278057 are exemplified.

As the pigments for use in the invention, commercially available pigments and the pigments described in Color Index (C.I.) Binran (Color Index Bulletin), Saishin Ganryo Binran (The Latest Pigment Handbook), compiled by Nippon Ganryo Gijutsu Kyokai (1977), Saishin Ganryo Oyo Gijutsu (The Latest Pigment Applied Techniques), CMC Publishing Co. Ltd. (1986), and Insatsu Ink Gijutsu (Printing Ink Techniques), CMC Publishing Co. Ltd. (1984) can be used.

Various kinds of pigments can be used in the invention, e.g., black pigments, yellow pigments, orange pigments, brown pigments, red pigments, purple pigments, blue pigments, green pigments, fluorescent pigments, metallic powder pigments, and polymer-bond pigments can be exemplified. Specifically, insoluble azo pigments, azo lake pigments, condensation azo pigments, chelate azo pigments, phthalocyanine pigments, anthraquinone pigments, perylene and perinone pigments, thioindigo pigments, quinacridone pigments, dioxazine pigments, isoindolinone pigments, quinophthalone pigments, dyed lake pigments, azine pigments, nitroso pigments, nitro pigments, natural pigments, fluorescent pigments, inorganic pigments, and carbon black can be used. Of these pigments, carbon black is preferably used.

These pigments can be used without surface treatment or may be surface-treated. As the methods of surface treatments, a method of coating the surfaces of pigments with resins and waxes, a method of adhering surfactants, and a method of bonding reactive substances (e.g., silane coupling agents, epoxy compounds, or polyisocyanate) on the surfaces of pigments can be exemplified, These surface treatment methods are described in Kinzoku Sekken no Seishitsu to Oyo (Natures and Applications of Metal Soaps), Saiwai Shobo Co., Ltd., Insatsu Ink Gijutsu (Printing Ink Techniques), CMC Publishing Co., Ltd. (1984), and Saishin Ganryo Oyo Giiutsu (The Latest Pigment Applied Techniques), CMC Publishing Co., Ltd. (1986).

The particle size of pigments is preferably in the range of from 0.01 to 10 µm, more preferably in the range of from 0.05 to 1 µm, and especially preferably in the range of from 0.1 to 1 µm. When the particle size of pigments is in this range, good stability of the pigment dispersion in a photo-polymerization layer coating solution and good uniformity of the photo-polymerization layer can be obtained.

Well-know dispersing methods used in the manufacture of inks and toners can be used as the dispersing methods of pigments. The examples of dispersing apparatus include an ultrasonic wave disperser, a sand mill, an attritor, a pearl mill, a super-mill, a ball mill, an impeller, a disperser, a KD mill, a colloid mill, a dynatron, a three-roll mill and a pressure kneader, and details are described in Saishin Ganryo Oyo Gijutsu (The Latest Pigment Applied Techniques), CMC Publishing Co., Ltd. (1986).

These infrared absorbers may be added to the same layer with other components, or a different layer may be provided and added thereto. However, when a negative lithographic printing plate precursor is prepared, infrared absorbers are added so that the absorbance of the photo-polymerization layer at the maximum absorption wavelength in the range of wavelengths of from 760 to 1,200 nm is from 0.3 to 1.2 by reflection measuring method, and preferably in the range of from 0.4 to 1.1. In this range of the addition amount of infrared absorbers, the polymerization reaction proceeds uniformly in the depth direction of the photo-polymerization layer and good film strength of the image part and the adhesion to the support can be obtained.

The absorbance of the photo-polymerization layer can be adjusted by the amount of an infrared absorber added to the photo-polymerization layer and the thickness of the photo-polymerization layer. Absorbance can be measured by ordinary methods. As measuring methods, e.g., a method of forming a photo-polymerization layer having a thickness arbitrarily determined in a dry coating weight necessary as the lithographic printing plate on a reflective support, e.g., an aluminum support, and measuring the reflection density with an optical densitometer, and a method of measuring the absorbance by a reflection method using an integrating sphere with a spectrophotometer are exemplified.

### [Polymerization initiator]

Polymerization initiators can be used in the photo-polymerization layer of the invention. Polymerization initiators for use in the invention are compounds capable of generating a radical by light or heat, or both energies, and initiating and accelerating the polymerization of a compound having a polymerizable unsaturated group. Various kinds of polymerization initiators known in patents and literatures or polymerization initiators of combined use system of two or more kinds can be arbitrarily selected and used according to the wavelength of the light source to be used.

As compounds capable of generating radicals, e.g., an organohalogen compound, a carbonyl compound, an organo-peroxide, an azo-based polymerization initiator, an azide compound, a metallocene compound, a hexaarylbiimidazole compound, an organoboron compound, a disulfone compound, an oxime ester compound, and an onium salt compound are exemplified.

As the organohalogen compounds, specifically, the compounds described in Wakabayashi et al., Bull. Chem. Soc. Japan, 42, 2924 (1969), U.S. Patent 3,905,815, JP-B-46-4605, JP-A-48-36281, JP-A-55-32070, JP-A-60-239736, JP-A-61-169835, JP-A-61-169837, JP-A-62-58241, JP-A-62-212401, JP-A-63-70243, JP-A-63-298339, and M.P. Hutt, Journal of Heterocyclic Chemistry, 1 (No. 3) (1970) are exemplified. Of these compounds, oxazole compounds substituted with a trihalomethyl group and S-triazine compounds are preferably used.

More preferably, s-triazine derivatives wherein at least one mono-, di- or trihalogen-substituted methyl group is bonded to the s-triazine ring are exemplified. Specifically, e.g., 2,4,6-tris(monochloromethyl)-s-triazine, 2,4,6-tris-(dichloromethyl)-s-triazine, 2,4,6-tris(trichloromethyl)-s-triazine, 2-methyl-4,6-bis(trichloromethyl)-s-triazine, 2-n-propyl-4,6-bis(trichloromethyl)-s-triazine, 2-(α,α,β-trichloroethyl)-4,6-bis(trichloromethyl)-s-triazine, 2-phenyl-4,6-bis(trichloromethyl)-s-triazine, 2-(p-methoxyphenyl)-4,6-bis(trichloromethyl)-s-triazine, 2-(3,4-epoxyphenyl)-4,6-bis(trichloromethyl)-s-triazine, 2-(p-chlorophenyl)-4,6-bis(trichloromethyl)-s-triazine, 2-[1-(p-methoxyphenyl)-2,4-butadienyl]-4,6-bis-(trichloromethyl)-s-triazine, 2-styryl-4,6-bis(trichloromethyl)-s-triazine, 2-(p-methoxystyryl)-4,6-bis(trichloromethyl)-s-triazine, 2-(p-isopropyloxystyryl)-4,6-bis(trichloromethyl)-s-triazine, 2-(p-tolyl)-4,6-bis(trichloromethyl)-s-triazine, 2-(4-methoxynaphthyl)-4,6-bis(trichloromethyl)-s-triazine, 2-phenylthio-4,6-bis(trichloromethyl)-s-triazine, 2-benzylthio-4,6-bis(trichloromethyl)-s-triazine, 2,4,6-tris(dibromomethyl)-s-triazine, 2,4,6-tris(tribromomethyl)-s-triazine, 2-methyl-4,6-bis(tribromomethyl)-s-triazine, 2-methoxy-4,6-bis(tribromomethyl)-s-triazine, etc., are exemplified.

As the carbonyl compounds, benzophenone derivatives, e.g., benzophenone, Michler's ketone, 2-methylbenzophenone, 3-methylbenzophenone, 4-methylbenzophenone, 2-chlorobenzo-phenone, 4-bromobenzophenone, 2-carboxybenzophenone, etc., acetophenone derivatives, e.g., 2,2-dimethoxy-2-phenylacetophenone, 2,2-diethoxyacetophenone, 1-hydroxycyclohexyl phenyl ketone, α-hydroxy-2-methylphenylpropanone, 1-hydroxy-1-methylethyl-(p-isopropylphenyl) ketone, 1-hydroxy-1-(p-dodecylphenyl) ketone, 2-methyl-[4'-(methylthio)phenyl]-2-morpholino-1-propanone, 1,1,1-trichloromethyl-(p-butyl-phenyl) ketone, etc., thioxanthone derivatives, e.g., thioxanthone, 2-ethylthioxanthone, 2-isopropylthioxanthone, 2-chlorothioxanthone, 2,4-dimethylthioxanthone, 2,4-diethylthioxanthone, 2,4-diisopropylthioxanthone, etc., and benzoate derivatives, e.g., ethyl p-dimethylaminobenzoate, ethyl p-diethylaminobenzoate, etc., are exemplified.

As the azo compounds, e.g., the azo compounds disclosed in JP-A-8-108621 can be used.

As the organoperoxides, e.g., trimethylcyclohexanone peroxide, acetylacetone peroxide, 1,1-bis(tert-butylperoxy)-3,3,5-trimethylcyclohexane, 1, 1-bis(tert-butylperoxy)cyclo-hexane, 2,2-bis(tert-butylperoxy)butane, tert-butyl hydro-peroxide, cumene hydroperoxide, diisopropylbenzene hydro-peroxide, 2,5-dimethylhexane-2,5-dihydroperoxide, 1,1,3,3-tetramethylbutyl hydroperoxide, tert-butylcumyl peroxide, dicumyl peroxide, 2,5-dimethyl-2,5-di(tert-butylperoxy)-hexane, 2,5-oxanoyl peroxide, succinic acid peroxide, benzoyl peroxide, 2,4-dichlorobenzoyl peroxide, diisopropylperoxy dicarbonate, di-2-ethylhexylperoxy dicarbonate, di-2-ethoxyethylperoxy dicarbonate, dimethoxyisopropylperoxy carbonate, di(3-methyl-3-methoxybutyl)peroxy dicarbonate, tert-butyl-peroxy acetate, tert-butylperoxy pivalate, tert-butylperoxy neodecanoate, tert-butylperoxy octanoate, tert-butylperoxy laurate, tertiary carbonate, 3,3',4,4'-tetra(t-butylperoxy-carbonyl)benzophenone, 3,3',4,4'-tetra(t-hexylperoxy-carbonyl)benzophenone, 3,3',4,4'-tetra(p-isopropylcumylperoxycarbonyl)benzophenone, carbonyldi(t-butylperoxy-dihydrogendiphthalate), carbonyldi(t-hexylperoxydihydrogen-diphthalate), etc., are exemplified.

As the metallocene compounds, various titanocene compounds disclosed in JP-A-59-152396, JP-A-61-151197, JP-A-63-41484, JP-A-2-249, JP-A-2-4705 and JP-A-5-83588, e.g., dicyclopentadienyl-Ti-bis-phenyl, dicyclopentadienyl-Ti-bis-2,6-difluorophen-1-yl, dicyclopentadienyl-Ti-bis-2,4-difluorophen-1-yl, dicyclopentadienyl-Ti-bis-2,4,6-trifluorophen-1-yl, dicyclopentadienyl-Ti-bis-2,3,5,6-tetrafluorophen-1-yl, dicyclopentadienyl-Ti-bis-2,3,4,5,6-pentafluorophen-1-yl, dimethylcyclopentadienyl-Ti-bis-2,6-difluorophen-1-yl, dimethylcyclopentadienyl-Ti-bis-2,4,6-trifluoropben-1-yl, dimethylcyclopentadienyl-Ti-bis-2,3,5,6-tetrafluorophen-1-yl, dimethylcyclopentadienyl-Ti-bis-2,3,4,5,6-pentafluorophen-1-yl, and the ironallene complexes disclosed in JP-A-1-304453 and JP-A-1-152109 are exemplified.

As the hexaarylbiimidazole compounds, various compounds disclosed in JP-B-6-29285, U.S. Patents 3,479,185, 4,311,783 and 4,622,286, specifically, e.g., 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichloro-phenyl)-4,4',5,5'-tetraphenylbiimidazole, 2,2'-bis-(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenyl-biimidazole, 2,2'-bis(o-methylphenyl)-4,4',5,5'-tetra-phenylbiimidazole, 2,2'-bis(o-trifluorophenyl)-4,4',5,5'-tetraphenylbiimidazole, etc., are exemplified.

As the organoboron compounds, the organoborates disclosed, e.g., in JP-A-62-143044, JP-A-62-150242, JP-A-9-188685, JP-A-9-188686, JP-A-9-188710, JP-A-2000-131837, JP-A-2002-107916, Japanese Patent No. 2764769, JP-A-2002-116539, and Kunz, Martin, "Rad Tech '98 Proceeding April 19-22, 1998, Chicago", the organoboron sulfonium complexes and the organoboron oxosulfonium complexes disclosed in JP-A-6-157623, JP-A-6-175564 and JP-A-6-175561, the organoboron iodonium complexes disclosed in JP-A-6-175554 and JP-A-6-175553, the organoboron phosphonium complexes disclosed in JP-A-9-188710, and organoboron transition metal coordination complexes disclosed in JP-A-6-348011, JP-A-7-128785, rP-A-7-140589, JP-A-7-306527 and JP-A-7-292014 are exemplified.

As the disulfone compounds, the compounds disclosed in JP-A-61-166544 and JP-A-2003-328465 are exemplified.

As the oxime ester compounds, the compounds described in J.C.S. Perkin II, 1653-1660 (1979), J.C.S. Perkin II, 156-162 (1979), Journal of Photopolymer Science and Technology, pp. 202-232 (1995), JP-A-2000-66385, the compounds disclosed in JP-A-2000-80068, and specifically the compounds represented by the following structural formulae are exemplified.

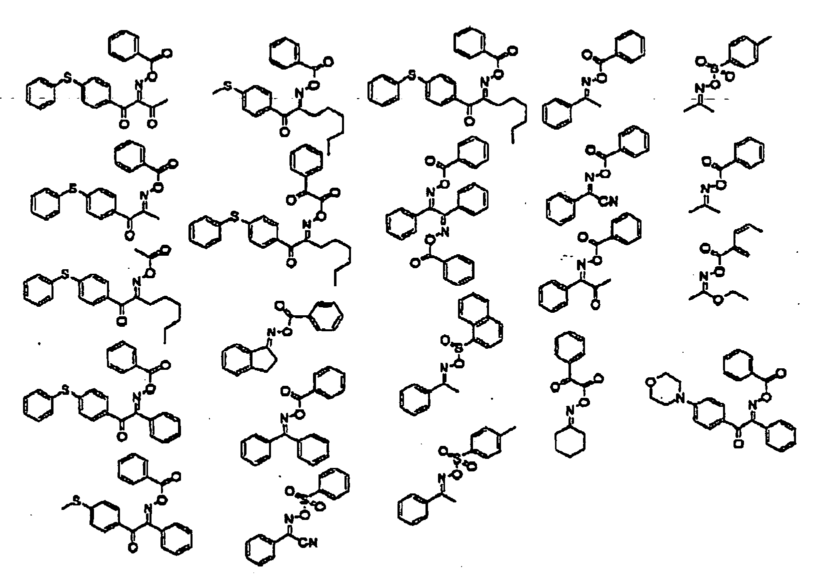

As the onium salt compounds, onium salts, e.g., the diazonium salts described in S.I. Schlesinger, Photogr. Sci. Eng., 18, 387 (1974), and T.S. Bal et al., Polymer 21, 423 (1980), the ammonium salts disclosed in U.S. Patent 4,069,055 and JP-A-4-365049, the phosphonium salts disclosed in U.S. Patents 4,069,055 and 4,069,056, the iodonium salts disclosed in EP 104,143, U.S. Patents 339,049, 410,201, JP-A-2-150848 and JP-A-2-296514, the sulfonium salts disclosed in EP 370,693, EP 390,214, EP 233,567, EP 297,443, EP 297,442, U.S. Patents 4,933,377, 161,811, 410,201, 339,049, 4,760,013, 4,734,444, 2,833,827, German Patents. 2,904,626, 3,604,580 and 3,604,581,
the selenonium salts described in J.V. Crivello et al., Macromolecules, 10 (6), 1307 (1977), and J.V. Crivello et al., J. Polymer Sci., Polymer Chem, Ed., 17, 1047 (1979), the arsonium salts described in C.S. Wen et al., Teh. Proc. Conf. Rad. Curing ASIA, p. 478, Tokyo, Oct (1988), etc., are exemplified.

Especially from the aspects of reactivity and stability, the above oxime ester compounds, or the diazonium salts, iodonium salts, sulfonium salts, and ammonium salts are exemplified.

In the invention, these onium salts function as ionic radical polymerization initiators not acid generators.

The onium salts preferably used in the invention are the onium salts represented by any of the following formulae (RI-I) to (RI-IV).

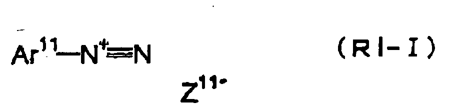

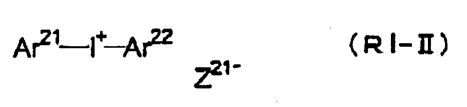

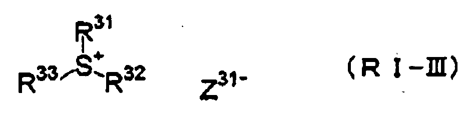

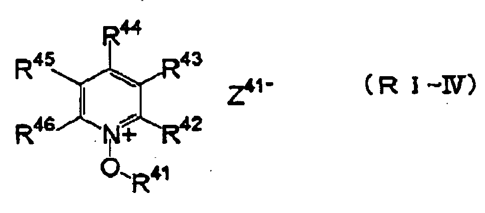

In formula (RI-I), Ar¹¹ represents an aryl group having 20 or less carbon atoms, which may have from 1 to 6 substituents, and as preferred substituents, an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxyl group having from 1 to 12 carbon atoms, an aryloxy group having from 1 to 12 carbon atoms, a halogen atom, an alkylamino group having from 1 to 12 carbon atoms, a dialkylamino group having from 1 to 12 carbon atoms, an alkylamido or arylamido group having from 1 to 12 carbon atoms, a carbonyl group, a carboxyl group, a cyano group, a sulfonyl group, a thioalkyl group having from 1 to 12 carbon atoms, and a thioaryl group having from 1 to 12 carbon atoms are exemplified. Z¹¹⁻ represents a monovalent anion, and specifically a halogen ion, a perchlorate ion, a hexafluorophosphate ion, a tetrafluoroborate ion, a sulfonate ion, a sulfinate ion, a thiosulfonate ion, and a sulfate ion are exemplified. In view of stability and visibility of a printed out image, a perchlorate ion, a hexafluorophosphate ion, a tetrafluoroborate ion, a sulfonate ion and a sulfinate ion are preferred.

In formula (RI-II), Ar²¹ and Ar²² each represents an aryl group having 20 or less carbon atoms, which may have from 1 to 6 substituents, and as preferred substituents, an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxyl group having from 1 to 12 carbon atoms, an aryloxy group having from 1 to 12 carbon atoms, a halogen atom, an alkylamino group having from 1 to 12 carbon atoms, a dialkyl-amino group having from 1 to 12 carbon atoms, an alkylamido or arylamido group having from 1 to 12 carbon atoms, a carbonyl group, a carboxyl group, a cyano group, a sulfonyl group, a thioalkyl group having from 1 to 12 carbon atoms, and a thioaryl group having from 1 to 12 carbon atoms are exemplified. Z²¹⁻ represents a monovalent anion, and specifically a halogen ion, a perchlorate ion, a hexafluorophosphate ion, a tetrafluoroborate ion, a sulfonate ion, a sulfinate ion, a thiosulfonate ion, and a sulfate ion are exemplified. In view of stability, a perchlorate ion, a hexafluorophosphate ion, a tetrafluoro-borate ion, a sulfonate ion, a sulfinate ion, and a carboxylate ion are preferred.

In formula (RI-III), R³¹, R³² and R³³ each represents an aryl, alkyl, alkenyl or alkynyl group having 20 or less carbon atoms, each of which may have from 1 to 6 substituents. In view of reactivity and stability, an aryl group is preferred. As preferred substituents, an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxyl group having from 1 to 12 carbon atoms, an aryloxy group having from 1 to 12 carbon atoms, a halogen atom, an alkylamino group having from 1 to 12 carbon atoms, a dialkylamino group having from 1 to 12 carbon atoms, an alkylamido or arylamido group having from 1 to 12 carbon atoms, a carbonyl group, a carboxyl group, a cyano group, a sulfonyl group, a thioalkyl group having from 1 to 12 carbon atoms, and a thioaryl group having from 1 to 12 carbon atoms are exemplified. Z³¹⁻ represents a monovalent anion, and specifically a halogen ion, a perchlorate ion, a hexafluoro-phosphate ion, a tetrafluoroborate ion, a sulfonate ion, a sulfinate ion, a thiosulfonate ion, and a sulfate ion are exemplified. In view of stability and visibility of a printed out image, a perchlorate ion, a hexafluorophosphate ion, a tetrafluoroborate ion, a sulfonate ion, a sulfinate ion, and a carboxylate ion are preferred. The carboxylate ion disclosed in JP-A-2001-343742 is more preferred, and the carboxylate ion disclosed in JP-A-2002-148790 is especially preferred.

In formula (RI-IV), R⁴¹ represents an alkyl group having from 1 to 20 carbon atoms, which may have a substituent; R⁴², R⁴³, R⁴⁴, R⁴⁵ and R⁴⁶ each represents an aryl, alkyl, alkenyl or alkynyl group having 20 or less carbon atoms, each of which may have from 1 to 6 substituents, In view of reactivity and stability, an aryl group is preferred. As preferred substituents, an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxyl group having from 1 to 12 carbon atoms, an aryloxy group having from 1 to 12 carbon atoms, a halogen atom, an alkylamino group having from 1 to 12 carbon atoms, a dialkylamino group having from 1 to 12 carbon atoms, an alkylamido or arylamido group having from 1 to 12 carbon atoms, a carbonyl group, a carboxyl group, a cyano group, a sulfonyl group, a thioalkyl group having from 1 to 12 carbon atoms, and a thioaryl group having from 1 to 12 carbon atoms are exemplified. R⁴¹ and R⁴³, R⁴² and R⁴³, R⁴³ and R⁴⁴, R⁴⁴ and R⁴⁵, and R⁴⁵ and R⁴⁶ may be bonded to each other to form a ring. Z⁴¹⁻ represents a monovalent anion, and specifically a halogen ion, a perchlorate ion, a hexafluorophosphate ion, a tetrafluoroborate ion, a sulfonate ion, a sulfinate ion, a thiosulfonate ion, and a sulfate ion are exemplified. In view of stability and visibility of a printed out image, a perchlorate ion, a hexafluorophosphate ion, a tetrafluoro-borate ion, a sulfonate ion, a sulfinate ion, and a carboxylate ion are preferred.

The examples of onium salts preferably used in the invention as polymerization initiators are shown below, but the invention is not restricted thereto.

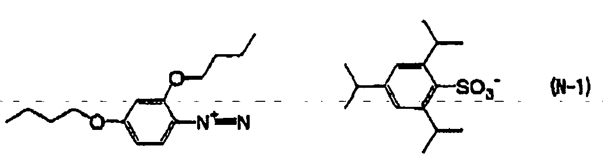

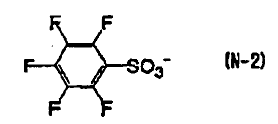

PF₆⁻ (N-3)

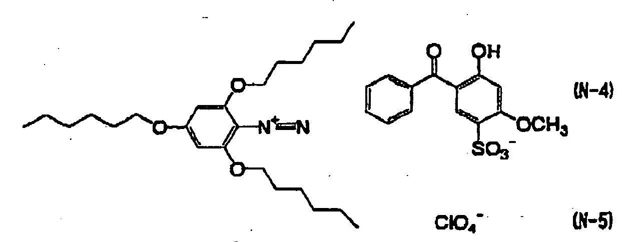

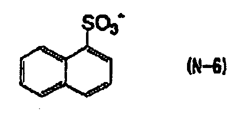

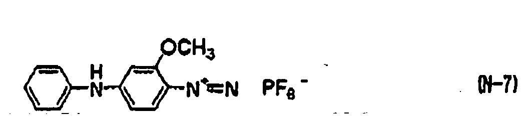

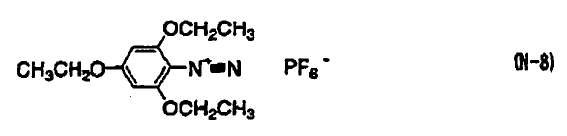

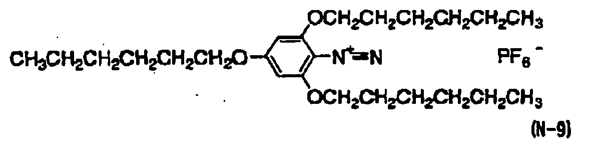

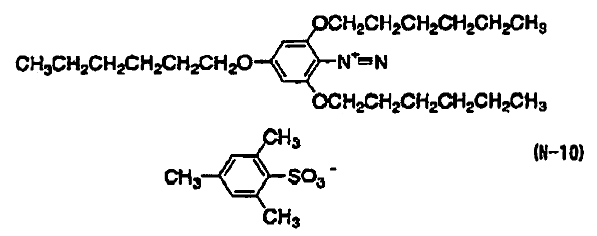

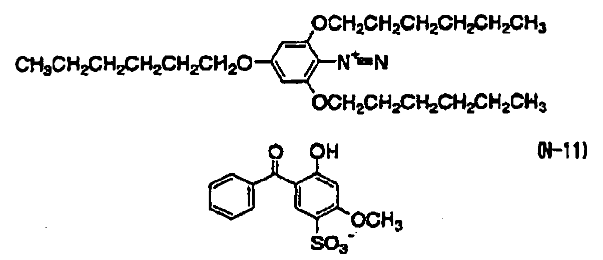

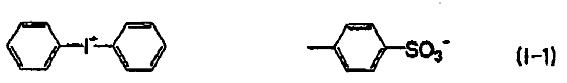

PF₈⁻ (I-2)

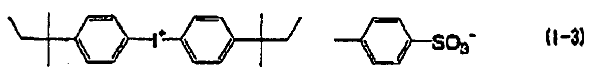

ClO₄⁻ (1-4)

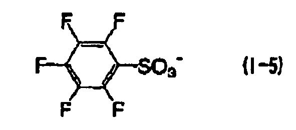

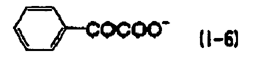

CF₃SO₃⁻ (I-7)

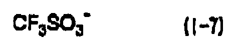

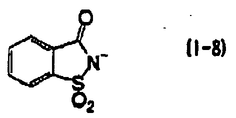

PF₆⁻ (1-10)

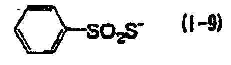

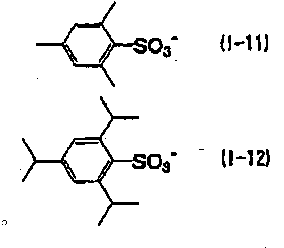

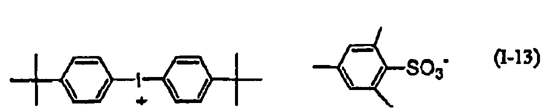

ClO₄⁻ (I-14)

PF₆⁻ (I-15)

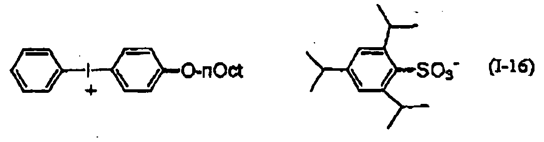

CF₃COO⁻ (I-17)

CF₃SO₃⁻ (I-18)

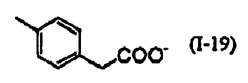

BF₄⁻ (I-20)

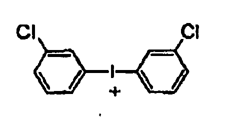

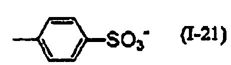

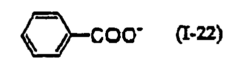

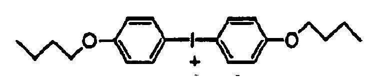

C₄F₉COO⁻ (I-23)

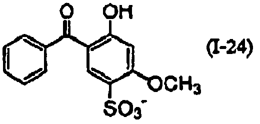

PF₆⁻ (I-25)

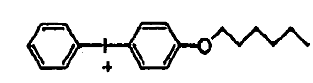

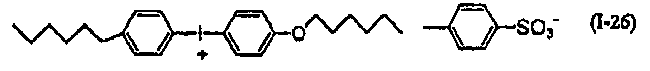

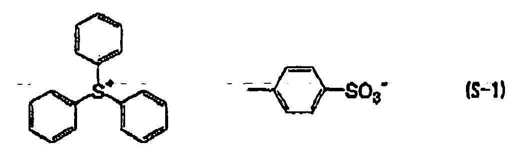

PF₆⁻ (S-2)

ClO₄⁻ (S-3)

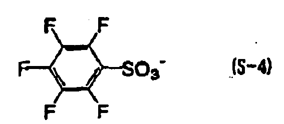

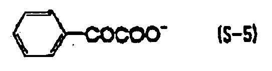

CF₃SO₃⁻ (S-6)

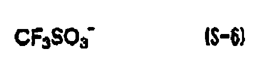

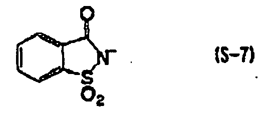

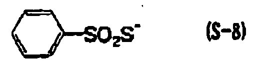

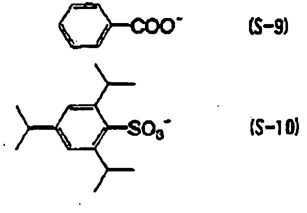

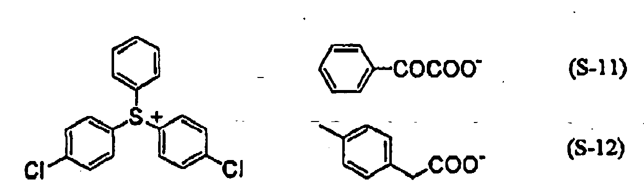

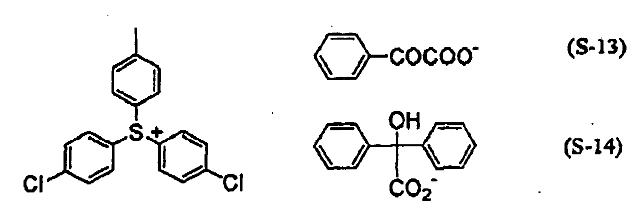

BF₄⁻ (S-15)

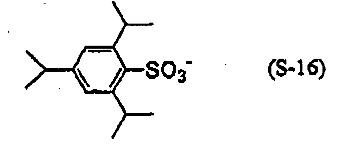

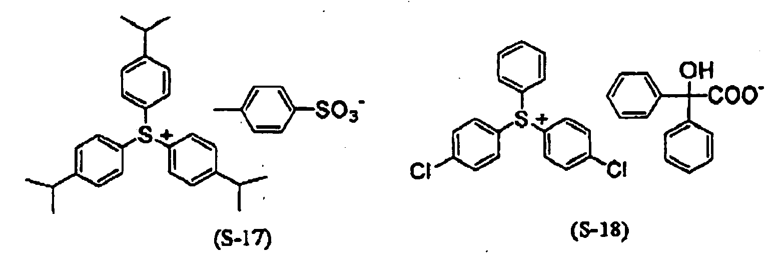

| | | | | | |
|---|---|---|---|---|---|
| 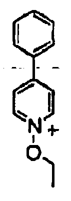 | | | 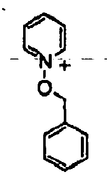 | PF₆⁻ | (A-10) |
| | 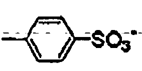 | (A-1) | | 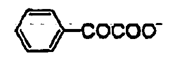 | (A-11) |
| | PF₆⁻ | (A-2) | | 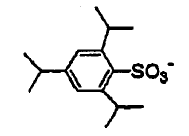 | (A-12) |
| | ClO₄⁻ | (A-3) | | | |
| | 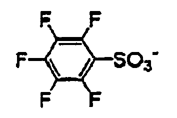 | (A-4) | 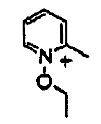 | PF₆⁻ | (A-13) |
| | 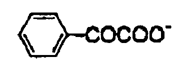 | (A-5) | 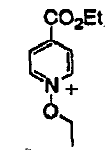 | | |
| | CF₃SO₃⁻ | (A-6) | | PF₆⁻ | (A-14) |
| | 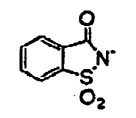 | (A-7) | 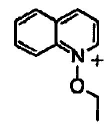 | PF₆⁻ | (A-15) |
| | 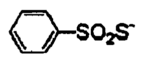 | (A-8) | | | |
| | 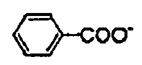 | (A-9) | 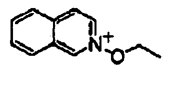 | PF₆⁻ | (A-16) |

Of these polymerization initiators, onium salts are preferred from the viewpoint of visibility of a printed out image, and those having an inorganic anion, e.g., PF₆⁻, BF₄⁻, etc., as the counter ion, are preferred. Further, of oniums, diaryl iodonium and ammonium are preferred for being excellent in press life.

These polymerization initiators can be added in a proportion of from 0.1 to 50 mass% based on all the solids content constituting the photo-polymerization layer, preferably from 0.5 to 30 mass%, and especially preferably from 1 to 20 mass%. In this range of the addition amount, good sensitivity and good soiling resistance of a non-image part at printing can be obtained. Polymerization initiators may be used by one kind alone or two or more kinds may be used in combination. These polymerization initiators may be added with other components in the same layer, or other layer may be provided for the addition of polymerization initiators.

### [Polymerizable monomer]

It is preferred that the photo-polymerization layer in the invention contains a polymerizable monomer for performing effective curing reaction. The polymerizable monomers that can be used in the invention are addition polymerizable compounds having at least one ethylenic unsaturated double bond, and they are selected from the compounds having at least one, preferably two or more, terminal ethylenic unsaturated bond. These groups of compounds are well known in the field of this industry, and they can be used with no particular limitation in the invention. These polymerizable compounds have chemical forms of, e.g., a monomer, a prepolymer, i.e., a dimer, a trimer, an oligomer, or a mixture and a copolymer of them. As the examples of monomers and the copolymers thereof, unsaturated carboxylic acids (e.g., acrylic acid, methacrylic acid, itaconic acid, crotonic acid, isocrotonic acid, maleic acid, etc.), and esters and amides of these unsaturated carboxylic acids are exemplified, and preferably esters of unsaturated carboxylic acids and aliphatic polyhydric alcohol compounds, and amides of unsaturated carboxylic acids and aliphatic polyhydric amine compounds are used. Further, the addition reaction products of esters and amides of unsaturated carboxylic acids having a nucleophilic substituent such as a hydroxyl group, an amino group or a mercapto group with monofunctional or polyfunctional isocyanates or epoxies, and the dehydration condensation reaction products with monofunctional or polyfunctional carboxylic acids are also preferably used. Furthermore, the addition reaction products of unsaturated carboxylic esters or amides having an electrophilic substituent such as an isocyanate group or an epoxy group with monofunctional or polyfunctional alcohols, amines or thiols, and the substitution reaction products of unsaturated carboxylic esters or amides having an eliminable substituent such as a halogen group or a tosyloxy group with monofunctional or polyfunctional alcohols, amines or thiols are also preferably used. As other examples, it is also possible to use groups of compounds in which the unsaturated carboxylic acids are replaced with unsaturated phosphonic acid, styrene, vinyl ether, etc.

The specific examples of the monomers of esters of aliphatic polyhydric alcohol compounds and unsaturated carboxylic acids include, as acrylic acid esters, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentacrythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, polyester acrylate oligomer, isocyanuric acid EO-modified triacrylate, etc. As methacrylic acid esters, the examples include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)-phenyl]dimethylmethane, bis[p-(methacryloxyethoxy)phenyl]-dimethylmethane, etc.

As itaconic acid esters, the examples include ethylene glycol diitaconate, propylene glycol diitaconate, 1,3-butanediol diitaconate, 1,4-butanediol diitaconate, tetramethylene glycol diitaconate, pentaerythritol diitaconate, sorbitol tetraitaconate, etc. As crotonic acid esters, the examples include ethylene glycol dicrotonate, tetramethylene glycol dicrotonate, pentaerythritol dicrotonate, sorbitol tetradicrotonate, etc. As isocrotonic acid esters, the examples include ethylene glycol diisocrotonate, pentaerythritol diisocrotonate, sorbitol tetraisocrotonate, etc. As maleic acid esters, the examples include ethylene glycol dimaleate, triethylene glycol dimaleate, pentaerythritol dimaleate, sorbitol tetramaleate, etc.

As the examples of other esters, e.g., the aliphatic alcohol esters disclosed in JP-B-51-47334 and JP-A-57-196231, the esters having an aromatic skeleton disclosed in JP-A-59-5240, JP-A-59-5241 and JP-A-2-226149, and the esters containing an amino group disclosed in JP-A-1-165613 are also preferably used in the invention. The above ester monomers can also be used as mixtures.

Further, the specific examples of the amide monomers of aliphatic polyhydric amine compounds and unsaturated carboxylic acids include methylenebis-acrylamide, methylenebis-methacrylamide, 1,6-hexamethylenebis-acrylamide, 1,6-hexamethylenebis-methacrylamide, diethylenetriaminetris-acrylamide, xylylenebis-acrylamide, xylylenebis-methacrylamide, etc. As the examples of other preferred amide monomers, the monomers having a cyclohexylene structure disclosed in JP-B-54-21726 can be exemplified.

Further, urethane-based addition polymerizable compounds manufactured by the addition reaction of isocyanate and hydroxyl groups are also preferably used. As the specific examples of such compounds, as is disclosed in JP-B-48-41708, a vinyl urethane compound containing two or more polymerizable vinyl groups in one molecule obtained by adding vinyl monomer containing a hydroxyl group represented by the following formula (ii) to a polyisocyanate compound having two or more isocyanate groups in one molecule is exemplified.

CH₂=C(R⁴)COOCH₂CH(R⁵)OH (ii)

wherein R⁴ and R⁵ each represents H or CH₃.

The urethane acrylates disclosed in JP-A-51-37193, JP-B-2-32293, and JP-B-2-16765, and the urethane compounds having an ethylene oxide skeleton disclosed in JP-B-58-49860, JP-B-56-17654, JP-B-62-39417 and JP-B-62-39418 are also preferably used in the invention. In addition, extremely high speed photopolymerizable compositions can be obtained by using addition polymerizable compounds having an amino structure and a sulfide structure in the molecule as disclosed in JP-A-63-277653, JP-A-63-260909 and JP-A-1-105238. As other examples, the polyfunctional acrylates and methacrylates, such as polyester acrylates, and epoxy acrylates obtained by reacting epoxy resins with acrylic acids or methacrylic acids as disclosed in JP-A-48-64183, JP-B-49-43191 and JP-B-52-30490 can be exemplified. The specific unsaturated compounds disclosed in JP-B-46-43946, JP-B-1-40337 and JP-B-1-40336, and the vinylsulfonic acid compounds disclosed in JP-A-2-25493 can also be exemplified. Further, according to cases, the structures containing a perfluoroalkyl group disclosed in JP-A-61-22048 are preferably used. Moreover, the compounds introduced, as photo-curable monomers and oligomers, into Bulletin of Nippon Setchaku Kyokai, Vol. 20, No. 7, pp. 300-308 (1984) can also be used.

The details in usage of these polymerizable compound, e.g., what a structure is to be used, whether the compound is to be used alone or in combination, or what an amount is to be used, can be optionally set up according to the final design of the performances of the lithographic printing plate precursor. For example, the conditions are selected from the aspects as follows.

In the point of sensitivity, the structure containing many unsaturated groups per a molecule is preferred and bifunctional or higher functional groups are preferred in many cases. For increasing the strength of an image part, i.e., a cured film, trifunctional or higher functional groups are preferred, and it is also effective to use different functional numbers and different polymerizable groups (e.g., acrylate, methacrylate, styrene compounds, vinyl ether compounds) in combination to control both speed and strength. Further, the selection and usage of the addition polymerizable compounds are important factors for the compatibility with other components in a photo-polymerization layer (e.g., a binder polymer, a polymerization initiator, a colorant, etc.) and dispersibility, for example, sometimes it is possible to improve compatibility by using a low purity compound or two or more compounds in combination. Further, it is also possible to select a specific structure for the purpose of improving the adhesion property with a substrate and a protective layer described later.

The polymerizable monomers are used preferably in the range of from 5 to 80 mass% based on the volatile content in the photo-polymerization layer, and more preferably from 25 to 75 mass%. These monomers may be used alone, or two or more monomers may be used in combination. In addition to the above, in connection with the usage of the polymerizable monomers, the structure, composition and addition amount can be properly selected in view of the degree of polymerization hindrance by oxygen, resolution, a fogging property, change in refractive indices, surface tackiness, etc. Further, in some cases, a layer constitution and a coating method such as undercoat and overcoat may be taken.

The polymerizable monomer to a binder polymer are preferably used in a mass ratio of from 0.5/1 to 4/1, more preferably from 1/1 to 3/1, and most preferably from 1.5/1 to 2.5/1.

### [Microcapsule and microgel]

In the invention, as the methods for adding the above constituents and other constituents described later of the photo-polymerization layer to the photo-polymerization layer, some embodiments can be used. One embodiment is a molecular dispersion type photo-polymerization layer of dissolving the constituents in an appropriate solvent and coating as disclosed in JP-A-2002-287334, and another one is a microcapsule type photo-polymerization layer of encapsulating all or a part of the constituents in microcapsules and adding to a photo-polymerization layer as disclosed in JP-A-2001-277740 and JP-A-2001-277742. In addition, in the microcapsule type photo-polymerization layer, the constitutional components may also be contained outside the microcapsules. Here, it is a preferred embodiment for the microcapsule type photo-polymerization layer to contain hydrophobic constituents in microcapsules and hydrophilic constituents out of microcapsules. Further, as another embodiment, an embodiment of containing crosslinking resin particles, i.e., microgels, in the photo-polymerization layer is exemplified. The microgels can contain a part of the constituents within the microgels and/or on the surfaces thereof. An embodiment of having a polymerizable monomer on the surfaces of microgels to thereby make them reactive microgels is especially preferred from the points of image forming sensitivity and press life.

It is preferred to contain microcapsules or microgels for the purpose of the photo-polymerization layer to be a photo-polymerization layer capable of being removed with at least one of printing ink and a fountain solution, i.e., a photo-polymerization layer capable of on-press development.

The constituents of the photo-polymerization layer can be microencapsulated or micro-gelatinized by known methods.

As the manufacturing methods of microcapsules, the method using coacervation disclosed in U.S. Patents 2,800,457 and 2,800,458, the method by interfacial polymerization disclosed in U.S. Patent 3,287,154, JP-B-38-19574 and JP-B-42-446, the method by the precipitation of a polymer disclosed in U.S. Patents 3,418,250 and 3,660,304, the method of using isocyanate polyol wall materials disclosed in U.S. Patent 3,796,669, the method of using isocyanate wall materials disclosed in U.S. Patent 3,914,511, the method of using urea-formaldehyde or urea-formaldehyde-resorcinol wall materials disclosed in U.S. Patents 4,001,140, 4,087,376 and 4,089,802, the method of using melamine-formaldehyde resin or hydroxy cellulose wall materials as disclosed in U.S. Patent 4,025,445, the in situ method by monomer polymerization disclosed in JP-B-36-9163 and JP-B-51-9079, the spray drying method disclosed in British Patent 930,422 and U.S. Patent 3,111,407, and the electrolytic dispersion cooling method disclosed in British Patents 952,807 and 967,074 can be exemplified, but the invention is by no means restricted to these methods.

The microcapsule walls preferably used in the invention have three dimensional crosslinking and a property of swelling by a solvent. From this point of view, polyurea, polyurethane, polyester, polycarbonate, polyamide, and the mixtures of these compounds are preferably used as microcapsule wall materials, and polyurea and polyurethane are especially preferred. Compounds having crosslinkable functional groups such as ethylenic unsaturated bonds that can introduce a binder polymer may be introduced into a microcapsule wall.

On the other hand, as methods of preparing microgels, it is possible to use granulation by interfacial polymerization disclosed in JP-B-38-19574 and JP-B-42-446, and granulation by nonaqueous dispersion polymerization disclosed in JP-A-5-61214, but the invention is not restricted to these methods.

The above-described known microcapsule manufacturing methods can be applied to the method utilizing interfacial polymerization.

The microgels preferably used in the invention have three dimensional crosslinking granulated by interfacial polymerization. From this point of view, materials such as polyurea, polyurethane, polyester, polycarbonate, polyamide, and mixtures of these materials are preferably used, and polyurea and polyurethane are especially preferably used.

The average particle size of the microcapsules and microgels is preferably from 0.01 to 3.0 µm, more preferably from 0.05 to 2.0 µm, and especially preferably from 0.10 to 1.0 µm. With this range of the average particle size, good resolution and aging stability can be obtained.

### [Surfactant]

In the invention, it is preferred to use a surfactant in the photo-polymerization layer to accelerate the on-press development property at the time of starting printing and to improve the conditions of coating surface. As the surfactants, nonionic surfactants, anionic surfactants, cationic surfactants, amphoteric surfactants and fluorine surfactants are used. Surfactants may be used alone, or two or more surfactants may be used in combination.

The nonionic surfactants for use in the invention are not particularly restricted and conventionally well known surfactants can be used, e.g., polyoxyethylene alkyl ethers, polyoxyethylene alkyl phenyl ethers, polyoxyethylene polystyryl phenyl ethers, polyoxyethylene polyoxypropylene alkyl ethers, glycerol fatty acid partial esters, sorbitan fatty acid partial esters, pentaerythritol fatty acid partial esters, propylene glycol fatty acid monoesters, sucrose fatty acid partial esters, polyoxyethylene sorbitan fatty acid partial esters, polyoxyethylene sorbitol fatty acid partial esters, polyethylene glycol fatty acid esters, polyglycerol fatty acid partial esters, polyoxyethylenated castor oils, polyoxyethylene glycerol fatty acid partial esters, fatty acid diethanolamides, N,N-bis-2-hydroxyalkylamines, polyoxyethylene alkylamine, triethanolamine fatty acid ester, trialkylamine oxide, polyethylene glycol, and copolymers of polyethylene glycol and polypropylene glycol are exemplified.

The anionic surfactants for use in the invention are not particularly restricted and conventionally well known surfactants can be used, e.g., fatty acid salts, abietates, hydroxyallcanesulfonates, alkanesulfonates, dialkylswfo-sucrinates, straight chain alkylbenzenesulfonates, branched chain alkylbenzenesulfonates, alkylnaphthalenesulfonates, alkylphenoxypolyoxyethylenepropylsulfonates, polyoxyethylene alkyl sulfophenyl ethers, sodium N-methyl-N-oleyl-taurine, disodium N-alkylsulfosuccinic acid monoamide, petroleum sulfonates, sulfated beef tallow, sulfates of fatty acid alkyl esters, alkylsulfates, polyoxyethylene alkyl ether sulfates, fatty acid monoglyceride sulfates, polyoxyethylene alkyl phenyl ether sulfates, polyoxyethylene styryl phenyl ether sulfates, alkylphosphates, polyoxyethylene alkyl ether phosphates, polyoxyethylene alkyl phenyl ether phosphates, partial saponification products of styrene/maleic acid anhydride copolymers, partial saponification products of olefin/maleic acid anhydride copolymers, and naphthalene sulfonate formaldehyde condensation products are exemplified.

The cationic surfactants for use in the invention are not particularly restricted and conventionally well known surfactants can be used, e.g., alkylamine salts, quaternary ammonium salts, polyoxyethyene alkylamine salts, and polyethylene polyamine derivatives are exemplified.

The amphoteric surfactants for use in the invention are not particularly restricted and conventionally well known surfactants can be used, e.g., carboxybetaines, amino-carboxylic acids, sulfobetaines, aminosulfates and imidazolines are exemplified.

In the above surfactants, "polyoxyethylene" can be taken as "polyoxyalkylene" such as polyoxymethylene, polyoxy-propylene, or polyoxybutylene, and these surfactants can also be used in the invention.

As more preferred surfactants, fluorine surfactants containing a perfluoroalkyl group in the molecule are exemplified. As such fluorine surfactants, anionic surfactants, e.g., perfluoroalkylcarboxylate, perfluoro-alkylsulfonate, and perfluoroalkylphosphate; amphoteric surfactants, e.g., perfluoroalkylbetaine; cationic surfactants, e.g., perfluoroalkyltrimethylammonium salt; and nonionic surfactants, e.g., perfluoroalkylamine oxide, perfluoroalkyl ethylene oxide adducts, oligomers containing a perfluoroalkyl group and a hydrophilic group, oligomers containing a perfluoroalkyl group and a lipophilic group, oligomers containing a perfluoroalkyl group, a hydrophilic group, and a lipophilic group, and urethane containing a perfluoroalkyl group and a lipophilic group are exemplified. Further, the fluorine surfactants disclosed in JP-A-62-170950, JP-A-62-226143 and JP-A-60-168144 are also preferably used.

Surfactants can be used alone, or two or more surfactants can be used in combination.

The content of surfactants is preferably from 0.001 to 10 mass% based on all the solids content of the photo-polymerization layer, and more preferably from 0.01 to 7 mass%.

### [Colorant]

Further, if necessary, various compounds besides the above compounds can be used in the invention. For example, dyes having large absorption in the visible ray region can be used as the colorants of images. Specifically, Oil Yellow #101, Oil Yellow #103, Oil Pink #312, Oil Green BG, Oil Blue BOS, Oil Blue #603, Oil Black BY, Oil Black BS, Oil Black T-505 (products of Orient Chemical Industries, Ltd.), Victoria Pure Blue, Crystal Violet (C.I. 42555), Methyl Violet (C.I. 42535), Ethyl Violet, Rhodamine B (C.I. 145170B), Malachite Green (C.I. 42000), Methylene Blue (C.I. 52015), etc., and the dyes disclosed in JP-A-62-293247 can be exemplified. In addition, pigments such as phthalocyanine pigments, azo pigments, carbon black, titanium oxide, etc., can also be preferably used.

These colorants are rather preferably added, since discrimination of an image part from a non-image part after image formation becomes easy. The addition amount of colorants is preferably in a proportion of from 0.01 to 10 mass% based on all the solids content of the image-recording material.

### [Printing-out agent]

Compounds that discolor by acids or radicals can be added to the photo-polymerization layer in the invention for forming a printing out image. As such compounds, various dyestuffs, e.g., diphenylmethane, triphenylmethane, thiazine, oxazine, xanthene, anthraquinone, iminoquinone, azo, and azomethine dyestuffs are effectively used.

The specific examples of the dyestuffs include dyes such as Brilliant Green, Ethyl Violet, Methyl Green, Crystal Violet, Basic Fuchsine, Methyl Violet 2B, Quinaldine Red, Rose Bengal, Metanil Yellow, Thymolsulfophthalein, Xylenol Blue, Methyl Orange, Paramethyl Red, Congo Red, Benzopurpurin 4B, α-Naphthyl Red, Nile Blue 2B, Nile Blue A, Methyl Violet, Malachite Green, Parafuchsine, Victoria Pure Blue BOH (products of HODOGAYA CHEMICAL CO., LTD.), Oil Blue #603 (a product of Orient Chemical Industries, Ltd.), Oil Pink #312 (a product of Orient Chemical Industries, Ltd.), Oil Red 5B (a product of Orient Chemical Industries, Ltd.), Oil Scarlet #308 (a product of Orient Chemical Industry Co., Ltd.), Oil Red OG (a product of Orient Chemical Industries, Ltd.), Oil Red RR (a product of Orient Chemical Industries, Ltd.), Oil Green #502 (a product of Orient Chemical Industries, Ltd.), Spiron Red BEH Special (a product of HODOGAYA CHEMICAL CO., LTD.), m-Cresol Purple, Cresol Red, Rhodamine B, Rhodamine 6G, Sulforhodamine B, Auramine, 4-p-diethylaminophenylimino-naphthoquinone, 2-carboxyanilino-4-p-diethylaminophenyl-iminonaphthoquinone, 2-carboxystearylamino-4-p-N,N-bis-(hydroxyethyl)aminophenyliminonaphthoquinone, 1-phenyl-3-methyl-4-p-diethylaminophenylimino-5-pyrazolone, 1-β-naphthyl-4-p-diethylaminophenylimino-5-pyrazolone, etc., and leuco dyes such as p,p',p"-hexamethyltriaminotriphenylmethane (Leuco Crystal Violet), Pergascript Blue SRB (a product of Ciba Geigy A.G.), etc.

In addition to the above, leuco dyes known as the materials of heat-sensitive paper and pressure-sensitive paper are also preferably exemplified. The specific examples of the leuco dyes include Crystal Violet Lactone, Malachite Green Lactone, Benzoyl Leuco Methylene Blue, 2-(N-phenyl-N-methylamino)-6-(N-p-tolyl-N-ethyl)aminofluoran, 2-anilino-3-methyl-6-(N-ethyl-p-toluidino)fluoran, 3,6-dimethoxy-fluoran, 3-(N,N-diethylamino)-5-methyl-7-(N,N-dibenzyl-amino)fluoran, 3-(N-cyclohexyl-N-methylamino)-6-methyl-7-anilinofluoran, 3-(N,N-diethylamino)-6-methyl-7-anilino-fluoran, 3-(N,N-diethylamino)-6-methyl-7-xylidinofluoran, 3-(N,N-diethylamino)-6-methyl-7-chlorofluoran, 3-(N,N-diethylamino)-6-methoxy-7-aminofluoran, 3-(N,N-diethyl-amino)-7-(4-chloroanilino)fluoran, 3-(N,N-diethylamino)-7-chlorofluoran, 3-(N,N-diethylamino)-7-benzylaminofluoran, 3-(N,N-diethylamino)-7,8-benzofluoran, 3-(N,N-dibutyl-amino)-6-methyl-7-anilinofluoran, 3-(N,N-dibutylamino)-6-methyl-7-xylidinofluoran, 3-piperidino-6-methyl-7-anilinofluoran, 3-pyrrolidino-6-methyl-7-anilinofluoran, 3,3-bis-(1-ethyl-2-methylindol-3-yl)phthalide, 3,3-bis(1-n-butyl-2-methylindol-3-yl)phthalide, 3,3-bis(p-dimethylaminophenyl)-6-dimethylaminophthalide, 3-(4-diethylamino-2-ethoxyphenyl)-3-(1-ethyl-2-methylindol-3-yl)-4-phthalide, 3-(4-diethylaminophenyl)-3-(1-ethyl-2-methylindol-3-yl)-phthalide, etc.

The dyes that discolor by acids or radicals are preferably added in a proportion of from 0.01 to 10 mass% based on the solids content of the photo-polymerization layer.

### [Polymerization inhibitor]

For the purpose of prevention of unnecessary thermal polymerization of a radical polymerizable monomer during the manufacture or preservation of the photo-polymerization layer, it is preferred that a small amount of a thermal polymerization inhibitor be added to the photo-polymerization layer in the invention.

As the examples of the thermal polymerization inhibitors, e.g., hydroquinone, p-methoxyphenol, di-t-butyl-p-cresol, pyrogallol, t-butylcatechol, benzoquinone, 4,4'-thiobis(3-methyl-6-t-butylphenol), 2,2'-methylenebis(4-methyl-6-t-butylphenol), and N-nitroso-N-phenylhydroxylamine aluminum salt are preferably exemplified.

The addition amount of the thermal polymerization inhibitors is preferably from about 0.01 to about 5 mass% based on all the solids content of the photo-polymerization layer.

### [Higher fatty acid derivative, etc.]

For the purpose of prevention of the polymerization hindrance due to oxygen, higher fatty acid derivatives, such as behenic acid and behenic acid amide may be added to the photo-polymerization layer in the invention to locally exist them on the surface of the photo-polymerization layer in the drying process after coating. The addition amount of the higher fatty acid derivatives is preferably from about 0.1 to about 10 mass% based on all the solids content of the photo-polymerization layer.

### [Plasticizer]

The photo-polymerization layer in the invention may contain a plasticizer for the purpose of improvement of an on-press developing property.

The examples of plasticizers include phthalic acid esters, e.g., dimethyl phthalate, diethyl phthalate, dibutyl phthalate, diisobutyl phthalate, dioctyl phthalate, octylcapryl phthalate, dicyclohexyl phthalate, ditridecyl phthalate, butylbenzyl phthalate, diisodecyl phthalate, diallyl phthalate, etc.; glycol esters, e.g., dimethyl glycol phthalate, ethyl phthalyl ethyl glycolate, methyl phthalyl ethyl glycolate, butyl phthalyl butyl glycolate, triethylene glycol dicaprylate, etc.; phosphoric acid esters, e.g., tricresyl phosphate, triphenyl phosphate, etc.; aliphatic dibasic acid esters, e.g., diisobutyl adipate, dioctyl adipate, dimethyl sebacate, dibutyl sebacate, dioctyl azelate, dibutyl maleate, etc.; and polyglycidyl methacrylate, triethyl citrate, glycerol triacetyl ester, butyl laurate, etc.

The content of plasticizers is preferably about 30 mass% or less based on all the solids content of the photo-polymerization layer.

### [Inorganic fine particles]

The photo-polymerization layer in the invention may contain inorganic fine particles for the purposes of increasing the strength of the cured film of an image part and improving the on-press developing properties of a non-image part.

As the inorganic fine particles, e.g., silica, alumina, magnesium oxide, titanium oxide, magnesium carbonate, calcium alginate and mixtures of these fine particles are preferably exemplified. These inorganic fine particles can be used for strengthening a film and enhancing an interface adhesion property by surface roughening treatment even when they are not light-heat convertible.

The average particle size of inorganic fine particles is preferably from 5 nm to 10 µm, and more preferably from 0.5 to 3 µm. When the average particle size is in the above range, inorganic fine particles are stably dispersed in the photo-polymerization layer and the film strength of the photo-polymerization layer can be sufficiently retained, thus a non-image part difficult to be soiled in printing and excellent in hydrophilicity can be formed.

These inorganic fine particles are easily available as commercial products such as colloidal silica dispersion and the like.

The content of inorganic fine particles is preferably 20 mass% or less based on all the solids content of the photo-polymerization layer, and more preferably 10 mass% or less.

### [Low molecular weight hydrophilic compound]

For the improvement of an on-press developing property, the photo-polymerization layer in the invention may contain hydrophilic low molecular weight compounds. As the hydrophilic low molecular weight compounds, water-soluble organic compounds, such as glycols, e.g., ethylene glycol, diethylene glycol, triethylene glycol, propylene glycol, dipropylene glycol, tripropylene glycol, etc., and ethers or ester derivatives thereof, polyhydroxies, e.g., glycerol, pentaerythritol, etc., organic amines, e.g., triethanolamine, diethanolamine, monoethanolamine, etc., and salts thereof, organic sulfonic acids, e.g., toluenesulfonic acid, benzenesulfonic acid, etc., and salts thereof, organic phosphonic acids, e.g., phenylphosphonic acid, etc., and salts thereof, and organic carboxylic acids, e.g., tartaric acid, oxalic acid, citric acid, malic acid, lactic acid, gluconic acid, amino acid, etc., and salts thereof are exemplified.

### [Formation of photo-polymerization layer]

The photo-polymerization layer in the invention is formed by coating a coating solution, which is prepared by dispersing or dissolving the above necessary constitutional components in a solvent, on a support and drying. As solvents used here, ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethyl-formamide, tetramethylurea, N-methylpyrrolidone, dimethyl sulfoxide, sulforan, γ-butyrolactone, toluene, and water are exemplified, but solvents are not limited thereto. These solvents are used alone or as mixture. The concentration of the solid contents of a coating solution is preferably from 1 to 50 mass%.

It is also possible to form the photo-polymerization layer in the invention by preparing a plurality of coating solutions by dispersing or dissolving the same or different components in the same or different solvents, and repeating the coating and drying a plurality of times.

Although the coating amount of the photo-polymerization layer (solids content) on a support obtained after coating and drying varies according to uses, it is generally preferably from 0.3 to 3.0 g/m². When the coating amount is in this range, good sensitivity and good film properties of the photo-polymerization layer can be obtained.

Various coating methods can be used. For example, bar coater coating, rotary coating, spray coating, curtain coating, dip coating, air knife coating, blade coating, and roll coating can be exemplified.

### [Support]

Supports for use in a lithographic printing plate precursor in the invention are not especially restricted and any support can be used so long as the support is dimensionally stable and a plate-like support. For example, paper, paper laminated with plastics (e.g., polyethylene, polypropylene, polystyrene, etc.), metal plates (e.g., aluminum, zinc, copper, etc.), plastic films (e.g., cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal, etc.), and paper and plastic films laminated or deposited with the above metals can be exemplified. Preferred supports are a polyester film and an aluminum plate. Above all, aluminum plates, which are dimensionally stable and comparatively inexpensive, are preferred.

Aluminum plates are a pure aluminum plate, alloy plates containing aluminum as the main component and a trace amount of different elements, and aluminum or aluminum alloy thin films laminated with plastics. The examples of different elements contained in aluminum alloys include silicon, iron, manganese, copper, magnesium, chromium, zinc, bismuth, nickel, titanium, etc. The content of different elements in aluminum alloys is preferably 10 mass% or less. In the invention, a pure aluminum plate is preferred but 100% pure aluminum is difficult to manufacture from the refining technique, so that an extremely small amount of different elements may be contained. The compositions of aluminum plates used in the invention are not specified, and aluminum plates of conventionally known and commonly used materials can be optionally used.

A support for use in the invention has a thickness of preferably from 0.1 to 0.6 mm, more preferably from 0.15 to 0.4 mm, and still more preferably from 0.2 to 0.3 mm.

Prior to the use of an aluminum plate, it is preferred for the aluminum plate to be subjected to surface treatment, such as surface roughening treatment and anodizing treatment. By surface treatment, the improvement of hydrophilicity and the security of the adhesion of the photo-polymerization layer and a support become easy. Prior to the surface roughening treatment of an aluminum plate, if necessary, degreasing treatment with a surfactant, an organic solvent or an alkaline aqueous solution is carried out to remove the rolling oil on the surface of the aluminum plate.

Surface roughening treatment of the surface of an aluminum plate is performed by various methods, e.g., mechanical surface roughening treatment, electrochemical surface roughening treatment (surface roughening treatment of electrochemically dissolving the surface), and chemical surface roughening treatment (surface roughening treatment of chemically selectively dissolving the surface) are exemplified.

As the method of mechanical surface roughening treatment, well-known methods, e.g., a ball rubbing method, a brush abrading method, a blast abrading method, or a buffing method, can be used.

As the method of electrochemical surface roughening treatment, a method of performing surface roughening in an electrolyte containing an acid such as a hydrochloric acid, a nitric acid, etc., by alternating current or direct current can be used. Further, a method of using mixed acids can also be used as disclosed in JP-A-54-63902.

An aluminum plate subjected to surface roughening treatment is, if necessary, subjected to alkali etching treatment with an aqueous solution of potassium hydroxide, sodium hydroxide, etc., and neutralizing treatment and then, according to necessity, to anodizing treatment to increase the abrasion resistance of the surface.

Various electrolytes can be used in the anodizing treatment of an aluminum plate for forming a porous oxide film, and a sulfuric acid, a hydrochloric acid, an oxalic acid, a chromic acid or a mixed acid of these acids is generally used. The concentrations of these electrolytes are arbitrarily determined according to the kinds of electrolytes.

Anodizing treatment conditions vary according to electrolytes used, so that the conditions cannot be specified unconditionally, but in general preferably the concentration of an electrolytic solution is from 1 to 80 mass%, the liquid temperature is from 5 to 70°C, the electric current density is from 5 to 60 A/dm², the voltage is from 1 to 100 V, the electrolytic time is from 10 seconds to 5 minutes. The amount of the anodic oxide film to be formed is preferably from 1.0 to 5.0 g/m², and more preferably from 1.5 to 4.0 g/m². In this range of the amount of the anodic oxide film, good press life and good scratch resistance of the non-image part of the lithographic printing plate can be obtained.

After anodizing treatment, if necessary, the surface of the aluminum plate is subjected to hydrophilization treatment. As the hydrophilization treatment, alkali metal silicate methods as disclosed in U.S. Patents 2,714,066, 3,181,461, 3,280,734 and 3,902,734 are known. In these methods, the support is subjected to immersion treatment in an aqueous solution of sodium silicate, etc., or electrolytic treatment. In addition, a method of treating an aluminum plate with potassium fluorozirconate as disclosed in JP-B-36-22063, and a method of treatment with polyvinylphosphonic acid as disclosed in U.S. Patents 3,276,868, 4,153,461 and 4,689,272 are exemplified,

It is preferred that a support for use in the invention has a central line average surface roughness of from 0.10 to 1.2 µm. In this range of an average surface roughness, good adhesion of the support and the photo-polymerization layer, good press life and good soiling resistance can be obtained.

The color density of a support is preferably from 0.15 to 0.65 in terms of a reflection density value. A good image forming property due to antihalation in the time of image exposure and a good plate-detecting property after development can be obtained when the color density of the support is in this range.

### [Back coat layer]

After surface treatment of a support or after forming an undercoat layer, if necessary, a back coat can be provided on the back surface of the support.

As the back coat, e.g., a coating layer comprising an organic polymer compound as disclosed in JP-A-5-45885, and a coating layer comprising metallic oxide obtained by hydrolysis and polycondensation of an organic or inorganic metallic compound as disclosed in JP-A-6-35174 are preferably used. Alkoxy compounds of silicon, e.g., Si(OCH₃)₄, Si(OC₂H₅)₄, Si(OC₃H₇)₄, Si(OC₄H₉)₄, etc., are preferably used for the inexpensiveness and easy availability of the materials.

### [Undercoat layer]

In the lithographic printing plate precursor in the invention, if necessary, an undercoat layer can be provided between the photo-polymerization layer and the support. In the case of an on-press development type lithographic printing plate precursor, since the photo-polymerization layer comes to be easily peeled off the support at an unexposed area by the undercoat layer, there is an advantage that on-press developing property is improved. In the case of infrared laser exposure, since an undercoat layer functions as a heat insulating layer, the heat generated by exposure does not diffuse to the support and is efficiently utilized, so that the improvement of sensitivity can be devised.

As the compounds for an undercoat layer (undercoating compounds), specifically silane coupling agents having an addition polymerizable ethylenic double bond reactive group as disclosed in JP-A-10-282679, and phosphorus compounds having an ethylenic double bond reactive group as disclosed in JP-A-2-304441 are preferably exemplified.

As the most preferred undercoating compound, a polymer resin obtained by copolymerization of a monomer having an adsorptive group, a monomer having a hydrophilic group, and a monomer having a crosslinking group can be exemplified.

The essential component of the polymer resin for undercoating is an adsorptive group onto a hydrophilic support surface. The presence or absence of adsorptivity onto a hydrophilic support surface can be judged by the following method.

A coating solution is prepared by dissolving a test compound in an easily dissolving solvent, and the resulting coating solution is coated on a support in a dry coating weight of 30 mg/m² and dried. The support coated with the test compound is thoroughly washed with the easily dissolving solvent, and the residual amount of the test compound not removed by washing is measured, from which the amount of the compound adsorbed onto the support is computed. The residual amount may be determined by directly measuring the amount of the residual compound, or may be computed from the determination of the amount of the test compound dissolved in the washing solution. The determination of the compound can be performed by fluorescent X-ray measurement, reflecting spectral absorbance measurement, and liquid chromatography measurement. A compound having adsorptivity onto a support is a compound that remains by 1 mg/m² or more after washing as above.

Adsorptive groups onto a hydrophilic support surface are functional groups capable of causing chemical bonding (e.g., ionic bonding, hydrogen bonding, coordinate bonding, bonding by intermolecular force) with the substances present on the hydrophilic support surface (e.g., metal, metallic oxide) or functional groups (e.g., a hydroxyl group). The adsorptive groups are preferably an acid radical or a cationic group.

The acid radical has an acid dissociation constant (pKa) of preferably 7 or less. The examples of acid radicals include a phenolic hydroxyl group, a carboxyl group, -SO₃H, -OSO₃H, -PO₃H₂, -OPO₃H₂, -CONHSO₂-, -SO₂NHSO₂-and -COCH₂COCH₃, and -OPO₃H₂ and -PO₃H₂ are especially preferred. These acid radicals may be metal salts.

The cationic groups are preferably onium groups. The examples of onium groups include an ammonium group, a phosphonium group, an arsonium group, a stibonium group, an oxonium group, a sulfonium group, a selenonium group, a stannonium group, and an iodonium group. An ammonium group, a phosphonium group and a sulfonium group are preferred, and an ammonium group and a phosphonium group are more preferred, and an ammonium group is most preferred.

As especially preferred examples of monomers having an adsorptive group, the compounds represented by the following formula (iii) or (iv) are exemplified.

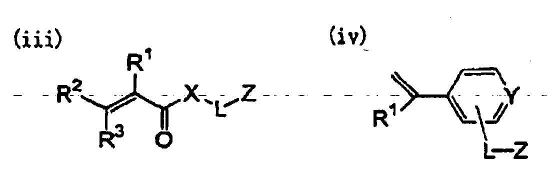

In formula (iii), R¹, R² and R³ each represents a hydrogen atom, a halogen atom, or an alkyl group having from 1 to 6 carbon atoms. R¹, R² and R³ each preferably represents a hydrogen atom or an alkyl group having from 1 to 6 carbon atoms, more preferably represents a hydrogen atom or an alkyl group having from 1 to 3 carbon atoms, and most preferably a hydrogen atom or a methyl group. R² and R³ each especially preferably represents a hydrogen atom. Z represents a functional group adsorptive to the surface of a hydrophilic support.

In formula (iii), X represents an oxygen atom (-O-) or imino (-NH-), and X more preferably represents an oxygen atom. In formula (iii), L represents a divalent linking group. L preferably represents a divalent aliphatic group (an alkylene group, a substituted alkylene group, an alkenylene group, a substituted alkenylene group, an alkynylene group, a substituted alkynylene group), a divalent aromatic group (an arylene group, a substituted arylene group), or a divalent heterocyclic group, or combinations of these groups with an oxygen atom (-O-), a sulfur atom (-S-), imino (-NH-), substituted imino (-NR-, where R represents an aliphatic group, an aromatic group or a heterocyclic group), or carbonyl (-CO-).

The aliphatic group may have a cyclic structure or a branched structure. The number of carbon atoms of the aliphatic group is preferably from 1 to 20, more preferably from 1 to 15, and most preferably from 1 to 10, As the aliphatic group, a saturated aliphatic group is preferred to an unsaturated aliphatic group. The aliphatic group may have a substituent. The examples of the substituents include a halogen atom, a hydroxyl group, an aromatic group and a heterocyclic group.

The number of carbon atoms of the aromatic group is preferably from 6 to 20, more preferably from 6 to 15, and most preferably from 6 to 10. The aromatic group may have a substituent. The examples of the substituents include a halogen atom, a hydroxyl group, an aliphatic group, an aromatic group and a heterocyclic group.

It is preferred for the heterocyclic group to have a 5-or 6-membered ring as a heterocyclic ring. Other heterocyclic ring, aliphatic ring or aromatic ring may be condensed with the heterocyclic ring. The heterocyclic group may have a substituent. The examples of the substituents include a halogen atom, a hydroxyl group, an oxo group (=O), a thioxo group (=S), an imino group (=NH), a substituted imino group (=N-R, where R represents an aliphatic group, an aromatic group or a heterocyclic group), an aliphatic group, an aromatic group, and a heterocyclic group.

L is preferably a divalent linking group containing a plurality of polyoxyalkylene structures. The polyoxyalkylene structures are more preferably polyoxyethylene structures. In other words, it is preferred for L to contain -(OCH₂CH₂)ₙ- (n is an integer of 2 or more).

In formula (iv), Y represents a carbon atom or a nitrogen atom. In a case where Y is a nitrogen atom and L is linked on Y to form a quaternary pyridinium group, the group itself shows adsorptivity, so that Z is not essential, and Z may be a hydrogen atom. L represents the same divalent linking group as in formula (iii) or a single bond.

The adsorptive functional group is as described above.

The representative examples of the compounds represented by formula (iii) or (iv) are shown below.

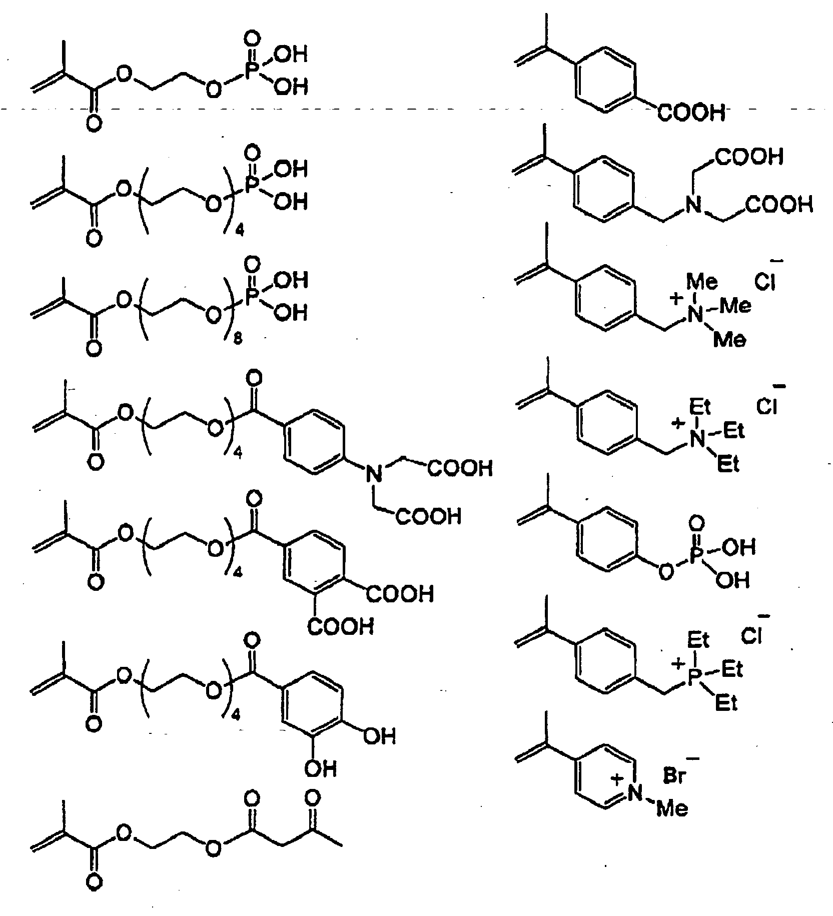

As the hydrophilic groups of polymer resins for undercoating that can be used in the invention, e.g., a hydroxyl group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amido group, a carboxymethyl group, a sulfonic acid group, a phosphoric acid group, etc., are preferably exemplified. Monomers having a sulfo group showing high hydrophilicity are preferred above all. As the specific examples of the monomers having a sulfo group, sodium salts and amine salts of methallyloxybenzene-sulfonic acid, allyloxybenzenesulfonic acid, allylsulfonic acid, vinylsulfonic acid, p-styrenesulfonic acid, methallyl-sulfonic acid, acrylamido-t-butylsulfonic acid, 2-acrylamido-2-methylpropanesulfonic acid, or (3-acryloyloxypropyl)butylsulfonic acid are exemplified. Of these monomers, from a hydrophilic performance and handling property in synthesis, sodium salt of 2-acrylamido-2-methyl-propanesulfonic acid is preferred.

It is preferred for the polymer resins for the undercoat layer in the invention to have a crosslinking group. Adhesion of the undercoat layer to an image part can be heightened on account of a crosslinking group. For giving a crosslinking property to the polymer resin for the undercoat layer, it is effective to introduce a crosslinking functional group, e.g., an ethylenic unsaturated bond, to the side chain of the polymer, and to form a salt structure by the polar substituent of the polymer resin, a substituent having counter charge, and a compound having an ethylenic unsaturated bond.

As the examples of polymers having an ethylenic unsaturated bond in the side chain of the molecule, polymers of ester or amide of an acrylic acid or methacrylic acid, wherein the residue of the ester or amide (R of -COOR or -CONHR) has an ethylenic unsaturated bond, are exemplified.

The examples of the residues having an ethylenic unsaturated bond (the above R) include -(CH₂)ₙCR₁=CR₂R₃, -(CH₂O),CH₂CR₁=CR₂R₃, -(CH₂CH₂O)ₙCH₂CR₁=CR₂R₃, -(CH₂)ₙNH-CO-O-CH₂CR₁=CR₂R₃, -(CH₂)ₙ-O-CO-CR₁=CR₂R₃, and (CH₂CH₂O)₂-X (in the formulae, R₁, R₂ and R₃ each represents a hydrogen atom, a halogen atom, an alkyl group having from 1 to 20 carbon atoms, an aryl group, an alkoxyl group or an aryloxy group, and R₁ and R₂ or R₃ may be bonded to each other to form a ring, n represents an integer of from 1 to 10, and X represents a dicyclopentadienyl residue).

The specific examples of the ester residues include -CH₂CH=CH₂ (disclosed in JP-B-7-21633), -CH₂CH₂O-CH₂CH=CH₂, -CH₂C(CH₃)=CH₂, -CH₂CH=CH-C₆H₅, -CH₂CH₂OCOCH=CH-C₆H₅, -CH₂CH₂NHCOO-CH₂CH=CH₂, and -CH₂CH₂O-X (wherein X represents a dicyclopentadienyl residue).

The specific examples of the amido residues include -CH₂CH=CH₂, -CH₂CH₂O-Y (wherein Y represents a cyclohexene residue), and -CH₂CH₂OCO-CH=CH₂.

As the monomers having a crosslinking group of the polymer resins for the undercoat layer, the above esters or amides of acrylic acid or methacrylic acid having a crosslinking group are preferred.

The content of crosslinkable groups in the polymer resin for the undercoat layer (the content of radical polymerizable unsaturated double bonds by the iodometric titration method) is preferably from 0.1 to 10.0 mmol per gram of the polymer resin, more preferably from 1.0 to 7.0 mmol, and most preferably from 2.0 to 5.5 mmol. The compatibility of good sensitivity with soiling resistance, and good preservation stability can be obtained in this range of the crosslinkable groups.

The polymer resins for the undercoat layer have a mass average molecular weight of preferably 5,000 or higher, more preferably from 10,000 to 300,000, and a number average molecular weight of preferably 1,000 or higher, more preferably from 2,000 to 250,000. The degree of polydispersion (mass average molecular weight/number average molecular weight) is preferably from 1.1 to 10.

The polymer resins for the undercoat layer may be any of a random polymer, a block polymer and a graft polymer, but a random polymer is preferred.

The polymer resins for the undercoat layer may be used alone, or two or more resins may be used as mixture. A coating solution for the undercoat layer can be obtained by dissolving the polymer resin for the undercoat layer in at least one of an organic solvent (e.g., methanol, ethanol, acetone, methyl ethyl ketone or the like) and water. The coating solution for the undercoat layer can also contain an infrared absorber.

Various well-known coating methods can be used for coating the coating solution for the undercoat layer on a support. For example, bar coater coating, rotary coating, spray coating, curtain coating, dip coating, air knife coating, blade coating, and roll coating can be exemplified.

The coating weight of the undercoat layer (solids content) is preferably from 0.1 to 100 mg/m², and more preferably from 1 to 30 mg/m².

### [Protective layer]

In the lithographic printing plate precursor of the invention, for the purpose of giving an oxygen-intercepting property, preventing the generation of scratches on a photo-polymerization layer, and preventing ablation occurring at the time of exposure with high intensity laser, if necessary, a protective layer (an overcoat layer) may be provided on the photo-polymerization layer.

Exposure processing of a lithographic printing plate is generally carried out in the air. Low molecular weight compounds such as oxygen and basic substances present in the air can hinder the image forming reaction that occurs in a photo-polymerization layer by exposure process. The protective layer prevents the low molecular weight compounds such as oxygen and basic substance from mixing into the photo-polymerization layer, as a result inhibits hindering the image forming reaction in the air. Accordingly, the characteristics required of the protective layer are to lower the permeability of the low molecular weight compounds such as oxygen, to be good in transmittance of light used for exposure, to be excellent in adhesion with the photo-polymerization layer, and to be capable of being eliminated easily in the on-press development process after exposure. Protective layers having such characteristics are disclosed in, e.g., U.S. Patent 3,458,311 and JP-B-55-49729.

As the materials for use in the protective layer, any of water-soluble polymers and water-insoluble polymers can be arbitrarily selected and used. Specifically, for example, water-soluble polymers, e.g., polyvinyl alcohol, modified polyvinyl alcohol, polyvinyl pyrrolidone, polyvinyl imidazole, polyacrylic acid, polyacrylamide, a partial saponification product of polyvinyl acetate, ethylene-vinyl alcohol copolymers, water-soluble cellulose derivatives, gelatin, starch derivatives, gum arabic, etc., and polymers, e.g., polyvinylidene chloride, poly(meth)acrylonitrile, polysulfone, polyvinyl chloride, polyethylene, polycarbonate, polystyrene, polyamide, cellophane, etc. can be exemplified. These polymers can also be used in combination of two or more, if necessary.

As relatively useful materials of the above polymers, water-soluble polymer compounds that are excellent in crystallizability are exemplified, and specifically polyvinyl alcohol, polyvinyl pyrrolidone, polyvinyl imidazole, water-soluble acrylic resins, e.g., polyacrylic acid, etc., gelatin, gum arabic, etc., are preferred, and from the aspects of capable of coating with water as the solvent and capable of being easily removed with a fountain solution in printing, polyvinyl alcohol, polyvinyl pyrrolidone and polyvinyl imidazole are preferred. Of these polymers, polyvinyl alcohol (PVA) gives the best results to fundamental characteristics such as oxygen interception and removal by development.

Polyvinyl alcohols that can be used for the protective layer may be partially substituted with ester, ether and acetal so long as they contain a substantial amount of unsubstituted vinyl alcohol units having necessary water solubility. A part of the polyvinyl alcohols may also contain other copolymer components. For example, polyvinyl alcohols of various polymerization degrees randomly having a variety of hydrophilic modified sites such as anion modified site modified with an anion, e.g., a carboxyl group, a sulfo group, etc., a cation modified site modified with a cation, e.g., an amino group, an ammonium group, etc., a silanol modified site, a thiol modified site, etc.; and polyvinyl alcohols of various degrees of polymerization having at polymer chain terminals a variety of modified sites such as ester modified sites of the above anion modified site, cation modified site, silanol modified site, thiol modified site, further an alkoxyl modified site, a sulfide modified site, or vinyl alcohol with various organic acids, ester modified sites of the above anion modified site with alcohols, etc., an epoxy modified site, etc., are also preferably used.

These modified polyvinyl alcohols are preferably compounds hydrolyzed by 71 to 100% and having polymerization degree of the range of from 300 to 2,400. Specifically, the examples include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, and L-8 (manufactured by Kuraray Co., Ltd.). Further, as modified polyvinyl alcohols, KL-318, KL-118, KM-618, KM-118 and SK-5102 having an anion modified site, C-318, C-118 and CM-318 having a cation modified site, M-205 and M-115 having a terminal thiol modified site, MP-103, MP-203, MP-102 and MP-202 having a terminal sulfide modified site, HL-12E and HL-1203 having a modified site of ester with higher fatty acid at terminals, and R-1130, R-2105, R-2130 having a reactive silane modified site are exemplified.

It is also preferred that the protective layer contains a layered compound. The layered compound is a particle in a thin tabular shape and, for example, a mica group, such as natural mica and synthetic mica represented by the following formula, A(B, C)₂₋₅D₄O₁₀(OH, F, O)₂ (wherein A represents any of Li, K, Na, Ca, Mg, and an organic cation, B and C represent any of Fe(II), Fe(III), Mn, Al, Mg and V, and D represents Si or Al), and talc, taeniolite, montmorillonite, saponite, hectorite and zirconium phosphate represented by formula 3MgO·4SiO·H₂O are exemplified.

The examples of natural micas include muscovite, paragonite, phlogopite, biotite and lepidolite. The examples of synthetic micas include non-swellable micas, e.g., fluorine phlogopite KMg₃(AlSi₃O₁₀)F₂ and potassium tetrasilicate mica KMg_{2.5}(Si₄O₁₀)F₂, etc., and swellable micas, for example, Na tetrasilisic mica NaMg_{2.5}(Si₄O₁₀)F₂, Na or Li taeniolite (Na, Li)Mg₂Li(Si₄O₁₀)F₂, and montmorillonite series Na or Li hectorite (Na, Li)_{1/8}Mg_{2/5}Li_{1/8}(Si₄O₁₀)F₂, etc. Synthetic smectites are also useful.

Of these layered compounds described above, fluorine-based swellable micas, which are synthetic layered compounds, are especially useful. That is, these swellable clay minerals, e.g., micas, montmorillonite, saponite, hectorite, bentonite, etc., have a lamination structure comprising unit crystal lattice layers having a thickness of from 10 to 15 Å or so, and metallic atom substitution in the lattice is extremely great as compared with other clay minerals. As a result, there is an insufficient quantity of positive electric charge in the lattice layers, and organic cations such as Li⁺, Na⁺, Ca²⁺, Mg²⁺, amine salt, quaternary ammonium salt, phosphonium salt and sulfonium salt are adsorbed among layers to compensate for the insufficiency. These layered compounds swell with water. When shear is applied in the swollen state, the lattices easily cleave and form stable sol in water. Bentonite and swellable synthetic micas have the tendency markedly.

In connection with the shape of the layered compounds, the thickness is the thinner the better from the viewpoint of the control of diffusion, and the plane size is the bigger the better so long as the smoothness of the coated surface and the transmission of actinic rays are not hindered. Accordingly, the aspect ratio of layered compounds is preferably 20 or higher, preferably 100 or higher, and especially preferably 200 or higher. The aspect ratio is the ratio of the thickness to the long diameter of a particle, and this can be measured, for example, from the projection drawing of the microphotograph of a particle. The greater the aspect ratio, the greater is the effect obtained.

The average diameter of the particle of layered compounds is from 1 to 20 µm, preferably from 1 to 10 µm, and especially preferably from 2 to 5 µm. When the particle size is smaller than 1 µm, the control of permeation of oxygen and moisture is insufficient, so that sufficient effect cannot be revealed. While when the particle size is greater than 20 µm, dispersion stability in a coating solution is insufficient, so that stable coating cannot be done. The average thickness of the particles is 0.1 µm or less, preferably 0.05 µm or less, and especially preferably 0.01 µm or less. For instance, of the inorganic layered compounds, the thickness of swellable synthetic mica, which is a representative compound, is from 1 to 50 nm, and the plane size is from 1 to 20 µm.

When the particles of inorganic layered compounds having such a high aspect ratio are contained in a protective layer, the film strength is improved and the permeation of oxygen and moisture can be effectively prevented, hence the deterioration of the protective layer due to deformation and the like can be restrained. Therefore, even when the lithographic printing plate precursor is preserved under a high moisture condition for a long period of time, the lithographic printing plate precursor is free from the degradation of image-forming property due to the change in moisture, and excellent preservation stability can be ensured.

The content of the inorganic layered compound in a protective layer is preferably in a proportion of from 5/1 to 1/100 in mass ratio to the amount of the binder used in the protective layer. Even when a plurality of inorganic layered compounds are used in combination, it is preferred that the total amount of these inorganic layered compounds be within the above mass ratio.

When the inorganic layered compounds are used in a protective layer, it is preferred to add a phosphonium compound to at least one of the photo-polymerization layer and the protective layer for the purpose of improvement of ink adhesion. As the phosphonium compound, a phosphonium compound represented by the following formula (v) or (vi) is preferred, and a phosphonium compound represented by formula (v) is especially preferred.

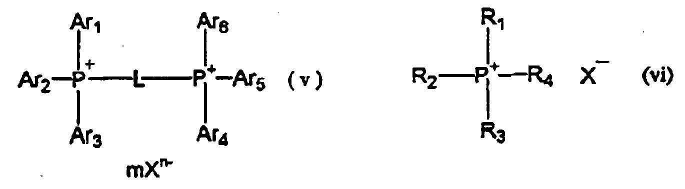

In formula (v), Ar₁ to Ar₆ each represents an aryl group or a heterocyclic group; L represents a divalent linking group; X represents an n-valent counter anion; n represents an integer of from 1 to 3; and m represents a number satisfying nxm=2. As the aryl groups here, a phenyl group, a naphthyl group, a tolyl group, a xylyl group, a fluorophenyl group, a chloro-phenyl group, a bromophenyl group, a methoxyphenyl group, an ethoxyphenyl group, a dimethoxyphenyl group, a methoxy-carbonylphenyl group, a dimethylaminophenyl group, etc., are preferably exemplified. As the heterocyclic group, a pyridyl group, a quinolyl group, a pyrimidinyl group, a thienyl group, a furyl group, etc., are exemplified.

L represents a divalent linking group. The number of carbon atoms in the linking group is preferably from 6 to 15, and more preferably from 6 to 12 carbon atoms.

X represents a counter anion, and as preferred anions, halogen anions, e.g., Cl⁻, Br⁻, I⁻, etc., a sulfonate anion, a carboxylate anion, a sulfate anion, PF₆⁻, BF₄⁻, a perchlorate anion, etc., are exemplified. Of these anions, halogen anions, such as Cl⁻, Br⁻ and I⁻, a sulfonate anion, and a carboxylate anion are especially preferred.

The specific examples of the phosphonium salts represented by formula (v) that are used in the invention are shown below.

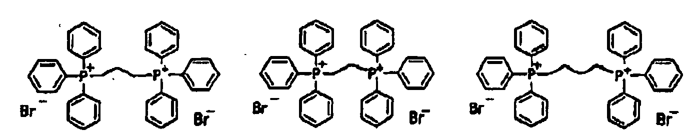

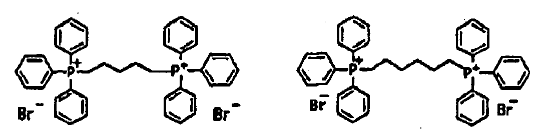

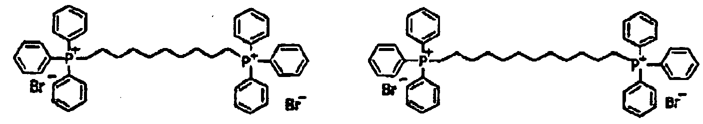

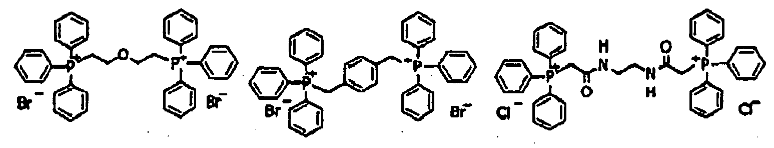

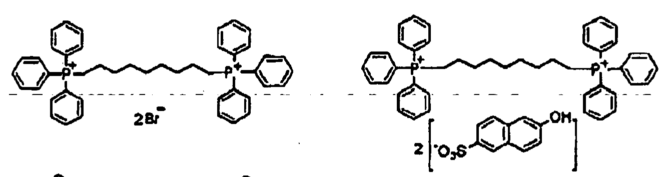

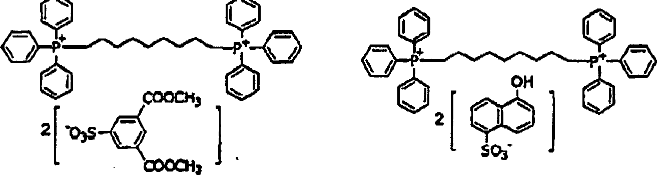

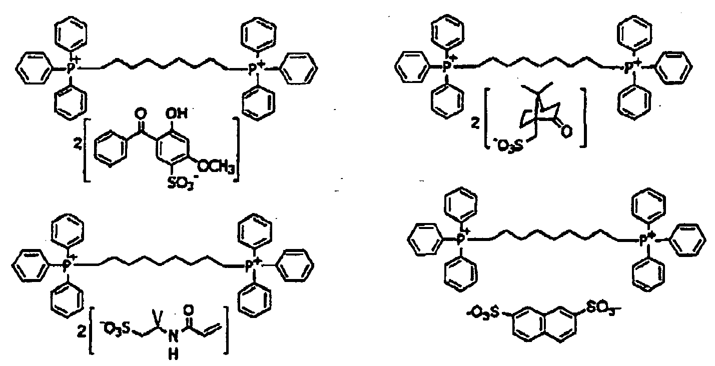

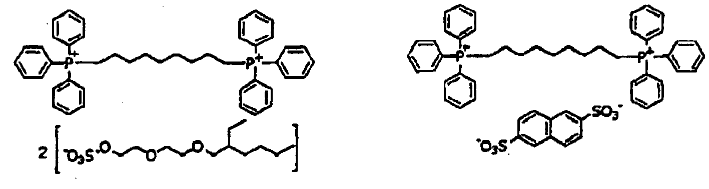

In formula (vi), R₁ to R₄ each represents an alkyl group, an alkenyl group, an alkynyl group, a cycloalkyl group, an alkoxyl group, an aryl group, an aryloxy group, an alkylthio group, a heterocyclic group, or a hydrogen atom, each of which may have a substituet. At least two of R₁ to R₄ may be bonded to each other to form a ring. X represents a counter anion.

When R₁ to R₄ each represents an alkyl group, an alkoxyl group or an alkylthio group, the number of carbon atoms is generally from I to 20, when an alkenyl group or an alkynyl group, the number of carbon atoms is generally from 2 to 15, and when a cycloalkyl group, the number of carbon atoms is generally from from 3 to 8. As the aryl group, a phenyl group and a naphthyl group, as the aryloxy group, a phenoxy group and a naphthyloxy group, as the arylthio group, a phenylthio group, and as the heterocyclic group, a furyl group and a thienyl group are respectively exemplified. As the substituents that these groups may have, for example, an alkyl group, an alkenyl group, an alkynyl group, a cycloalkyl group, an alkoxyl group, an alkoxycarbonyl group, an acyl group, an alkylthio group, an aryl group, an aryloxy group, an arylthio group, a sulfino group, a sulfo group, a phosphino group, a phosphoryl group, an amino group, a nitro group, a cyano group, a hydroxyl group, a halogen atom, etc., are exemplified. These substituents may further have a substituent.

As the examples of the anions represented by X⁻, halide ions such as cl⁻, Br⁻, I⁻, etc., inorganic acid anions, e.g., ClO₄⁻, PF₆⁻, SO₄⁻², etc., organic carboxylate anions, and an organic sulfonate anion are exemplified. As the organic groups of the organic carbonate anion and organic sulfonate anion, methyl, ethyl, propyl, butyl, phenyl, methoxyphenyl, naphthyl, fluorophenyl, difluorophenyl, pentafluorophenyl, thienyl, pyrrolyl, etc., are exemplified. Of these anions, Cl⁻, Br⁻, I⁻, ClO₄⁻ and PF₆⁻ are preferred. The specific examples of the phosphonium compounds that are preferably used in the invention are shown below.

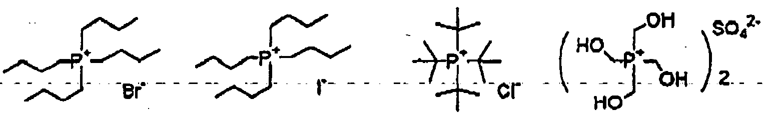

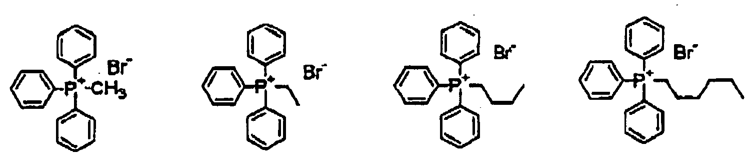

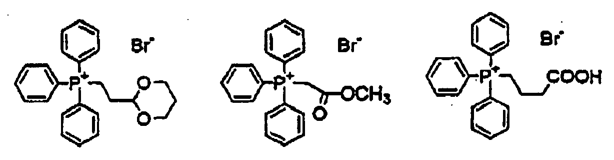

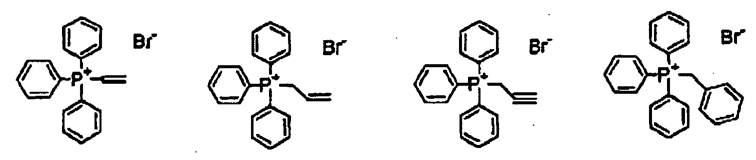

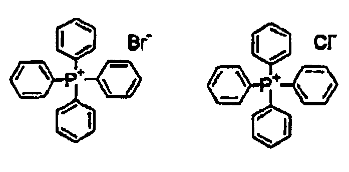

The addition amount of the phosphonium salt to the photo-polymerization layer or protective layer is preferably from 0.01 to 20 mass% based on the solids content of each layer, more preferably from 0.05 to 10 mass%, and most preferably from 0.1 to 5 mass%. In this range of the content, a good ink adhering property can be obtained.

As other compositions of the protective layer, by the addition of glycerol, dipropylene glycol, etc., in an amount of several mass% to the (co)polymer, flexibility can be given. Further, an anionic surfactant, e.g., sodium alkylsulfate, sodium alkylsulfonate, etc.; an amphoteric surfactant, e.g., alkylaminocarboxylate, alkylaminodicarboxylate, etc.; and a nonionic surfactant, e.g., polyoxyethylene alkyl phenyl ether, etc., can be added. These surfactants can be used in an amount of from 0.1 to 100 mass% based on the (co)polymer.

For the improvement of adhesion with an image part, there are disclosed, e.g., in JP-A-49-70702 and British Patent Application 1,303,578 that sufficient adhesion can be obtained by mixing from 20 to 60 mass% of an acrylic emulsion, a water-insoluble vinylpyrrolidone-vinyl acetate copolymer, etc., to a hydrophilic polymer primarily comprising polyvinyl alcohol, and laminating the resulting mixture on a photo-polymerization layer. Any of these known techniques can be used in the invention.

Other functions can also be given to the protective layer. For example, by the addition of a colorant excellent in transmission of infrared rays used for exposure and capable of efficiently absorbing rays of other wavelengths (e.g., water-soluble dyes), safelight aptitude can be improved without causing reduction of sensitivity.

General methods of dispersing a layered compound for use in a protective layer are described below. In the first place, from 5 to 10 mass parts of a swellable layered compound exemplified above as preferred example is added to 100 mass parts of water to be made thoroughly intimate with water to swell, and then dispersed with a disperser. As the dispersers used here, various kinds of mills of directly applying force mechanically to effect dispersion, high speed stirring type dispersers having great shearing force, and dispersers giving ultrasonic energy of high strength and the like are exemplified. Specifically, a ball mill, a sand grinder mill, a visco mill, a colloid mill, a homogenizer, a dissolver, a POLYTRON, a homomixer, a homoblender, a KD mill, a JET AJITER, a capillary emulsifier, a liquid siren, an electromagnetic distortion type ultrasonic wave generator, an emulsifier having a Poleman whistle and the like are exemplified. The dispersion containing 5 to 10 mass parts of the inorganic layered compound dispersed by the above method is highly viscous or gel and very excellent in preservation stability. When a protective layer coating solution is prepared by using the dispersion, it is preferred to dilute the dispersion with water and thoroughly stir, and then blend with a binder solution.

To the protective layer coating solution can be added known additives such as an anionic surfactant, a nonionic surfactant, a cationic surfactant, and a fluorine surfactant to improve coating stability, and a water-soluble plasticizer to improve physical properties of the film. As water-soluble plasticizers, e.g., propionamide, cyclohexanediol, glycerol, sorbitol, etc., are exemplified. Further, a water-soluble (meth)acrylic polymer can also be added. In addition, known additives may be added to the coating solution in order to improve the adhesion with the photo-polymerization layer and aging stability of the coating solution,

By coating the thus prepared protective layer coating solution on the photo-polymerization layer provided on a support and drying, a protective layer is formed. A coating solvent can be arbitrarily selected in connection with the binder, and when a water-soluble polymer is used, it is preferred to use distilled water and purified water as the coating solvent. The coating method of the protective layer is not especially restricted and known methods, e,g., the methods disclosed in U.S. Patent 3,458,311 and JP-B-55-49729 can be used. Specifically, the protective layer is coated, for example, by a blade coating method, an air knife coating method, a gravure coating method, a roll coating method, a spray coating method, a dip coating method, or a bar coater coating method.

The coating amount of the protective layer is preferably in the range of from 0.01 to 10 g/m² in dry weight, more preferably from 0.02 to 3 g/m², and most preferably from 0.02 to 1 g/m².

### [Lithographic printing method]

As the light source for the exposure of the lithographic printing plate precursor of the invention, known ones can be used. Specifically, various kinds of lasers are preferably used as the light sources. In the lithographic printing method of the invention, the lithographic printing plate precursor is imagewise exposed with an infrared laser. The infrared lasers used are not especially restricted, but a solid state laser and a semiconductor laser radiating infrared rays of from 760 to 1,200 nm are preferably exemplified.

Exposure mechanism may be any of an internal drum system, an external drum system and a flat bed system. Infrared lasers are preferably those capable of outputting 100 mW or more. It is preferred to use a multi-beam laser device for expediting exposure. The exposure time per a pixel is preferably not longer than 20 µsec. The quantity of irradiation energy is preferably from 10 to 300 mJ/cm2.

In the lithographic printing method in the invention, after the lithographic printing plate precursor of the invention is imagewise exposed with an infrared laser as described above, printing is carried out by supplying oil ink and an aqueous component without being subjected to any development process.

Specifically, a method of subjecting the lithographic printing plate precursor to exposure with an infrared laser, and then mounting the exposed printing plate precursor on a printing press without undergoing development process and performing printing, and a method of mounting the lithographic printing plate precursor on a printing press, and then exposing the printing plate precursor with an infrared laser on the printing press, and performing printing are exemplified.

In the case of an on-press development type lithographic printing plate precursor, when the lithographic printing plate precursor is imagewise exposed with an Infrared laser and then printing is performed by supplying an aqueous component and oil ink without development process such as wet development process, the photo-polymerization layer cured by exposure forms an oil ink-receiving part having a lipophilic surface at the exposed part of the photo-polymerization layer. On the other hand, at the unexposed part, the uncured photo-polymerization layer is dissolved or dispersed with at least one of the supplied aqueous component and oil ink and removed, and a hydrophilic surface is bared at that part. As a result, the aqueous component adheres to the bared hydrophilic surface, the oil ink adheres to the photo-polymerization layer of the exposed part, and printing is started.

Here, the one supplied first to the printing plate may be an aqueous component or may be oil ink. However, for preventing the aqueous component from being soiled by the photo-polymerization layer at the unexposed part, it is preferred to supply oil ink first in the on-press developing type lithographic printing plate precursor of the invention. As the aqueous component and the oil ink, a fountain solution and printing ink for ordinary lithographic printing are respectively used.

By the use of the lithographic printing plate precursor of the invention, on-press development and subsequent printing can be performed in the same manner as in the above lithographic printing method even when UV ink is used, and good press life can be obtained. As the UV ink, ordinary UV inks on the market can be used.

In this manner, a lithographic printing plate precursor is subjected to on-press development on an offset press and used as it is in printing of a plenty of sheets.

### [Example]

The invention will be described in detail with reference to examples and comparative examples, but the invention should not be construed as being restricted thereto.

### EXAMPLES 1 TO 17 AND COMPARATIVE EXAMPLE 1

### 1. Manufacture of a lithographic printing plate precursor:

### (1) Manufacture of a support:

For removing the rolling oil on the surface of an aluminum plate having a thickness of 0.3 mm (material 1050), the aluminum plate is subjected to degreasing treatment with a 10 mass% sodium aluminate aqueous solution at 50°C for 30 seconds, and then graining with three nylon brushes planted with hairs having a hair diameter of 0.3 mm and a suspension of pumice of a median diameter of 25 µm and water (the specific gravity: 1.1 g/cm³), and thoroughly washed with water. The plate is immersed in a 25 mass% sodium hydroxide aqueous solution of 45°C for 9 seconds for etching, and washed with water. After washing with water, the plate is further immersed in a 20 mass% nitric acid aqueous solution at 60°C for 20 seconds, followed by washing with water. The etched amount of the surface by the graining is about 3 g/m².

In the next place, electrochemical surface roughening treatment is performed continuously by alternating voltage of 60 Hz. The electrolyte at this time is a 1 mass% nitric acid aqueous solution (containing 0.5 mass% of aluminum ions) and the liquid temperature is 50°C. As the alternating current electric source waveform, trapezoidal rectangular wave alternating current is used, the time TP required for the electric current value to reach the peak from zero is 0.8 msec, the duty ratio is 1/1, and electrochemical surface roughening treatment is performed with a carbon electrode as the counter electrode. Ferrite is used as the auxiliary anode. The electric current density is 30 A/dm² at a peak value of electric current, and 5% of the electric current from the electric source is diverted to the auxiliary anode. The quantity of electricity in the nitric acid electrolysis is the quantity of electricity of 175 C/dm² at the time with the aluminum plate as the anode. The aluminum plate is then washed with water by spraying.

Subsequently, the aluminum plate is subjected to electrochemical surface roughening treatment with an electrolyte containing a 0.5 mass% hydrochloric acid aqueous solution (containing 0.5 mass% of aluminum ions) at a liquid temperature of 50°C on the condition of the quantity of electricity of 50 C/dm² at the time with the aluminum plate as the anode in the same manner as in the above nitric acid electrolysis. The plate is then washed with water by spraying. The plate is provided with a direct current anodic oxide film of 2.5 g/m² with a 15 mass% sulfuric acid (containing 0.5 mass% of aluminum ions) as the electrolyte and by the electric current density of 15 A/dm², and then washed and dried. The central line average roughness (Ra) of the plate measured with a needle having a diameter of 2 µm is 0.51 µm. The following undercoat layer coating solution (1) is coated on the aluminum plate in a dry coating weight of 6 mg/m² to prepare a support.

**<Undercoat layer coating solution (1)>**

| | |
|---|---|
| Compound (1) for undercoating (mass average molecular weight: 60,000) | 0.017 g |
| Methanol | 9.00 g |
| Water | 1.00 g |

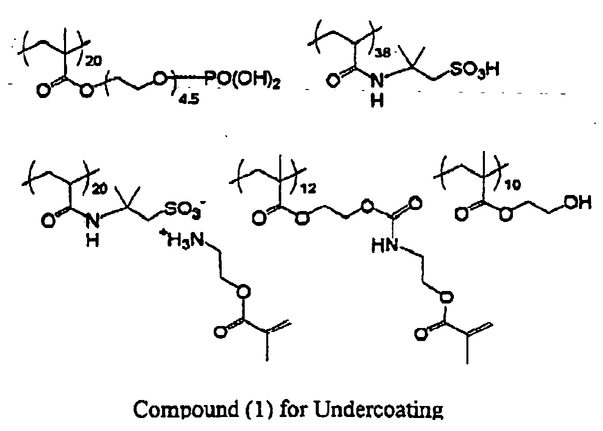

### (2) Formation of a photo-polymerization layer and a protective layer:

A photo-polymerization layer coating solution having the composition shown below is coated on the above support having been provided with the undercoat layer by bar coating, dried in an oven at 100°C for 60 sec. to form a photo-polymerization layer having a dry coating weight of 1.0 g/m².

Subsequently, a protective layer coating solution having the composition shown below is coated on the above photo-polymerization layer by bar coating, dried in an oven at 120°C for 60 sec. to form a protective layer having a dry coating weight of 0.15 g/m², whereby each of lithographic printing plate precursors (1) to (6) and lithographic printing plate precursor for comparison (R1) is obtained.

The photo-polymerization layer coating solution is obtained by mixing each of the photosensitive solutions and microgel solution (1) respectively shown below and stirring just before coating.

Incidentally, in photosensitive solution (R1) for use in Comparative Example 1, specific polymer for comparison (R-1) having the structure shown below is used in place of the specific polymer compound of the invention.

### <Photosensitive solutions (1) to (9) and (R1)>

| | |
|---|---|
| Binder polymer (exemplified compound of the invention shown in Table 1 below) | 0.177 g |
| Infrared absorber (1) | 0.031 g |
| Polymerizable monomer (ARONIX M-215™, manufactured by Toagosei Co., Ltd.) | 0.319 g |
| Polymerization initiator (1) | 0.213 g |
| Phosphonium compound (1) | 0.035 g |
| Fluorine surfactant (1) | 0.004 g |
| Anionic surfactant (Pionin A-24-EA™, a 40 mass% aq. soln., manufactured by Takemoto Oil & Fat) | 0.125 g |
| Methyl ethyl ketone | 2.554 g |
| 1-Methoxy-2-propanol | 7.023 g |

### <Microgel solution (1)>

| | |
|---|---|
| Dispersion of microgel solution (1) | 1.800 g |
| Water | 1.678 g |

### <Synthesis of microgel dispersion (1)>

As the oil phase component, 10.0 g of the addition product of trimethylolpropane and xylene diisocyanate (Takenate D-110N™, a 75 mass% ethyl acetate solution, manufactured by Mitsui Takeda Chemicals Inc.), 6.00 g of ARONIX M-215™ (manufactured by Toagosei Co., Ltd.) as the polymerizable monomer, and 0.12 g of Pionin A-41C™ (manufactured by Takemoto Oil & Fat) are dissolved in 16.67 g of ethyl acetate. As the aqueous phase component, 37.5 g of a 4 mass% aqueous solution of PVA-205™ is prepared. The oil phase component and the aqueous phase component are mixed, and emulsified with a homogenizer at 12,000 rpm for 10 minutes. The obtained emulsified product is added to 25 g of distilled water, stirred at room temperature for 30 minutes, and then stirred at 40°C for 2 hours. The microcapsule solution thus obtained is diluted with distilled water to make the concentration of solids content 21 mass% to obtain microgel dispersion (1). The average particle size is 0.23 µm.

The structures of the compounds used in the photosensitive solutions are shown below,

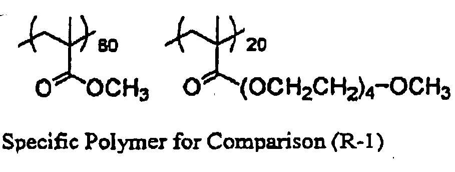

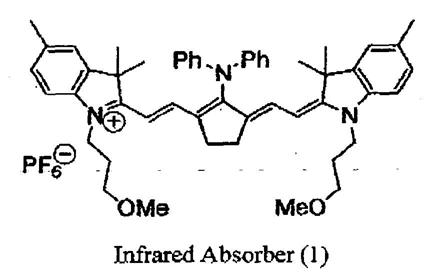

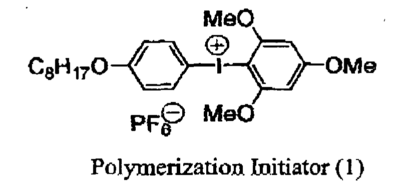

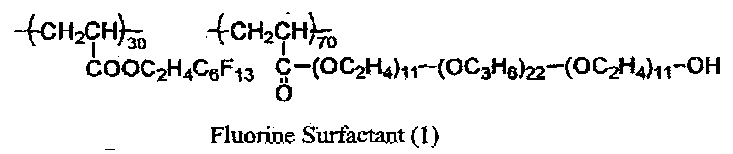

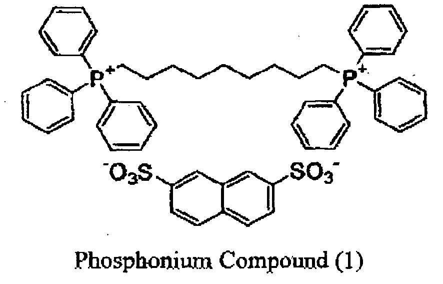

### <Protective layer coating solution>

| | |
|---|---|
| Inorganic layered compound dispersion (1) shown below | 1.5 g |
| Polyvinyl alcohol (PVA 105™, degree of saponification: 98.5 mol%, degree of polymerization: 500, manufactured by Kuraray Co., Ltd.) | 0.06 g |
| Polyvinyl pyrrolidone (Polyvinyl Pyrrolidone K30™, molecular weight Mw: 40,000, manufactured by Tokyo Chemical Industry Co., Ltd.) | 0.01 g |
| Copolymer of vinylpyrrolidone and vinyl acetate (LUVITEC VA64W™, copolymerization ratio: 6/4, manufactured by ISP) | 0,01 g |

### <Preparation of inorganic layered compound dispersion (1)>

To 193.6 g of ion exchange water is added 6.4 g of synthetic mica Somasif ME-100™ (manufactured by CO-OP CHEMICAL CO., LTD.), and the mixture is dispersed with a homogenizer until the average particle size (a laser scattering method) reaches 3 µm. The aspect ratio of the particles of the obtained inorganic layered compound dispersion is 100 or more.

### 2. Exposure, printing and evaluation of the lithographic printing plate precursor:

Each of the obtained lithographic printing plate precursors in Examples and Comparative Example is subjected to exposure with Trendsetter 3244VX™ (manufactured by Creo Products Incorporated) loading a water-cooling type 40 W infrared semiconductor laser on the conditions of output of 9 W, external drum rotation speed of 210 rpm, and resolution of 2,400 dpi, so that the exposed image contains a fine line chart.

In general, in the case of a negative lithographic printing plate precursor, the degree of curing of a photosensitive layer (a photo-polymerization layer in the invention) is low when the quantity of exposure is small, and the degree of curing is high when the quantity of exposure is large. When the degree of curing of a photo-polymerization layer is too low, the press life of the lithographic printing plate precursor lowers, and also reproducibility of a small dot and a fine line becomes failure. On the other hand, when the degree of curing of a photo-polymerization layer is high, the press life is high, and reproducibility of a small dot and a fine line becomes good.

In the examples and comparative example, as shown below, the press life and fine line reproducibility of the obtained negative lithographic printing plate precursors are evaluated on the same exposure condition as described above and the results of evaluations are taken as the criteria of the sensitivity of each lithographic printing plate precursor. That is, it can be said that the more the number of printed sheets in press life, and the finer the fine line width in fine line reproducibility, the higher is the sensitivity of the lithographic printing plate precursor.

### (1) On-press developing property:

Each of the obtained exposed lithographic printing plate precursors is mounted on the cylinder of printing press SOR-M™ (manufactured by Heidelberg Japan K.K.) without being subjected to development processing. A fountain solution (EU-3 (an etch, manufactured by Fuji Photo Film Co., Ltd.)/water/isopropyl alcohol = 1/89/10 (by volume)) and TRANS-G (N) Sumi Ink™ (manufactured by Dainippon Ink and Chemicals Inc.) are fed respectively as the fountain solution and ink, and printing is performed at a printing speed of 6,000 sheets per hour. At this time, the number of the printed sheets required until the time when the state that the ink does not transfer to the unexposed part (the non-image part) of the photo-polymerization layer is reached is counted and evaluated as the on-press developing property. The smaller the number of sheets, the more excellent is the on-press developing property. The results of evaluation are shown in Table 1 below.

### (2) Fine line reproducibility:

After printing 100 sheets of paper as described above and confirming that a printed sheet free from the soiling of ink on the non-image part is obtained, 500 sheets of paper are further printed. The fine line chart (a chart on which 10, 12, 14, 16, 18, 20, 25, 30, 35, 40, 60, 80, 100 and 200 µm fine lines are exposed) of the 600^{th} in total of the printed sheets is observed with a loupe of 25 magnifications, and fine line reproducibility is evaluated by the fine line width reproduced with the ink without breaking. The results of evaluation are shown in Table 1.

### (3) Press life by conventional ink:

After printing in the evaluation of fine line reproducibility as above, printing is further continued. Since the photo-polymerization layer gradually wears down and ink receptive property lowers with the increase in the number of sheets of printing, the density of ink on the printed sheets lowers. Press life is evaluated by the number of the printed sheets required until the time when the ink density (reflection density) lowers by 0.1 from the starting time of printing. The results of evaluation are shown in Table 1.

### (4) Press life by UV ink:

Each of the obtained exposed lithographic printing plate precursors is mounted on the cylinder of printing press Dia IF-2™ (manufactured by Mitsubishi Heavy Industries Ltd.) without being subjected to development processing. As the fountain solution and ink, an aqueous solution of 2 vol% of IF102™ fountain solution (manufactured by Fuji Photo Film Co., Ltd.) and Best Cure UV-BF-WRO™ standard Sumi Ink (manufactured by T&K TOKA COMPANY) are respectively fed and printing is performed at a printing speed of 10,000 sheets per hour.

Press life is evaluated by the number of the printed sheets as printing finish at the time when image density of the obtained printed matter lowers by 5% from the starting time of printing. The results of evaluation are shown in Table 1.

**TABLE 1**

| Specific polymer compounds used and results of evaluations of lithographic printing plate precursors | | | | | |
|---|---|---|---|---|---|
| Example No. | Specific Polymer Compound | On-Press Developing Property (number of sheets) | Fine Line Reproducibility (µm) | Press Life by Conventional Ink (number of sheets) | Press Life by UV Ink (number of sheets) |
| Example 1 | Exemplified compound (2) (Mw: 140,000) | 20 | 10 | 60,000 | 28,000 |
| Example 2 | Exemplified compound (15) (Mw: 100.000) | 20 | 10 | 60,000 | 20,000 |
| Example 3 | Exemplified compound (16) (Mw: 88,000) | 20 | 10 | 60,000 | 15,000 |
| Example 4 | Exemplified compound (43) (Mw: 200,000) | 13 | 10 | 50,000 | 25,000 |
| Example 5 | Exemplified compound (44) (Mw: 220,000) | 13 | 10 | 50,000 | 15,000 |
| Example 6 | Exemplified compound (25) (Mw:350.000) | 13 | 10 | 50,000 | 25,000 |
| Example 7 | Exemplified compound (45) (Mw: 220,000) | 16 | 10 | 55,000 | 30,000 |
| Example 8 | Exemplified compound (46) (Mw: 150,000) | 18 | 10 | 55,000 | 27,000 |
| Example 9* | Exemplified compound (47) (Mw:10.000) | 20 | 10 | 60,000 | 28,000 |
| Example 10 | Exemplified compound (48) (Mw:120.000) | 20 | 10 | 58,000 | 28,000 |
| Example 11 | Exemplified compound (66) (Mw: 100,000) | 20 | 10 | 54,000 | 24,000 |
| Example 12 | Exemplified compound (51) (Mw: 180.000) | 20 | 10 | 58,000 | 28,000 |
| Example 13* | Exemplified compound (53) (Mw: 120.000) | 30 | 10 | 60,000 | 29,000 |
| Example 14 | Exemplified compound (65) (Mw: 80,000) | 20 | 10 | 55,000 | 25,000 |
| Example 15 | Exemplified compound (78) (Mw: 95,000) | 20 | 10 | 55,000 | 20,000 |
| Example 16 | Exemplified compound (84) (Mw: 75.000) | 20 | 10 | 50,000 | 15,000 |
| Example 17 | Exemplified compound (89) (Mw: 10,000) | 20 | 10 | 50,000 | 15,000 |
| Comparative Example 1 | Specific polymer for comparison (R-1) (Mw: 100,000) | 20 | 10 | 50,000 | 8,000 |

| | | | | | |
|---|---|---|---|---|---|
| *Reference Example | | | | | |

When Examples 1 to 9 are compared with Comparative Exmaple 1, the negative lithographic printing plate precursors of the invention containing in the photo-polymerization layer a polymer compound having a sulfonamido group and a hydrophilic group in the molecule are confirmed to be excellent not only in the press life by conventional ink and on-press developing property but also in the press life by UV ink.

When Examples 10 to 17 are compared with Comparative Exmaple I, the negative lithographic printing plate precursors of the invention containing in the photo-polymerization layer a polymer compound having a cyclic structure derived from maleimide and a hydrophilic group in the molecule are confirmed to be excellent not only in the press life by conventional ink and on-press developing property but also in the press life by UV ink.

The invention can provide a lithographic printing plate excellent in an on-press developing property, having excellent fine line reproducibility, capable of obtaining a plenty of sheets of printed matters even when printing is carried out with UV ink, and excellent in press life, and the invention can also provide a lithographic printing method using the same.

## Claims

1. A negative on press development type lithographic printing plate precursor comprising:
a support; and
a photo-polymerization layer containing a polymer compound having at least one of a sulfonamido group and a cyclic structure derived from maleimide, and further having a hydrophilic group in a molecule thereof, wherein
the hydrophilic group is an alkylene oxide structure represented by a following Formula (II): 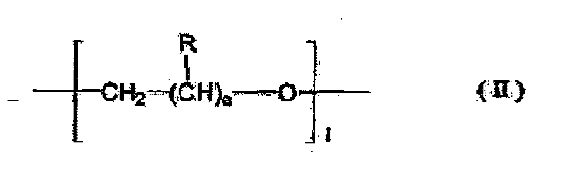
wherein
R represents a hydrogen atom or a methyl group;
a represents 1, 3 or 5; and
1 represents an integer of from 1 to 9.

2. The negative on-press development type lithographic printing plate precursor according to Claim 1, comprising:
a support; and
a photo-polymerization layer containing a polymer compound having a sulfonamido group and a hydrophilic group in a molecule thereof.

3. The negative on-preas development type lithographic printing plate precursor according to Claim 2, wherein
the polymer compound has a unit derived from a monomer having a sulfonamido group represented by any of following Formulae (Ia) to (Ie): 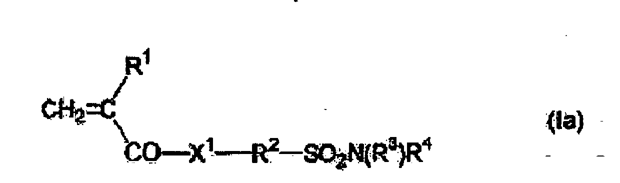 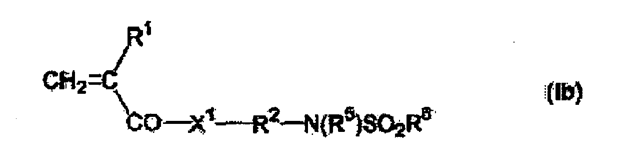 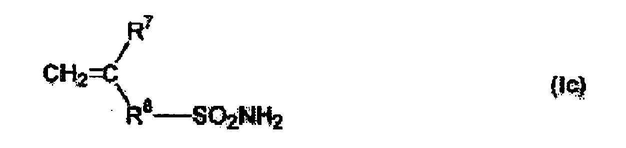 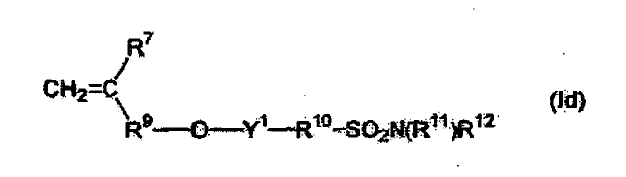 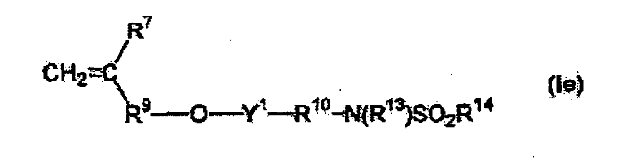 wherein
X¹ represents O or NR;
R¹ represents a hydrogen atom or a methyl group;
R² , R⁸ and R¹⁰ each independently represents an alkylene, Cycloalkylene, arylene or aralkylene group having from 1 to 12 carbon atoms, each of which may have a substituent;
R³ , R⁴ , R⁵ , R¹¹ , R¹² and R¹³ each independently represents a hydrogen atom, or an alkyl, cycloalkyl, aryl or aralkyl group having from 1 to 12 carbon atoms, each of which may have a substituent;
R⁶ and R¹⁴ each independently represents an alkyl, cycloalkyl, aryl or aralkyl group having from 1 to 12 carbon atoms, each of which may have a substituent;
R⁷ represents a hydrogen atom, a halogen atom, or a methyl group;
R⁹ represents a single bond, or an alkylene, cycloalkylene, arylene or aralkylene group having from 1 to 12 carbon atoms, each of which may have a substituent;
R represents a hydrogen atom, or an alkyl, cycloalkyl, aryl or aralkyl group having from 1 to 12 carbon atoms, each of which may have a substituent; and
Y¹ represents a single bond or a carbonyl group.

4. The negative on-press development type lithographic printing plate precursor according to Claim 1, comprising:
a support; and
a photo-polymerization layer containing a polymer compound having a cyclic structure derived from maleimide and a hydrophilic group in a molecule thereof.

5. The negative on-press development type lithographic printing plate precursor according to Claim 4, wherein
the cyclic structure derived from maleimide is a structure represented by a following Formula (I): 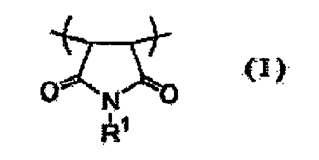 wherein
R¹ represents a hydrogen atom or a monovalent organic group that may have a substituent.

6. The negative on-press development type lithographic printing plate precursor according to Claim 5, wherein
R¹ in the Formula (I) represents an aryl group that may have a substituent.

7. The negative on-press development type lithographic printing plate precursor according to Claim 1, wherein
the photo-polymerization layer contains an infrared absorber, a polymerization initiator and a polymerizable monomer.

8. The negative on-press development type lithographic printing plate precursor according to Claim 1, wherein
the photo-polymerization layer contains a microcapsule or microgel.

9. The negative on-press development type lithographic printing plate precursor according to Claim 2, wherein
the photo-polymerization layer contains a polymerizable monomer, and
a mass ratio of the polymer compound having a sulfonamido group and a hydrophilic group in a molecule thereof to the polymerizable monomer is from 1/1 to 1/3.

10. The negative on-press development type lithographic printing plate precursor according to Claim 4, wherein
the photo-polymerization layer contains a polymerizable monomer, and
a mass ratio of the polymer compound having a cyclic structure derived from maleimide and a hydrophilic group in a molecule thereof to the polymerizable monomer is from 1/1 to 1/3.

11. The negative on-press development type lithographic printing plate precursor according to Claim 1, wherein
the photo-polymerization layer can be removed with at least one of printing ink and a fountain solution.

12. The negative on-press development type lithographic printing plate precursor according to Claim 1, wherein
the photo-polymerization layer can be removed with at least one of UV ink and a fountain solution.

13. A lithographic printing method comprising:
mounting the negative on-press development type lithographic printing plate precursor according to Claim 11 on a printing press and imagewise exposing it with an infrared laser beam, or imagewise exposing the negative on-press development type lithographic printing plate precursor according to Claim 11 with a infrared laser beam and mounting it on a printing press; and
feeding oil ink and an aqueous component to the negative on-press development type lithographic printing plate precursor to thereby remove an unexposed part of the photo-polymerization layer; and
performing printing.

14. A lithographic printing method comprising:
mounting the negative on-press development type lithographic printing plate precursor according to Claim 12 on a printing press and imagewise exposing it with an infrared laser beam, or imagewise exposing the negative on-press development type lithographic printing plate precursor according to Claim 12 with a infrared laser beam and mounting it on a printing press;
feeding UV ink and an aqueous component to the negative on-press development type lithographic printing plate precursor to thereby remove an unexposed part of the photo-polymerization layer; and
performing printing.

## Patentansprüche

1. Negativ-Lithografiedruckplattenvorläufer vom Typ zur Entwicklung auf der Presse, umfassend:
einen Träger; und
eine Fotopolymerisationsschicht, enthaltend eine Polymerverbindung, die zumindest eine von einer Sulfonamidgruppe und einer cyclischen Struktur, die sich von Maleimid ableitet, aufweist und die ferner eine hydrophile Gruppe in einem Molekül hiervon aufweist, worin
die hydrophile Gruppe eine durch die folgende Formel (II) dargestellte Alkylenoxidstruktur ist: 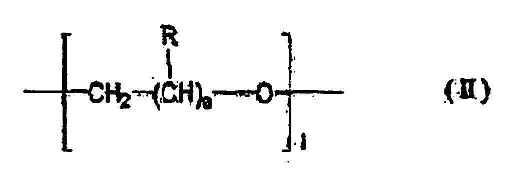
worin
R ein Wasserstoffatom oder eine Methylgruppe darstellt;
a 1, 3 oder 5 darstellt; und
1 eine ganze Zahl von 1 bis 9 darstellt.

2. Negätiv-Lithografiedruckplattenvorläufer vom Typ zur Entwicklung auf der Presse gemäß Anspruch 1, umfassend:
einen Träger; und
eine Fotopolymerisationsschicht, enthaltend eine Polymerverbindung, die eine Sulfonamidgruppe und eine hydrophile Gruppe in einem Molekül hiervon aufweist.

3. Negativ-Lithografiedruckplattenvorläufer vom Typ zur Entwicklung auf der Presse gemäß Anspruch 2, worin
die Polymerverbindung eine Einheit aufweist, die aus einem Monomer abgeleitet ist, das eine Sulfonamidgruppe aufweist, dargestellt durch irgendeine der folgenden Formeln (Ia) bis (Ie): 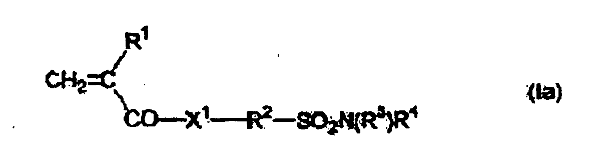 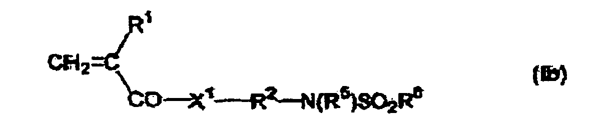 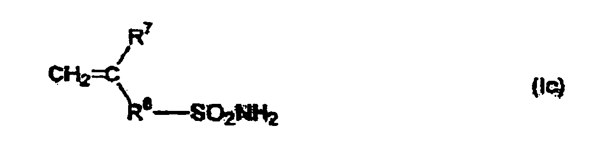 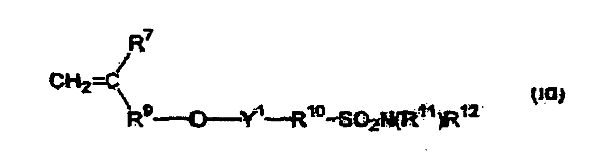 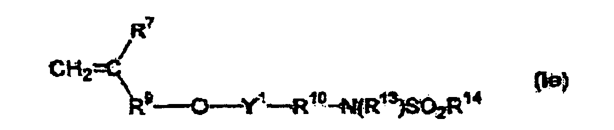 worin
X¹ O oder NR darstellt;
R¹ ein Wasserstoffatom oder eine Methylgruppe darstellt;
R², R⁸ und R¹⁰ jeweils unabhängig voneinander eine Alkylen-, Cycloalkylen-, Arylen- oder Aralkylengruppe mit 1 bis 12 Kohlenstoffatomen darstellen, von denen jede einen Substituenten aufweisen kann;
R³, R⁴ R⁵, R¹¹, R¹² und R¹³ jeweils unabhängig voneinander ein Wasserstoffatom oder eine Alkyl-, Cycloalkyl-, Aryl- oder Aralkylgruppe mit 1 bis 12 Kohlenstoffatomen darstellen, von denen jede einen Substituenten aufweisen kann;
R⁶ und R¹⁴ jeweils unabhängig voneinander eine Alkyl-, Cycloalkyl-, Aryl- oder Aralkylgruppe mit 1 bis 12 Kohlenstoffatomen darstellen, von denen jede einen Substituenten aufweisen kann;
R⁷ ein Wasserstoffatom, ein Halogenatom oder eine Methylgruppe darstellt;
R⁹ eine Einfachbindung oder eine Alkylen-, Cycloalkylen-, Arylen- oder Aralkylengruppe mit 1 bis 12 Kohlenstoffatomen darstellt, von denen jede einen Substituenten aufweisen kann;
R ein Wasserstoffatom oder eine Alkyl-, Cycloalkyl-, Aryl- oder Aralkylgruppe mit 1 bis 12 Kohlenstoffatomen darstellt, von denen jede einen Substituenten aufweisen kann; und
Y¹ eine Einfachbindung oder eine Carbonylgruppe darstellt.

4. Negativ-Lithografiedruckplattenvorläufer vom Typ zur Entwicklung auf der Presse gemäß Anspruch 1, umfassend,
einen Träger, und
eine Fotopolymerisationsschicht, enthaltend eine Polymerverbindung, die eine cyclische Struktur, abgeleitet von Maleimid, und eine hydrophile Gruppe in einem Molekül hiervon aufweist.

5. Negativ-Lithografiedruckplattenvorläufer vom Typ zur Entwicklung auf der Presse gemäß Anspruch 4, worin die aus Maleimid abgeleitete cyclische Struktur eine durch die folgende Formel (I) dargestellt Struktur ist 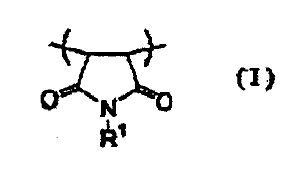 worin
R¹ ein Wasserstoffatom oder eine monovalente organische Gruppe darstellt, die einen Substituenten aufweisen kann.

6. Negativ-Lithografiedruckplattenvorläufer vom Typ zur Entwicklung auf der Presse gemäß Anspruch 5, worin
R¹ in der Formel (I) eine Arylgruppe darstellt, die einen Substituenten aufweisen kann.

7. Negativ-Lithografiedruckplattenvorläufer vom Typ zur Entwicklung auf der Presse gemäß Anspruch 1, worin
die Fotopolymerisationsschicht einen Infrarotabsorber, einen Polymerisationsinitiator und ein polymerisierbares Monomer umfasst.

8. Negativ-Lithografiedruckplattenvorläufer vom Typ zur Entwicklung auf der Presse gemäß Anspruch 1, worin
die Fotopolymerisationsschicht eine Mikrokapsel oder ein Mikrogel umfasst.

9. Negativ-Lithografiedruckplattenvorläufer vom Typ zur Entwicklung auf der Presse gemäß Anspruch 2, worin
die Fotopolymerisationsschicht ein polymerisierbares Monomer umfasst und
das Gewichtsverhältnis der Polymerverbindung, die eine Sulfonamidgruppe und eine hydrophile Gruppe in einem Molekül hiervon aufweist, zu dem polymerisierbaren Monomer 1/1 bis 1/3 beträgt.

10. Negativ-Lithografiedruckplattenvorläufer vom Typ zur Entwicklung auf der Presse gemäß Anspruch 4, worin
die Fotopolymerisationsschicht ein polymerisierbares Monomer umfasst und
das Gewichtsverhältnis der Polymerverbindung, die eine cyclische Struktur, abgeleitet von Maleimid, und eine hydrophile Gruppe in einem Molekül hiervon aufweist, zu dem polymerisierbaren Monomer 1/1 bis 1/3 beträgt.

11. Negativ-Lithografiedruckplattenvorläufer vom Typ zur Entwicklung auf der Presse gemäß Anspruch 1, worin
die Fotopolymerisationsschicht mit zumindest einem von Drucktinte und einer Anfeuchtlösung entfernt werden kann.

12. Negativ-Lithografiedruckplattenvorläufer vom Typ zur Entwicklung auf der Presse gemäß Anspruch 1, worin
die Fotopolymerisationschicht mit zumindest einem von UV-Tinte und eine Anfeuchtlösung entfernt werden kann.

13. Lithografisches Druckverfahren, umfassend:
Montieren des Negativ-Lithografiedruckplattenvorläufers vom Typ zur Entwicklung auf der Presse gemäß Anspruch 11 auf einer Druckpresse und bildweises Belichten hiervon mit einem Infrarotlaserstrahl, oder bildweises Belichten des Negativ-Lithografiedruckplattenvorläufers vom Typ zur Entwicklung auf der Presse gemäß Anspruch 11 mit einem Infrarotlaserstrahl und Montieren hiervon auf einer Druckpresse; und
Zuführen von Öltinte und einer wässrigen Komponente zu dem Negativ-Lithografiedruckplattenvorläufer vom Typ zur Entwicklung auf der Presse, um hierdurch einen nicht belichteten Bereich der Fotopolymerisationsschicht zu entfernen; und
Durchführen des Druckens.

14. Lithografisches Druckverfahren, umfassend:
Montieren des Negativ-Lithografiedruckplattenvorläufers vom Typ zur Entwicklung auf der Presse gemäß Anspruch 12 auf einer Druckpresse und bildweises Belichten hiervon mit einem Infrarotlaserstrahl, oder bildweises Belichten des Negativ-Lithografiedruckplattenvorläufers vom Typ zur Entwicklung auf der Presse gemäß Anspruch 12 mit einem Infrarotlaserstrahl und Montieren hiervon auf einer Druckpresse; und
Zuführen von UV-Tinte und einer wässrigen Komponente zu dem Negativ-Lithografiedruckplattenvorläufer vom Typ zur Entwicklung auf der Presse, um hierdurch einen nicht belichteten Bereich der Fotopolymerisationsschicht zu entfernen; und
Durchführen des Druckens.

## Revendications

1. Précurseur de plaque d'impression lithographique négative de type à développement sur presse comprenant :
un support ; et
une couche de photo-polymérisation contenant un composé polymère ayant au moins l'un parmi un groupe sulfonamido et une structure cyclique dérivée d'un groupe maléimide, et ayant en outre un groupe hydrophile dans une molécule de celui-ci, dans lequel
le groupe hydrophile est une structure d'oxyde d'alkylène représentée par la formule (II) suivante : 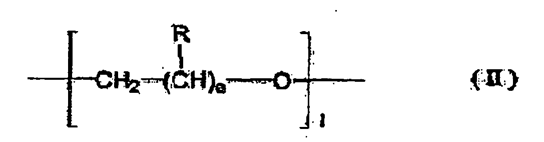
dans laquelle
R représente un atome d'hydrogène ou un groupe méthyle ;
a représente 1, 3 ou 5 ; et
I représente un nombre entier de 1 à 9.

2. Précurseur de plaque d'impression lithographique négative de type à développement sur presse selon la revendication 1, comprenant :
un support ; et
une couche de photo-polymérisation contenant un composé polymère ayant un groupe sulfonamido et un groupe hydrophile dans une molécule de celui-ci.

3. Précurseur de plaque d'impression lithographique négative de type à développement sur presse selon la revendication 2, dans lequel
le composé polymère a une unité dérivée d'un monomère ayant un groupe sulfonamido représenté par l'une quelconque des formules (la) à (le) suivantes : 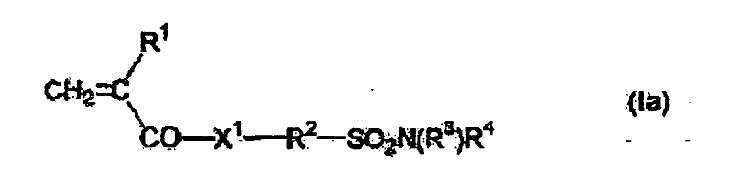 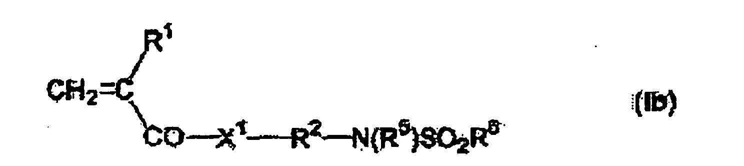 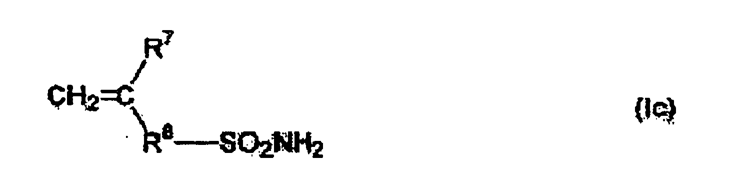 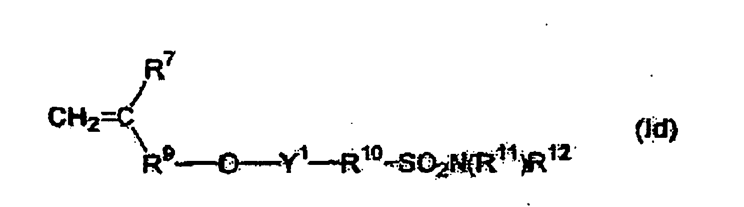 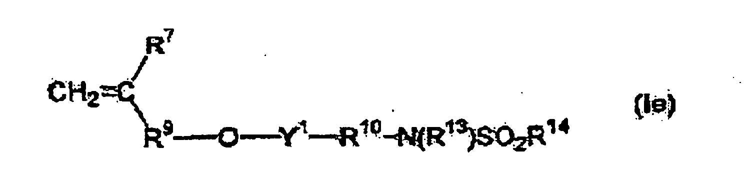 dans lesquelles
X¹ représente O ou NR ;
R¹ représente un atome d'hydrogène ou un groupe méthyle ;
R², R³ et R¹⁰ représentent chacun de manière indépendante un groupe alkylène, cycloalkylène, arylène ou aralkylène ayant de 1 à 12 atomes de carbone, chacun d'eux pouvant avoir un substituant ;
R³, R⁴, R⁵, R¹¹, R¹² et R¹³ représentent chacun de manière indépendante un atome d'hydrogène ou un groupe alkyle, cycloalkyle, aryle ou aralkyle ayant de 1 à 12 atomes de carbone, chacun d'eux pouvant avoir un substituant ;
R⁶ et R¹⁴ représentent chacun de manière indépendante un groupe alkyle, cycloalkyle, aryle ou aralkyle ayant de 1 à 12 atomes de carbone, chacun d'eux pouvant avoir un substituant ;
R⁷ représente un atome d'hydrogène, un atome d'halogène, ou un groupe méthyle ;
R⁹ représente une liaison simple, ou un groupe alkylène, cycloalkylène, arylène ou aralkylène ayant de 1 à 12 atomes de carbone, chacun d'eux pouvant avoir un substituant ;
R représente un atome d'hydrogène, ou un groupe alkyle, cycloalkyle, aryle ou aralkyle ayant de 1 à 12 atomes de carbone, chacun d'eux pouvant avoir un substituant ; et
Y¹ représente une liaison simple ou un groupe carbonyle.

4. Précurseur de plaque d'impression lithographique négative de type à développement sur presse selon la revendication 1, comprenant :
un support ; et
une couche de photo-polymérisation contenant un composé polymère ayant une structure cyclique dérivée d'un groupe maléimide et un groupe hydrophile dans une molécule de celui-ci.

5. Précurseur de plaque d'impression lithographique négative de type à développement sur presse selon la revendication 4, dans lequel
la structure cyclique dérivée d'un groupe maléimide est une structure représentée par la formule (I) suivante : 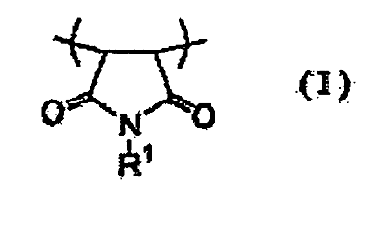 dans laquelle
R¹ représente un atome d'hydrogène ou un groupe organique monovalent qui peut avoir un substituant.

6. Précurseur de plaque d'impression lithographique négative de type à développement sur presse selon la revendication 5, dans lequel
R¹ dans la formule (I) représente un groupe aryle qui peut avoir un substituant.

7. Précurseur de plaque d'impression lithographique négative de type à développement sur presse selon la revendication 1, dans lequel
la couche de photo-polymérisation contient un absorbant d'infrarouge, un initiateur de polymérisation et un monomère polymérisable.

8. Précurseur de plaque d'impression lithographique négative de type à développement sur presse selon la revendication 1, dans lequel
la couche de photo-polymérisation contient une microcapsule ou un microgel.

9. Précurseur de plaque d'impression lithographique négative de type à développement sur presse selon la revendication 2, dans lequel
la couche de photo-polymérisation contient un monomère polymérisable, et
un rapport de masses du composé polymère ayant un groupe sulfonamido et un groupe hydrophile dans une molécule de celui-ci au monomère polymérisable est de 1/1 à 1/3.

10. Précurseur de plaque d'impression lithographique négative de type à développement sur presse selon la revendication 4, dans lequel
la couche de photo-polymérisation contient un monomère polymérisable, et
un rapport de masses du composé polymère ayant une structure cyclique dérivée d'un groupe maléimide et un groupe hydrophile dans une molécule de celui-ci au monomère polymérisable de 1/1 à 1/3.

11. Précurseur de plaque d'impression lithographique négative de type à développement sur presse selon la revendication 1, dans lequel
la couche de photo-polymérisation peut être enlevée avec au moins l'une parmi de l'encre d'impression et une solution mouillante.

12. Précurseur de plaque d'impression lithographique négative de type à développement sur presse selon la revendication 1, dans lequel
la couche de photo-polymérisation peut être enlevée avec au moins l'une parmi de l'encre sensible aux UV et une solution mouillante.

13. Procédé d'impression lithographique comprenant :
le montage du précurseur de plaque d'impression lithographique négative de type à développement sur presse selon la revendication 11 sur une presse d'impression et son exposition image par image à un faisceau laser infrarouge, ou bien l'exposition image par image du précurseur de plaque d'impression lithographique négative de type à développement sur presse selon la revendication 11 à un faisceau laser infrarouge et son montage sur une presse d'impression ; et
l'apport d'encre huileuse et d'un composant aqueux au précurseur de plaque d'impression lithographique négative de type à développement sur presse pour enlever ainsi une partie non exposée de la couche de photo-polymérisation ; et
l'exécution d'une impression.

14. Procédé d'impression lithographique comprenant :
le montage du précurseur de plaque d'impression lithographique négative de type à développement sur presse selon la revendication 12 sur une presse d'impression et son exposition image par image à un faisceau laser infrarouge, ou bien l'exposition image par image du précurseur de plaque d'impression lithographique négative de type à développement sur presse selon la revendication 12 à un faisceau laser infrarouge et son montage sur une presse d'impression ;
l'apport d'encre sensible aux UV et d'un composant aqueux au précurseur de plaque d'impression lithographique négative de type à développement sur presse afin d'enlever ainsi une partie non exposée de la couche de photo-polymérisation ; et
l'exécution d'une impression.
